# EUROPEAN PATENT APPLICATION

(11) **EP 4 579 345 A2**
(43) Date of publication of application: **02.07.2025**
(21) Application number: 24216524.9
(22) Date of filing: 29.11.2024
(51) Int. Cl.: G03F 7/075

(54) **COMPOSITION FOR FORMING SILICON-CONTAINING ANTI-REFLECTIVE FILM AND PATTERNING METHOD**

(30) Priority: 27.12.2023 JP 2023221249
(71) Applicant: Shin-Etsu Chemical Co., Ltd., Tokyo 100-0005 (JP)
(72) Inventor: Kobayashi, Naoki, Niigata (JP); Takizawa, Kanata, Niigata (JP); Yano, Toshiharu, Niigata (JP); Mitsui, Ryo, Niigata (JP); Yamamoto, Yasuyuki, Niigata (JP)
(74) Representative: Sonnenhauser, Thomas Martin

(57) **Abstract**

The present invention is a composition for forming a silicon-containing anti-reflective film, including: a silicon-containing polymer (A); an organic polymer (B); and an organic solvent (C), wherein the silicon-containing polymer (A) includes any one selected from a polysiloxane, a polycarbosilane, and a polysilane, and the organic polymer (B) includes two or more hydroxy groups in a repeating unit structure of the polymer, and includes no silicon. This can provide: a composition for forming a silicon-containing anti-reflective film and a patterning method for forming a silicon-containing anti-reflective film that has both an excellent anti-reflective function and good process selectivity in dry etching in fine patterning process in the semiconductor device producing process.

## Description

### TECHNICAL FIELD

The present invention relates to a composition for forming a silicon-containing anti-reflective film and a patterning method using the same.

### BACKGROUND ART

As higher integration and higher speed of LSI have been achieved, the pattern size has been rapidly miniaturized. With this miniaturization, lithography techniques have achieved formation of the fine pattern by shortening a wavelength of a light source and appropriately selecting a resist composition corresponding to the wavelength. The center of the resist composition is a positive-type photoresist composition used for a single layer. This single-layer positive-type photoresist composition has a skeleton having etching resistance against dry etching with chlorine-type or fluorine-type gas plasma in a resist resin, and has a switching mechanism so that an exposed portion is dissolved to form a pattern by dissolving the exposed portion. While using the remained resist pattern as an etching mask, a substrate to be processed is processed by dry etching.

However, miniaturing the pattern, that is reducing the pattern width, with keeping a thickness of the used photoresist film causes a problem of deteriorating resolution performance of the photoresist film. In addition, pattern-developing such a photoresist film, which has an excessively high "aspect ratio", with a developer consequently causes a problem of pattern collapse. Thus, the photoresist film has been thinned as the pattern has been miniaturized.

Meanwhile, commonly used for processing a substrate to be processed is a method of processing the substrate by dry etching while using a patterned photoresist film having a formed pattern as an etching mask. However, there is realistically no dry etching method that can have complete etching selectivity between the photoresist film and the substrate to be processed. Thus, there is a problem of collapse of the resist film with damaged during the substrate processing to fail to accurately transfer the photoresist pattern to the substrate to be processed. Accordingly, as the pattern has been miniaturized, the resist composition is required to have higher dry-etching resistance. However, on the other hand, a resin used for the photoresist composition is required to have small light absorption at the exposure wavelength to improve the resolution. Thus, as the wavelength of the exposure light has become shorter to i-line, KrF, and ArF, the resin has also changed to a novolac resin, polyhydroxystyrene, and a resin having an aliphatic polycyclic skeleton. However, the etching rate under the dry etching condition during the substrate processing has become realistically high, and recent photoresist compositions having high resolution rather tend to have weak etching resistance.

Thus, the substrate to be processed is necessarily processed by dry etching with the photoresist film having a smaller thickness and weaker etching resistance. It is urgently necessary to achieve a material and process for this processing.

One of methods to solve such a problem is a multilayer resist method. This method is of: interposing a resist underlayer film having etching selectivity different from etching selectivity of a photoresist film (that is, a resist upper layer film) between the resist upper layer film and a substrate to be processed; obtaining a pattern in the resist upper layer film; then transferring the pattern to the resist underlayer film by dry etching while using the resist upper layer film pattern as a dry etching mask; and further transferring the pattern to the substrate to be processed by dry etching while using the resist underlayer film as a dry etching mask.

One of the multilayer resist methods is a three-layer resist method that can be performed by using a common resist composition used for the single-layer resist method. In this three-layer resist method, for example, an organic film of a novolac resin etc. is formed on a substrate to be processed as a resist underlayer film, a silicon-containing resist middle layer film is formed thereon as a resist middle layer film, and a common organic photoresist film is formed thereon as a resist upper layer film. The organic resist upper layer film can have good etching selectivity to the silicon-containing resist middle layer film when the dry etching is performed with fluorine-type gas plasma. Thus, the resist upper layer film pattern can be transferred to the silicon-containing resist middle layer film by dry etching with the fluorine-type gas plasma. According to this method, the pattern can be transferred to the silicon-containing resist middle layer film (resist middle layer film) even by using a resist composition that is difficult to form a pattern having a film thickness sufficient for directly processing the substrate to be processed or by using a resist composition that has dry-etching resistance insufficient for processing the substrate. Subsequently transferring the pattern by dry etching with oxygen-type or hydrogen-type gas plasma can yield an organic film (resist underlayer film) pattern of the novolac resin, etc. that has dry-etching resistance sufficient for processing the substrate. As the aforementioned resist underlayer film, many materials including, for example, materials described in Patent Document 1, have been already known.

Used as the silicon-containing resist middle layer film used in the aforementioned three-layer resist method are an inorganic hard mask middle layer film by CVD, for example, a SiO₂ film (for example, Patent Document 2 etc.) and a SiON film (for example, Patent Document 3 etc.), and for obtaining a film by spin-coating, spin-on-glass (SOG) film (for example, Patent Document 4 etc. and Non Patent Document 1), and a crosslinkable silsesquioxane film (for example, Patent Document 5 etc.) are used. A polysilane film (for example, Patent Document 6 etc.) would be usable too. In the latest three-layer resist method, the SOG film is commonly used because an anti-reflective function is easily controlled.

The SOG film conventionally used in such a three-layer resist method has several problems. For example, it is well known that, when a resist pattern is to be formed by photolithography, the exposure light is reflected on the substrate and interferes incident light to cause problem, so-called standing wave. To obtain a fine pattern without edge roughness on the resist film under the latest ArF immersion and high NA exposure condition, an anti-reflective function is essential as the resist middle layer film. Further, in the latest semiconductor process as noted above, the photoresist has been more thinned, and thus the resist middle layer film has also been required to be thinner. In the next-generation exposure process, it is required to impart the anti-reflective effect with a film thickness of 30 nm or less. The dry etching rate against oxygen gas plasma, which is commonly used in processing the resist underlayer film, is preferably smaller in order to increase etching selectivity between the SOG film and the resist underlayer film, and with the stream of thinning, the SOG film is required to improve the dry-etching resistance.

In the three-layer resist method, it is difficult to develop an SOG film having the anti-reflective function and the dry-etching resistance at a high level. To improve the anti-reflective function, a polysiloxane having an organic group having a high refractive index is necessarily used, but increasing an introduction rate of the organic group decreases the silicon component in the film to deteriorate the dry-etching resistance against oxygen gas. Meanwhile, there is a four-layer resist method in which the functions of the antireflection and the dry-etching resistance are imparted to two different films. Patent Document 7 reports a four-layer resist method including an organic underlayer film (resist underlayer film), a silicon-containing hard mask (resist middle layer film), an organic anti-reflective film, and a photoresist (resist upper layer film).

The anti-reflective film needs to have functions as a layer for preventing interaction between the substrate to be processed and the photoresist, a layer having a function of preventing an adverse effect of the material used for the photoresist or a substance generated during exposure of the photoresist on the substrate, a layer having a function of preventing diffusion of a substance generated from the substrate during heating and baking toward the upper layer photoresist, a barrier layer for reducing poisoning to the photoresist layer due to a semiconductor substrate dielectric layer, etc. The organic anti-reflective film is insufficient for these functions, and further improvement is considered to be needed.

Patent Document 8 reports a four-layer resist method using a silicon-containing anti-reflective film. It has been reported that the silicon-containing anti-reflective film is effective for inhibiting poisoning against the organic anti-reflective film, but the silicon-containing anti-reflective film used in Example is 50 nm. As described above, the photoresist has been further thinned in the latest semiconductor process, and thus, the silicon-containing anti-reflective film is also required to be thinned. In the next-generation exposure process, required is a composition for forming a silicon-containing anti-reflective film that exhibits excellent film formability in forming a thin film with 12 nm or less in film thickness.

### CITATION LIST

### PATENT LITERATURE

Patent Document 1: JP 2004-205685 A
Patent Document 2: JP H07-183194 A
Patent Document 3: JP H07-181688 A
Patent Document 4: JP H05-291208 A
Patent Document 5: JP 2005-520354 A
Patent Document 6: JP H11-060735 A
Patent Document 7: JP 5057107 B2
Patent Document 8: JP 4481902 B2

### NON PATENT LITERATURE

Non Patent Document 1: J. Appl. Polym. Sci., Vol. 88, 636-640 (2003)

### SUMMARY OF INVENTION

### TECHNICAL PROBLEM

The present invention has been made in view of the above circumstances. An object of the present invention is to provide, in fine patterning process in the semiconductor device producing process, a composition for forming a silicon-containing anti-reflective film for forming a silicon-containing anti-reflective film having both excellent anti-reflective function and good process selectivity in dry etching, and a patterning method using the same.

To solve the above problem, the present invention provides a composition for forming a silicon-containing anti-reflective film, comprising:
a silicon-containing polymer (A);
an organic polymer (B); and
an organic solvent (C), wherein
the silicon-containing polymer (A) comprises any one selected from a polysiloxane, a polycarbosilane, and a polysilane, and
the organic polymer (B) comprises two or more hydroxy groups in a repeating unit structure of the polymer, and comprises no silicon.

The composition for forming a silicon-containing anti-reflective film as above can exhibit a high anti-reflective effect under the ArF immersion and high NA exposure condition by combination of a silicon-containing anti-reflective film formed by using this composition and a resist middle layer film such as a silicon-containing hard mask and a resist underlayer film such as an organic resist underlayer film. Therefore, a fine pattern without edge roughness can be obtained. In addition, the composition for forming a silicon-containing anti-reflective film containing the organic polymer (B) can exhibit an excellent poisoning-inhibiting effect compared with the conventional anti-reflective film and exhibit good adhesiveness to a resist pattern, and therefore, the composition also exhibits an effect of preventing collapse of a fine pattern. The organic polymer (B) having two or more hydroxy groups in the repeating unit structure of the polymer and having no silicon yields good compatibility with a hydrophilic substrate, and exhibits excellent film formability in forming a thin film with 12 nm or less in film thickness. Therefore, the patterning method of the present invention can transfer a resist pattern shape on a substrate to be processed with high accuracy.

In an aspect of the present invention, the organic polymer (B) preferably comprises the following general formula (1B) or (2B), 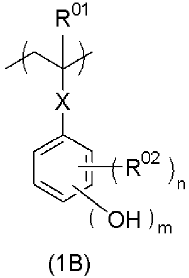
wherein R⁰¹ represents a hydrogen atom or a methyl group, R⁰² represents an alkyl group having 1 to 3 carbon atoms or a halogen atom, "m" represents an integer of 2 to 5, "n" represents an integer of 0 to 3, m+n represents an integer of 2 or more and 5 or less, X represents a single bond or an alkylene group having 1 to 10 carbon atoms and optionally having one or more selected from an oxygen atom and a nitrogen atom, 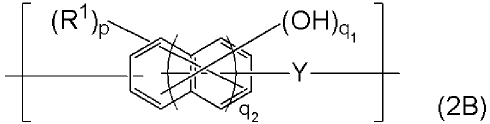
wherein R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, "q₁" represents an integer of 2 to 6, p+q₁ represents an integer of 2 or more and 6 or less, and "q₂" represents 0 or 1.

Containing the organic polymer (B) as above improves compatibility with the underlayer substrate in applying the composition for forming a silicon-containing anti-reflective film on the underlayer substrate, which can form a thin silicon-containing anti-reflective film exhibiting excellent film formability.

In an aspect of the present invention, the polysiloxane preferably comprises one or more selected from a repeating unit represented by the following general formula (Sx-1), a repeating unit represented by the following general formula (Sx-2), and a partial structure represented by the following general formula (Sx-3), 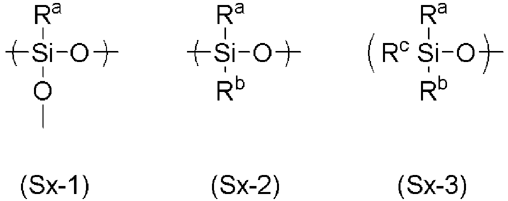 wherein R^{a}, R^{b}, and R^{c} represent a monovalent organic group having 1 to 30 carbon atoms which may be same as or different from each other.

The composition for forming a silicon-containing anti-reflective film containing the polysiloxane as above can improve the effect of the present invention, which is preferable.

In this case, at least one of the R^{a} to R^{c} in the general formulae (Sx-1) to (Sx-3) preferably represents an organic group having one or more carbon-oxygen single bonds or carbon-oxygen double bonds.

Use of the composition for forming a silicon-containing anti-reflective film as above can improve adhesiveness to the resist pattern, and can prevent collapse of a fine pattern.

In an aspect of the present invention, the polycarbosilane preferably comprises a unit structure represented by the following general formula (Sy-1), 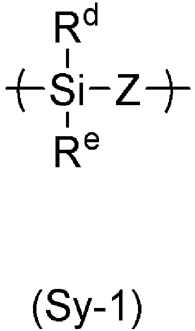 wherein R^{d} and R^{e} each independently represent a hydrogen atom, a hydroxy group, a halogen atom, or a monovalent organic group having 1 to 30 carbon atoms, and Z represents a substituted or unsubstituted divalent hydrocarbon group having 1 to 20 carbon atoms.

Use of the composition for forming a silicon-containing anti-reflective film as above can improve adhesiveness to the resist pattern, and can prevent collapse of a fine pattern.

In an aspect of the present invention, a content of the organic polymer (B) is preferably within a range of 1 to 50 parts by mass relative to 100 parts by mass of the silicon-containing polymer (A).

The composition for forming a silicon-containing anti-reflective film containing the organic polymer (B) within the above range enables the silicon-containing anti-reflective film formed by using this composition to achieve both the dry-etching resistance and thin-film formability at a high level.

In an aspect of the present invention, a weight-average molecular weight Mw of the organic polymer (B) is preferably within a range of 1,500 ≤ Mw ≤ 20,000 in terms of polystyrene by gel permeation chromatography.

The above molecular weight range of the organic polymer (B) can form the silicon-containing anti-reflective film exhibiting excellent film formability in thin film formation. In addition, the above range can form the silicon-containing anti-reflective film having excellent film thickness uniformity and inhibition of sublimate-derived defects.

In an aspect of the present invention, the composition for forming a silicon-containing anti-reflective film preferably further comprising a crosslinking agent (D).

The composition for forming a silicon-containing anti-reflective film as above increases density of the silicon-containing anti-reflective film formed by using this composition, transfers a basic component generated from the inorganic hard mask middle layer film to the photoresist film (resist upper layer film), and can more improve ability to inhibit poisoning, which deteriorates sensitivity and resolution of the resist. In addition, adhesiveness to the resist pattern can be further improved to prevent collapse of a fine pattern. Further, the refractive index of the silicon-containing anti-reflective film can be increased to impart excellent anti-reflective function.

In this case, the crosslinking agent (D) is preferably a compound having an isocyanuric acid structure.

The composition for forming a silicon-containing anti-reflective film as above can more improve the aforementioned effect.

In an aspect of the present invention, the composition for forming a silicon-containing anti-reflective film preferably further comprising one or more selected from an acid generator (E), a surfactant (F), and a pigment (H).

Presence or absence and selection of these additives can achieve film formability, reduce a sublimate, and finely adjust performance according to customer's requirements for properties of the resist patterning, which are practically preferable.

In an aspect of the present invention, the organic solvent (C) preferably comprising one or more organic solvents having a boiling point of 180°C or higher as a high-boiling-point solvent (C1).

Containing the high-boiling-point solvent as above can yield sufficient thermal flowability during film formation, and thus the compatibility effect of the organic polymer (B) with substrate in thin film formation can be more improved. In addition, occurrence of defects derived from dry of the composition for forming a silicon-containing anti-reflective film can be inhibited, which is practically preferable.

The present invention provides patterning method for forming a pattern on a substrate to be processed, the method comprising steps of:
(I-1) applying the aforementioned composition for forming a silicon-containing anti-reflective film on a substrate to be processed, and then heat-treating the composition to form a silicon-containing anti-reflective film;
(I-2) forming a resist upper layer film on the silicon-containing anti-reflective film by using a photoresist material;
(I-3) pattern-exposing the resist upper layer film, and then developing the exposed resist upper layer film with a developer to form a pattern in the resist upper layer film;
(I-4) transferring the pattern to the silicon-containing anti-reflective film by dry etching while using the resist upper layer film having the formed pattern as a mask; and
(I-5) forming a pattern on the substrate to be processed by processing the substrate to be processed while using the silicon-containing anti-reflective film having the transferred pattern as a mask.

The above patterning method with a two-layer resist process can form a fine pattern on a body to be processed (substrate to be processed).

The present invention provides a patterning method for forming a pattern on a substrate to be processed, the method comprising steps of:
(II-1) forming a resist underlayer film on a substrate to be processed;
(II-2) applying the aforementioned composition for forming a silicon-containing anti-reflective film on the resist underlayer film, and then heat-treating the composition to form a silicon-containing anti-reflective film;
(II-3) forming a resist upper layer film on the silicon-containing anti-reflective film by using a photoresist material;
(II-4) pattern-exposing the resist upper layer film, and then developing the exposed resist upper layer film with a developer to form a pattern in the resist upper layer film;
(II-5) transferring the pattern to the silicon-containing anti-reflective film by dry etching while using the resist upper layer film having the formed pattern as a mask;
(II-6) transferring the pattern to the resist underlayer film by dry etching while using the silicon-containing anti-reflective film having the transferred pattern as a mask; and
(II-7) forming a pattern on the substrate to be processed by processing the substrate to be processed while using the resist underlayer film having the transferred pattern as a mask.

The above patterning method with a three-layer resist process can form a fine pattern on a body to be processed (substrate to be processed).

The present invention provides a patterning method for forming a pattern on a substrate to be processed, the method comprising steps of:
(III-1) forming a resist underlayer film on a substrate to be processed;
(III-2) forming an inorganic hard mask middle layer film selected from a group consisting of a silicon oxide film, a silicon nitride film, and a silicon oxynitride film on the resist underlayer film;
(III-3) applying the aforementioned composition for forming a silicon-containing anti-reflective film on the inorganic hard mask middle layer film, and then heat-treating the composition to form a silicon-containing anti-reflective film;
(III-4) forming a resist upper layer film on the silicon-containing anti-reflective film by using a photoresist material;
(III-5) pattern-exposing the resist upper layer film, and then developing the exposed resist upper layer film with a developer to form a pattern in the resist upper layer film;
(III-6) transferring the pattern to the silicon-containing anti-reflective film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) forming a pattern on the substrate to be processed by processing the substrate to be processed while using the resist underlayer film having the transferred pattern as a mask.

The above patterning method with a four-layer resist process can form a fine pattern on a body to be processed (substrate to be processed).

In this case, a film thickness of the silicon-containing anti-reflective film is preferably 12 nm or less.

Use of the silicon-containing anti-reflective film with the above film thickness can transfer the resist pattern shape to the silicon-containing anti-reflective film at a high speed, and thus, the pattern shape with reduced roughness can be transferred onto the substrate to be processed.

### ADVANTAGEOUS EFFECTS OF INVENTION

As noted above, the composition for forming a silicon-containing anti-reflective film of the present invention can form the silicon-containing anti-reflective film having excellent anti-reflective function and good process selectivity in dry etching in the fine-patterning process in the semiconductor device producing process.

The present invention can also provide the patterning method using the above composition for forming a silicon-containing anti-reflective film.

### BRIEF DESCRIPTION OF DRAWINGS

FIG. 1 is an explanatory view of an example of a patterning method of the present invention (four-layer resist process).
FIG. 2 is an explanatory view of an example of a patterning method of the present invention (three-layer resist process).
FIG. 3 is an explanatory view for reflectance calculation in the patterning method.

### DESCRIPTION OF EMBODIMENTS

As noted above, in the fine patterning process using the ArF immersion and high NA exposure condition in the semiconductor device producing process, there has been a demand for development of a composition for forming a silicon-containing anti-reflective film having excellent anti-reflective function that can form a fine resist pattern without edge roughness and exhibiting thin-film formability, and a patterning method using the same.

In fine processing using ArF excimer laser (wavelength: 193 nm), EUV excimer laser (wavelength: 13 nm), etc., a wiring width has become narrow and consequently causes pattern collapse of the photoresist film (simply referred to as "resist"). In order to prevent pattern collapse of the resist, the resist layer has also become thin as the wiring width becomes smaller. When such a thin-film resist is used, a resist underlayer film thereof is also required to have an improved dry-etching rate. However, the organic resist underlayer film relative to the organic photoresist film causes film reduction of the organic photoresist film by dry-etching gas for the organic resist underlayer film (for example, fluorine-type gas, oxygen gas, etc.). Meanwhile, when a silicon-containing hard mask layer is used as an underlayer for the organic resist film, in dry-etching the silicon-containing hard mask (resist middle layer) with a fluorine-type gas, film reduction of the organic photoresist film (the resist film (resist upper layer film) having a formed resist pattern) by the fluorine-type gas is small, and the resist pattern with the thin-film resist can be accurately transferred to the silicon-containing hard mask (resist middle layer). Then, dry-etching the organic underlayer film (resist underlayer film) with oxygen-type dry-etching gas can accurately transfer the resist pattern to the organic underlayer film (resist underlayer film) with small film reduction of the silicon-containing hard mask (resist middle layer film), and the semiconductor substrate can be processed with fluorine-type gas with the organic underlayer film (resist underlayer film) having the transferred resist pattern.

However, the aforementioned three-layer process of the organic underlayer film (resist underlayer film) on the semiconductor substrate, the silicon-containing hard mask (resist middle layer film), and the resist film (resist upper layer film) have a problem of technical difficulty in achievement of both increase in refraction and dry-etching resistance of the silicon-containing hard mask.

Due to thinning of the film for a purpose of preventing pattern collapse of the photoresist film, the silicon-containing hard mask is also required to be thinned. Accordingly, it is required to increase refraction of the silicon-containing hard mask in order to more improve the anti-reflective effect under the latest ArF immersion and high NA exposure condition. To form the highly refractive silicon-containing hard mask, SOG materials containing a polysiloxane having an organic group with a high refractive index is commonly used. These materials, however, have a large introduction rate of the organic group and a reduced silicon component in the film, and thereby the dry-etching resistance against oxygen gas becomes insufficient. To transfer the fine pattern without edge roughness onto the substrate to be processed with high accuracy, a silicon-containing hard mask having excellent dry-etching resistance is needed.

For such an object, it has been investigated to solve the above problem to provide a silicon-containing anti-reflective film between the silicon-containing hard mask (resist middle layer film) and the photoresist film (resist upper layer film). Meanwhile, Patent Document 8 reports the four-layer resist method using the silicon-containing anti-reflective film, but the silicon-containing anti-reflective film used in Example is 50 nm. As described above, the photoresist has been further thinned in the latest semiconductor process, and thus, the silicon-containing anti-reflective film is also required to be thinned. In the next-generation exposure process, required is a composition for forming a silicon-containing anti-reflective film that exhibits excellent film formability in forming a thin film with 12 nm or less in film thickness.

The present inventors have made earnest study on the above object, and consequently found that the above problem can be solved according to a composition for forming a silicon-containing anti-reflective film including: a silicon-containing polymer (A); an organic polymer (B); and an organic solvent (C), wherein the silicon-containing polymer (A) contains any one selected from a polysiloxane, a polycarbosilane, and a polysilane, and the organic polymer (B) has two or more hydroxy groups in a repeating unit structure of the polymer, and has no silicon, and according to a patterning method using the same because of a high effect of inhibiting the poisoning from the underlayer film to also have excellent thin-film formability, and a fine resist pattern can be formed. This finding has led to completion of the present invention.

Specifically, the present invention is a composition for forming a silicon-containing anti-reflective film including: a silicon-containing polymer (A); an organic polymer (B); and an organic solvent (C), wherein
the silicon-containing polymer (A) contains any one selected from a polysiloxane, a polycarbosilane, and a polysilane, and
the organic polymer (B) has two or more hydroxy groups in a repeating unit structure of the polymer, and comprises no silicon.

Hereinafter, the present invention will be described in detail, but the present invention is not limited thereto.

### Composition for Forming Silicon-Containing Anti-Reflective Film

The composition for forming a silicon-containing anti-reflective film of the present invention is a composition for forming a silicon-containing anti-reflective film including: a silicon-containing polymer (A); an organic polymer (B); and an organic solvent (C). The silicon-containing polymer (A) includes any one selected from a polysiloxane, a polycarbosilane, and a polysilane. The organic polymer (B) has two or more hydroxy groups in a repeating unit structure of the polymer, and has no silicon.

### <(A) Silicon-Containing Polymer>

The silicon-containing polymer (A) contained in the composition for forming a silicon-containing anti-reflective film of the present invention contains any one selected from a polysiloxane (Sx), a polycarbosilane (Sy), and a polysilane (Sz).

### (Polysiloxane (Sx))

When the silicon-containing polymer (A) in the composition for forming a silicon-containing anti-reflective film of the present invention contains a polysiloxane, the polysiloxane (Sx) preferably has any one or more selected from a repeating unit represented by the following general formula (Sx-1), a repeating unit represented by the following general formula (Sx-2), and a partial structure represented by the following general formula (Sx-3).

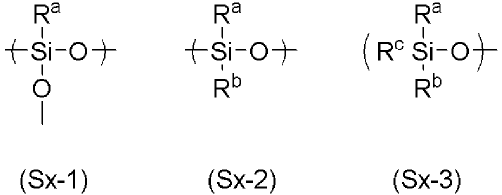

In the formula, R^{a}, R^{b}, and R^{c} represent a monovalent organic group having 1 to 30 carbon atoms which may be same as or different from each other.

The polysiloxane (Sx) is preferably a thermally crosslinkable polysiloxane, and may be produced by hydrolytically condensing the following hydrolysable monomer (Sm), for example.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, and dimethylphenethylethoxysilane.

Preferable examples of the above compounds include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, and dimethylphenethylmethoxysilane.

Other examples of the organic group represented by the R^{a}, R^{b}, and R^{c} corresponding to the compounds exemplified above as the hydrolysable monomer (Sm) include organic groups having one or more carbon-oxygen single bonds or carbon-oxygen double bonds. That is, at least one of the R^{a} to R^{c} in the general formulae (Sx-1) to (Sx-3) may be an organic group having one or more carbon-oxygen single bonds or carbon-oxygen double bonds. Specifically, such an organic group has one or more groups selected from a group consisting of an ether bond, an ester bond, an alkoxy group, a hydroxy group, etc. Examples thereof include groups represented by the following general formula (Sm-R).

(P-Q₁-(S₁)ᵥ₁-Q₂-)ᵤ-(T)ᵥ₂-Q₃-(S₂)ᵥ₃-Q₄- (Sm-R)

In the general formula (Sm-R), P represents a hydrogen atom, a cyclic ether group, a hydroxy group, an alkoxy group having 1 to 4 carbon atoms, an alkylcarbonyloxy group having 2 to 6 carbon atoms, or an alkylcarbonyl group having 2 to 6 carbon atoms. Q₁, Q₂, Q₃, and Q₄ each independently represent -C_{q}H_{(2q-p)}Pₚ-, wherein P is same as above, "p" represents an integer of 0 to 3, and "q" represents an integer of 0 to 10 (provided that q=0 represents a single bond). "u" represents an integer of 0 to 3. S₁ and S₂ each independently represent -O-, -CO-, -OCO-, -COO-, or - OCOO-. "v1", "v2", and "v3" each independently represent 0 or 1. T represents a divalent atom except for carbon or a divalent group including an aliphatic ring, an aromatic ring, or a heteroaromatic ring.

As T, examples of the aliphatic ring, the aromatic ring, or the heteroaromatic ring optionally having a heteroatom such as an oxygen atom are described below. In T, positions to be bonded to Q₂ and Q₃ are not particularly limited, and may be appropriately selected with considering reactivity due to a steric factor, availability of commercial reagents used for the reaction, etc.

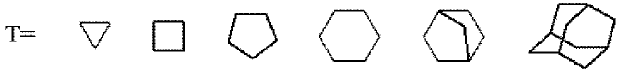

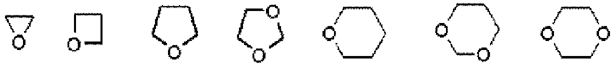

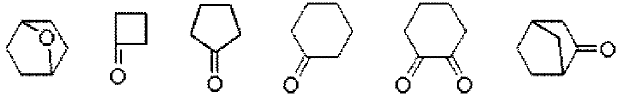

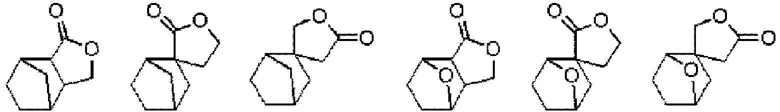

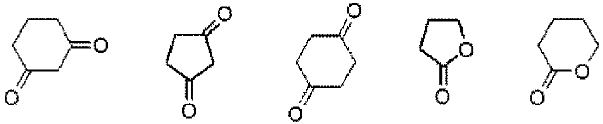

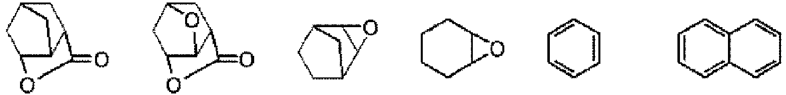

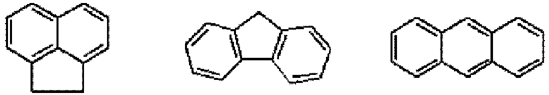

Preferable examples of the organic group having one or more carbon-oxygen single bonds or carbon-oxygen double bonds in the general formula (Sm-R) include the following groups. In the following formulae, (Si) is described to indicate a bonding portion with Si.

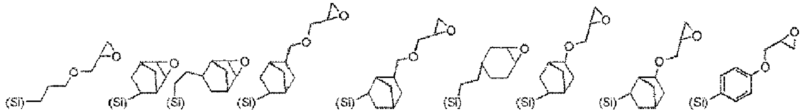

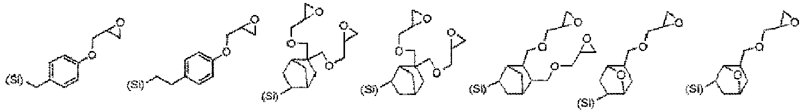

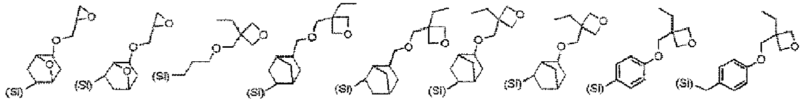

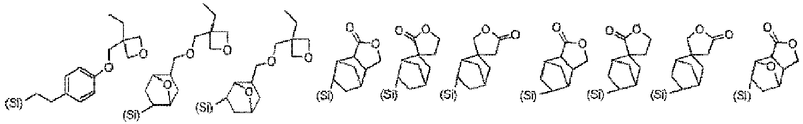

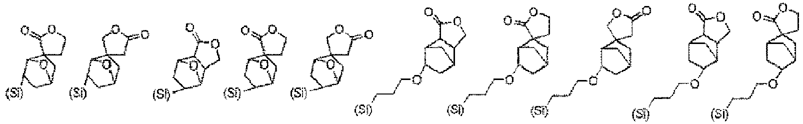

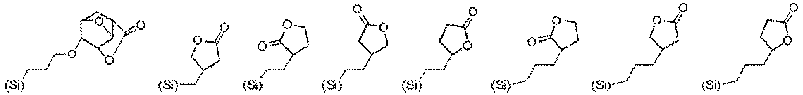

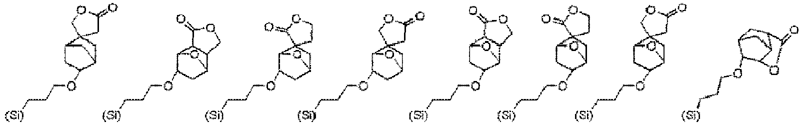

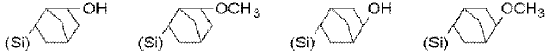

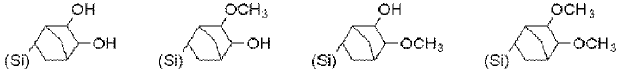

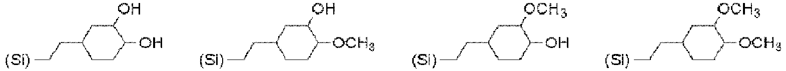

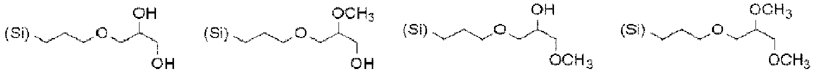

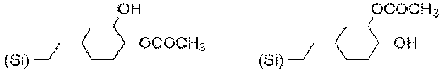

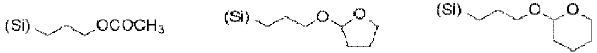

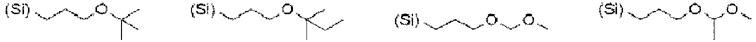

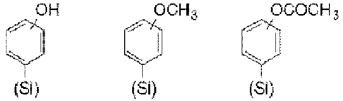

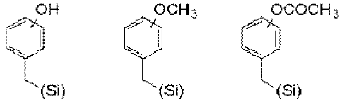

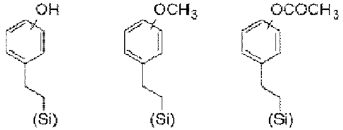

As an example of the organic groups of R^{a}, R^{b}, and R^{c}, an organic group having a silicon-silicon bond may also be used. Specific examples thereof include the followings.

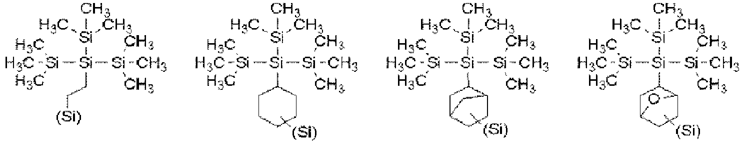

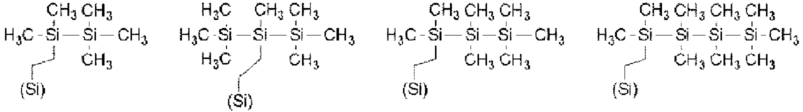

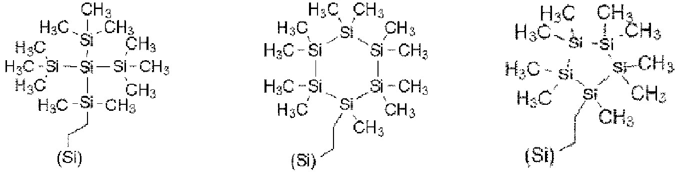

As an example of the organic groups of R^{a}, R^{b}, and R^{c}, an organic group having a protective group to be decomposed by an acid may also be used. Specific examples thereof include organic groups described in paragraphs [0043] to [0048] of JP 2013-167669 A, and organic groups obtained from silicon compounds described in a paragraph [0056] of JP 2013-224279 A.

As an example of the organic groups of R^{a}, R^{b}, and R^{c}, an organic group having a fluorine atom may be further used. Specific examples thereof include organic groups obtained from silicon compounds described in paragraphs [0059] to [0065] of JP 2012-053253 A.

In the above hydrolysable monomer (Sm), one, two, or three chlorine, bromine, iodine, acetoxy groups, methoxy groups, ethoxy groups, propoxy groups, butoxy groups, etc. are bonded, as the hydrolysable group, to the silicon indicated as (Si) in the above partial structures.

### Synthesis Method of Thermally Crosslinkable Polysiloxane (Sx)

### (Synthesis Method 1: Acid Catalyst)

The thermally crosslinkable polysiloxane (Sx) used in the present invention can be produced by hydrolytically condensing a mixture of one or two or more of the hydrolysable monomer (Sm) in the presence of an acid catalyst.

Examples of the acid catalyst used in this case include: organic acids such as formic acid, acetic acid, oxalic acid, maleic acid, methanesulfonic acid, benzenesulfonic acid, and toluenesulfonic acid; and inorganic acids such as hydrofluoric acid, hydrochloric acid, hydrobromic acid, sulfuric acid, nitric acid, perchloric acid, and phosphoric acid. A use amount of the catalyst is 1×10⁻⁶ to 10 mol, preferably 1×10⁻⁵ to 5 mol, and more preferably 1×10⁻⁴ to 1 mol relative to 1 mol of the monomer.

An amount of water added for obtaining the thermally crosslinkable polysiloxane (Sx) from these monomers via the hydrolytic condensation is 0.01 to 100 mol, more preferably 0.05 to 50 mol, and further preferably 0.1 to 30 mol per mole of the hydrolysable substituent bonded to the monomer. When the amount is 100 mol or less, an apparatus used for the reaction may be small, which is economical. When the amount is 0.01 mol or more, the reaction proceeds.

As the procedure, the monomer is added into an aqueous solution of the catalyst to initiate the hydrolytic condensation reaction. In this case, an organic solvent may be added into the aqueous solution of the catalyst, the monomer may be diluted in advance with an organic solvent, or both of them may be performed. The reaction temperature is 0 to 100°C, and preferably 5 to 80°C. A preferable method is retaining the temperature to 5 to 80°C during dropwise addition of the monomer, and then aging at 20 to 80°C.

Preferable organic solvents that can be added into the aqueous solution of the catalyst or that can dilute the monomer include methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, and a mixture thereof.

Preferable solvents among these are water-soluble solvents. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone; acetonitrile; and tetrahydrofuran. Particularly preferable solvents among these have a boiling point of 100°C or lower.

An amount of the used organic solvent is preferably 0 to 1,000 ml, and particularly preferably 0 to 500 ml relative to 1 mol of the monomer. When the amount of the used organic solvent is smaller, a reaction vessel may be smaller, which is economical.

Thereafter, a neutralization reaction of the catalyst is performed as necessary to obtain an aqueous solution of the reaction mixture. In this case, an amount of an alkaline substance that can be used for the neutralization is preferably 0.1 to 2 equivalents relative to the used acid as the catalyst. This alkaline substance may be any substance as long as it exhibits alkalinity in water.

Subsequently, a byproduct such as an alcohol generated by the hydrolytic condensation reaction is preferably removed from the reaction mixture under a reduced pressure, etc. In this time, a temperature at which the reaction mixture is heated is preferably 0 to 100°C, more preferably 10 to 90°C, and further preferably 15 to 80°C, depending on types of the added organic solvent and the alcohol generated in the reaction. A pressure reducing degree in this case is preferably the atmospheric pressure or lower, more preferably 80 kPa or lower as an absolute pressure, and further preferably 50 kPa or lower as an absolute pressure, which varies depending on types of the organic solvent and alcohol to be removed, a ventilation apparatus, a condensation apparatus, and the heating temperature. Although an amount of the removed alcohol in this case is difficult to be accurately determined, approximately 80 mass% or more of the generated alcohol etc. is desirably removed.

Then, the acid catalyst used for the hydrolytic condensation may be removed from the reaction mixture. As a method for removing the acid catalyst, water and the solution of the thermally crosslinkable polysiloxane being the reaction mixture are mixed, and the thermally crosslinkable polysiloxane is extracted with an organic solvent. The organic solvent used in this case is preferably an organic solvent that can dissolve the thermally crosslinkable polysiloxane and that forms separated two layers with mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Furthermore, a mixture of a water-soluble organic solvent and a water-hardly-soluble organic solvent can also be used. Examples of preferable mixtures include a methanol-ethyl acetate mixture, an ethanol-ethyl acetate mixture, a 1-propanol-ethyl acetate mixture, a 2-propanol-ethyl acetate mixture, a butanediol monomethyl ether-ethyl acetate mixture, a propylene glycol monomethyl ether-ethyl acetate mixture, an ethylene glycol monomethyl ether-ethyl acetate mixture, a butanediol monoethyl ether-ethyl acetate mixture, a propylene glycol monoethyl ether-ethyl acetate mixture, an ethylene glycol monoethyl ether-ethyl acetate mixture, a butanediol monopropyl ether-ethyl acetate mixture, a propylene glycol monopropyl ether-ethyl acetate mixture, an ethylene glycol monopropyl ether-ethyl acetate mixture, a methanol-methyl isobutyl ketone mixture, an ethanol-methyl isobutyl ketone mixture, a 1-propanol-methyl isobutyl ketone mixture, a 2-propanol-methyl isobutyl ketone mixture, a propylene glycol monomethyl ether-methyl isobutyl ketone mixture, an ethylene glycol monomethyl ether-methyl isobutyl ketone mixture, a propylene glycol monoethyl ether-methyl isobutyl ketone mixture, an ethylene glycol monoethyl ether-methyl isobutyl ketone mixture, a propylene glycol monopropyl ether-methyl isobutyl ketone mixture, an ethylene glycol monopropyl ether-methyl isobutyl ketone mixture, a methanol-cyclopentyl methyl ether mixture, an ethanol-cyclopentyl methyl ether mixture, a 1-propanol-cyclopentyl methyl ether mixture, a 2-propanol-cyclopentyl methyl ether mixture, a propylene glycol monomethyl ether-cyclopentyl methyl ether mixture, an ethylene glycol monomethyl ether-cyclopentyl methyl ether mixture, a propylene glycol monoethyl ether-cyclopentyl methyl ether mixture, an ethylene glycol monoethyl ether-cyclopentyl methyl ether mixture, a propylene glycol monopropyl ether-cyclopentyl methyl ether mixture, an ethylene glycol monopropyl ether-cyclopentyl methyl ether mixture, a methanol-propylene glycol methyl ether acetate mixture, an ethanol-propylene glycol methyl ether acetate mixture, a 1-propanol-propylene glycol methyl ether acetate mixture, a 2-propanol-propylene glycol methyl ether acetate mixture, a propylene glycol monomethyl ether-propylene glycol methyl ether acetate mixture, an ethylene glycol monomethyl ether-propylene glycol methyl ether acetate mixture, a propylene glycol monoethyl ether-propylene glycol methyl ether acetate mixture, an ethylene glycol monoethyl ether-propylene glycol methyl ether acetate mixture, a propylene glycol monopropyl ether-propylene glycol methyl ether acetate mixture, and an ethylene glycol monopropyl ether-propylene glycol methyl ether acetate mixture. The combination is not limited thereto.

A mixing ratio between the water-soluble organic solvent and the water-hardly-soluble organic solvent is appropriately selected, and is 0.1 to 1,000 parts by mass, more preferably 1 to 500 parts by mass, and further preferably 2 to 100 parts by mass of the water-soluble organic solvent, relative to 100 parts by mass of the water-hardly-soluble organic solvent.

Subsequently, the reaction mixture may be washed with neutral water. As this water, so-called deionized water or ultrapure water is typically used. An amount of this water is preferably 0.01 to 100 L, more preferably 0.05 to 50 L, and further preferably 0.1 to 5 L relative to 1 L of the solution of the thermally crosslinkable polysiloxane. In this washing method, the both are added into one vessel, and the mixture is stirred and left to stand to separate the aqueous layer. A washing time is one or more, and preferably one to approximately five because even ten times or more of washing may not yield an expected effect.

Examples of another method for removing the acid catalyst include: a method with an ion-exchange resin; and a method of neutralization with an epoxy compound such as ethylene oxide and propylene oxide, and then removing the neutralized product. These methods can be appropriately selected according to the acid catalyst used for the reaction.

The washing procedure in this time with water may allow a part of the thermally crosslinkable polysiloxane to escape into the aqueous layer and yield an effect approximately same as a fractioning procedure. Thus, the washing time with water and the amount of washing water are appropriately selected with considering the effect of removing the catalyst and the effect of fractioning.

In any of the solution of the thermally crosslinkable polysiloxane with a remained acid catalyst and the solution of the thermally crosslinkable polysiloxane with removed acid catalyst, a final solvent is added and solvent exchange is performed under a reduced pressure to obtain a desired solution of the thermally crosslinkable polysiloxane. A temperature of the solvent exchange in this case is preferably 0 to 100°C, more preferably 10 to 90°C, and further preferably 15 to 80°C, depending on types of the reaction solvent and extraction solvent to be removed. A pressure reducing degree in this case is preferably the atmospheric pressure or lower, more preferably 80 kPa or lower as an absolute pressure, and further preferably 50 kPa or lower as an absolute pressure, which differs depending on a type of the extraction solvent to be removed, a ventilation apparatus, a condensation apparatus, and the heating temperature.

In this case, the thermally crosslinkable polysiloxane may be destabilized by changing the solvent. This destabilization is caused by compatibility between the final solvent and the thermally crosslinkable polysiloxane. To prevent this destabilization, a monovalent or divalent or more alcohol having a cyclic ether as a substituent described in paragraphs [0181] to [0182] in JP 2009-126940 A may be added as a stabilizer. An amount of the stabilizer to be added is 0 to 25 parts by mass, preferably 0 to 15 parts by mass, and more preferably 0 to 5 parts by mass relative to 100 parts by mass of the thermally crosslinkable polysiloxane in the solution before the solvent exchange. When the stabilizer is added, the amount is preferably 0.5 parts by mass or more. As necessary, the monovalent or divalent or more alcohol having a cyclic ether as a substituent is added into the solution before the solvent exchange, and then the solvent exchange procedure is performed.

The thermally crosslinkable polysiloxane has a risk of further proceeding of the condensation reaction to change in an insoluble state in an organic solvent when condensed at a certain concentration or more. Thus, the thermally crosslinkable polysiloxane is preferably maintained as a solution state at an appropriate concentration. When the solution is too thin, the solvent amount becomes excessively large. Thus, the thermally crosslinkable polysiloxane is economically preferably maintained as a solution state at an appropriate concentration. The concentration in this case is preferably 0.1 to 20 mass%.

The final solvent added into the solution of the thermally crosslinkable polysiloxane is preferably alcoholic solvents. Particularly preferable alcoholic solvents are monoalkyl ether derivatives of ethylene glycol, diethylene glycol, triethylene glycol, propylene glycol, dipropylene glycol, butanediol, etc. Specifically, preferable solvents include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, etc.

When these solvents are the main component, non-alcoholic solvents can be added as an auxiliary solvent. Examples of the auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, and cyclopentyl methyl ether.

As another reaction procedure using the acid catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is 0 to 100°C, and preferably 10 to 80°C. A preferable method is heating during dropwise addition of the water to 10 to 50°C, and then heating to age the reaction mixture at 20 to 80°C.

When being used, the organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

An amount of the used organic solvent is preferably 0 to 1,000 ml, and particularly preferably 0 to 500 ml relative to 1 mol of the monomer. When the amount of the used organic solvent is smaller, a reaction vessel may be smaller, which is economical. The obtained reaction mixture can be after-treated in the same manner as the above method to obtain the thermally crosslinkable polysiloxane.

### (Synthesis Method 2: Alkali Catalyst)

The thermally crosslinkable polysiloxane (Sx) may also be produced by hydrolytically condensing a mixture of one or two or more types of the hydrolysable monomer (Sm) in the presence of an alkali catalyst.

Examples of the alkali catalyst used in this case include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, and calcium hydroxide. An amount of the used catalyst is 1×10⁻⁶ to 10 mol, preferably 1×10⁻⁵ to 5 mol, and more preferably 1×10⁻⁴ to 1 mol, relative to 1 mol of the silicon monomer.

An amount of water added for obtaining the thermally crosslinkable polysiloxane from the monomer via the hydrolytic condensation is preferably 0.1 to 50 mol relative to 1 mol of the hydrolysable substituent bonded to the monomer. When the amount is 50 mol or less, an apparatus used for the reaction may be small, which is economical.

As the procedure, the monomer is added into an aqueous solution of the catalyst to initiate the hydrolytic condensation reaction. In this case, an organic solvent may be added into the aqueous solution of the catalyst, the monomer may be diluted in advance with an organic solvent, or both of them may be performed. The reaction temperature is 0 to 100°C, and preferably 5 to 80°C. A preferable method is retaining the temperature to 5 to 80°C during dropwise addition of the monomer, and then aging at 20 to 80°C.

Preferably used organic solvents that can be added into the aqueous solution of the alkali catalyst or that can dilute the monomer include organic solvents same as the exemplified organic solvent that can be added into the aqueous solution of the acid catalyst. An amount of the used organic solvent is preferably 0 to 1,000 ml relative to 1 mol of the monomer for the economical reaction.

Thereafter, a neutralization reaction of the catalyst is performed as necessary to obtain an aqueous solution of the reaction mixture. In this case, an amount of an acidic substance that can be used for the neutralization is preferably 0.1 to 2 equivalents relative to the used alkaline substance as the catalyst. This acidic substance may be any substance as long as it exhibits acidity in water.

Subsequently, a byproduct such as an alcohol generated by the hydrolytic condensation reaction is preferably removed from the reaction mixture under a reduced pressure, etc. In this time, a temperature at which the reaction mixture is heated is preferably 0 to 100°C, more preferably 10 to 90°C, and further preferably 15 to 80°C, depending on types of the added organic solvent and alcohol generated in the reaction. A pressure reducing degree in this case is preferably the atmospheric pressure or lower, more preferably 80 kPa or lower as an absolute pressure, and further preferably 50 kPa or lower as an absolute pressure, which differs depending on types of the organic solvent and alcohol to be removed, a ventilation apparatus, a condensation apparatus, and the heating temperature. Although an amount of the removed alcohol in this case is difficult to be accurately determined, approximately 80 mass% or more of the generated alcohol is desirably removed.

Then, to remove the alkali catalyst used for the hydrolytic condensation, the thermally crosslinkable polysiloxane is extracted with an organic solvent. The organic solvent used in this case is preferably an organic solvent that can dissolve the thermally crosslinkable polysiloxane and that forms separated two layers with mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Further, a mixture of a water-soluble organic solvent and a water-hardly-soluble organic solvent can also be used.

Specific examples of the organic solvent used for removing the alkali catalyst include: the specifically exemplified organic solvents used for removing the acid catalyst; and a mixture same as the mixture of the water-soluble organic solvent and the water-hardly soluble organic solvent.

A mixing ratio between the water-soluble organic solvent and the water-hardly-soluble organic solvent is appropriately selected, and is 0.1 to 1,000 parts by mass, preferably 1 to 500 parts by mass, and further preferably 2 to 100 parts by mass of the water-soluble organic solvent, relative to 100 parts by mass of the water-hardly-soluble organic solvent.

Subsequently, the reaction mixture is washed with neutral water. As this water, so-called deionized water or ultrapure water is typically used. An amount of this water is 0.01 to 100 L, preferably 0.05 to 50 L, and more preferably 0.1 to 5 L, relative to 1 L of the solution of the thermally crosslinkable polysiloxane. In this washing method, the both are added into one vessel, and the mixture is stirred and left to stand to separate the aqueous layer. A washing time is one or more, and preferably one to approximately five because even ten times or more of washing may not yield an expected effect.

Into the washed solution of the thermally crosslinkable polysiloxane, a final solvent is added and solvent exchange is performed under a reduced pressure to obtain a solution of the desired thermally crosslinkable polysiloxane. A temperature of the solvent exchange in this case is preferably 0 to 100°C, more preferably 10 to 90°C, and further preferably 15 to 80°C, depending on a type of the extraction solvent to be removed. A pressure reducing degree in this case is preferably the atmospheric pressure or lower, more preferably 80 kPa or lower as an absolute pressure, and further preferably 50 kPa or lower as an absolute pressure, which differs depending on a type of the extraction solvent to be removed, a ventilation apparatus, a condensation apparatus, and the heating temperature.

The final solvent added into the solution of the thermally crosslinkable polysiloxane is preferably alcoholic solvents. Particularly preferable alcoholic solvents are monoalkyl ether such as ethylene glycol, diethylene glycol, and triethylene glycol; and monoalkyl ethers of propylene glycol, dipropylene glycol, etc. Specifically, preferable solvents include propylene glycol monomethyl ether, ethylene glycol monomethyl ether, propylene glycol monoethyl ether, ethylene glycol monoethyl ether, propylene glycol monopropyl ether, ethylene glycol monopropyl ether, and diacetone alcohol.

As another reaction procedure using the alkali catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is 0 to 100°C, and preferably 10 to 80°C. A preferable method is heating to 10 to 50°C during dropwise addition of the water, and then heating to age the reaction mixture at 20 to 80°C.

The usable organic solvent as the organic solution of the monomer or the water-containing organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

A molecular weight of the thermally crosslinkable polysiloxane obtained by the above synthetic method 1 or 2 can be regulated by not only selecting the monomer but also controlling the reaction condition of the polymerization. A preferably used thermally crosslinkable polysiloxane has a weight-average molecular weight of 100,000 or less, more preferably 200 to 50,000, and further preferably 300 to 30,000. When the thermally crosslinkable polysiloxane having a weight-average molecular weight of 100,000 or less is used, no foreign matter nor coating unevenness occurs. Note that data on the above weight-average molecular weight indicate the molecular weight in terms of polystyrene by gel permeation chromatography (GPC) using tetrahydrofuran as an eluent solvent, using RI as a detector, and using polystyrene as a standard substance.

The thermally crosslinkable polysiloxane used in the present invention has different physical properties depending on types of the acid or alkali catalyst used in the hydrolytic condensation and the reaction condition. Thus, the catalyst and the reaction condition can be appropriately selected according to target performance of the silicon-containing anti-reflective film.

Further, a polysiloxane derivative produced from a mixture of one or two or more of the hydrolysable monomer (Sm) and a hydrolysable metal compound represented by the following general formula (Mm) under the condition using the acid or alkali catalyst may be used as a component in the composition for forming a silicon-containing anti-reflective film.

**U(OR⁷)ₘ₇(OR⁸)ₘ₈** **(Mm)**

In the formula, R⁷ and R⁸ represent an organic group having 1 to 30 carbon atoms, m7+m8 is same as a valency determined by a type of U, "m7" and "m8" represent an integer of 0 or more, and U represents a III-group, IV-group, or V-group element in the periodic table except for carbon and silicon.

In the general formula (Mm), R⁷ and R⁸ represent an organic group having 1 to 30 carbon atoms, m7+m8 is same as a valency determined by a type of U, "m7" and "m8" represent an integer of 0 or more, and U represents a III-group, IV-group, or V-group element in the periodic table except for carbon and silicon.

Examples of the hydrolysable metal compound represented by the general formula (Mm) include metal alkoxides of boron, aluminum, gallium, yttrium, germanium, titanium, hafnium, etc. Specifically, compounds described in paragraphs [0107] to [0123] in JP 2020-118960 A may be used.

### (Polycarbosilane (Sy))

When the silicon-containing polymer (A) in the composition for forming a silicon-containing anti-reflective film of the present invention contains a polycarbosilane, the polysilane preferably has a unit structure represented by the following general formula (Sy-1).

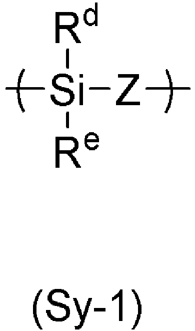

In the formula, R^{d} and R^{e} each independently represent a hydrogen atom, a hydroxy group, a halogen atom, or a monovalent organic group having 1 to 30 carbon atoms, and Z represents a substituted or unsubstituted divalent hydrocarbon group having 1 to 20 carbon atoms.

Examples of Z in the general formula (Sy-1) include a substituted or unsubstituted divalent chain hydrocarbon group having 1 to 20 carbon atoms, a substituted or unsubstituted divalent alicyclic hydrocarbon having 3 to 20 carbon atoms, and a substituted or unsubstituted divalent aromatic hydrocarbon group having 6 to 20 carbon atoms. Note that the chain hydrocarbon group herein includes both of a linear hydrocarbon group and a branched hydrocarbon group.

Examples of the unsubstituted divalent chain hydrocarbon group having 1 to 20 carbon atoms include chain saturated hydrocarbon groups such as a methanediyl group and an ethanediyl group, and chain unsaturated hydrocarbon groups such as an ethenediyl group and a propenediyl group.

Examples of the unsubstituted divalent alicyclic hydrocarbon having 3 to 20 carbon atoms include monocyclic saturated hydrocarbon groups such as a cyclobutanediyl group, monocyclic unsaturated hydrocarbon groups such as a cyclobutenediyl group, polycyclic saturated hydrocarbon groups such as a bicyclo[2.2.1]heptanediyl group, and polycyclic unsaturated hydrocarbon groups such as a bicyclo[2.2.1]heptenediyl group.

Examples of the unsubstituted divalent aromatic hydrocarbon group having 6 to 20 carbon atoms include a phenylene group, a biphenylene group, a phenyleneethylene group, and a naphthylene group.

Examples of a substituent group in the substituted divalent chain hydrocarbon group having 1 to 20 carbon atoms, the substituted divalent alicyclic hydrocarbon having 3 to 20 carbon atoms, and the substituted divalent aromatic hydrocarbon group having 6 to 20 carbon atoms represented by the Z include a halogen atom, a hydroxy group, a cyano group, a nitro group, an alkoxy group, an acyl group, and an acyloxy group.

Z preferably represents the unsubstituted chain saturated hydrocarbon group, and more preferably represents a methanediyl group or an ethanediyl group.

Examples of the monovalent organic group having 1 to 30 carbon atoms represented by R^{d} or R^{e} in the formula (Sy-1) include: a monovalent hydrocarbon group having 1 to 30 carbon atoms, preferably 1 to 20 carbon atoms; a monovalent group (α) having a divalent heteroatom-containing group between carbon-carbon of this hydrocarbon group; and a monovalent group (β) in which a part or all of hydrogen atoms in the above hydrocarbon group or the above monovalent group (α) having the divalent heteroatom-containing group are substituted with a monovalent heteroatom-containing group.

Examples of the monovalent hydrocarbon group having 1 to 30 carbon atoms include a monovalent chain hydrocarbon group having 1 to 30 carbon atoms, preferably 1 to 20 carbon atoms; a monovalent alicyclic hydrocarbon group having 3 to 30 carbon atoms, preferably 3 to 20 carbon atoms; and a monovalent aromatic hydrocarbon group having 6 to 30 carbon atoms, preferably 6 to 20 carbon atoms.

Examples of the monovalent chain hydrocarbon group having 1 to 30 carbon atoms include alkyl groups such as a methyl group and an ethyl group, alkenyl groups such as an ethenyl group, and alkynyl groups such as an ethynyl group.

Examples of the monovalent alicyclic hydrocarbon group having 3 to 30 carbon atoms include monovalent monocyclic alicyclic saturated hydrocarbon groups such as a cyclopentyl group and a cyclohexyl group, monovalent monocyclic alicyclic unsaturated hydrocarbon groups such as a cyclopentenyl group and a cyclohexenyl group, monovalent polycyclic alicyclic saturated hydrocarbon groups such as an norbornyl group and an adamantyl group, and monovalent polycyclic alicyclic unsaturated hydrocarbon groups such as a norbornenyl group and a tricyclodecenyl group.

Examples of the monovalent aromatic hydrocarbon group having 6 to 30 carbon atoms include: aryl groups such as a phenyl group, a tolyl group, a xylyl group, a naphthyl group, a methylnaphthyl group, and an anthryl group; and aralkyl groups such a benzyl group, a naphthylmethyl group, and an anthrylmethyl group.

Examples of the divalent organic group having 1 to 30 carbon atoms represented by R^{e} in the formula (Sy-1) include a divalent chain hydrocarbon group having 1 to 30 carbon atoms, a divalent alicyclic hydrocarbon group having 3 to 30 carbon atoms, and a divalent aromatic hydrocarbon group having 6 to 30 carbon atoms.

Examples of the heteroatom constituting the divalent or monovalent heteroatom-containing group include an oxygen atom, a nitrogen atom, a sulfur atom, a phosphorus atom, a silicon atom, and a halogen atom. Examples of the halogen atom include a fluorine atom, a chlorine atom, a bromine atom, and an iodine atom.

Examples of the divalent heteroatom-containing group include -O-, -CO-, -S-, -CS-, -NR'-, and a group combining two or more thereof. R' represents a hydrogen atom or a monovalent hydrocarbon group.

Examples of the monovalent heteroatom-containing group include halogen atoms such as a fluorine atom, a chlorine atom, a bromine atom, and an iodine atom, a hydroxy group, a carboxy group, a cyano group, an amino group, and a sulfanyl group.

Examples of the monovalent organic group having 1 to 30 carbon atoms represented by R^{d} or R^{e} is preferably the monovalent hydrocarbon group, more preferably the monovalent chain hydrocarbon group or the monovalent aromatic hydrocarbon group, and further preferably the alkyl group or the aryl group.

The number of carbon atoms in the monovalent organic group represented by R^{d} or R^{e} is preferably 1 or more and 10 or less, and more preferably 1 or more and 6 or less.

Examples of the halogen atom represented by R^{d} or R^{e} include a fluorine atom, a chlorine atom, a bromine atom, and an iodine atom. This halogen atom is preferably a chlorine atom or a bromine atom.

A lower limit of the content proportion of the structural unit (Sy-1) relative to all the structural units constituting the polycarbosilane (Sy) is preferably 5 mol%, more preferably 30 mol%, further preferably 60 mol%, and particularly preferably 80 mol%. Meanwhile, an upper limit of the content proportion of the structural unit (Sy-1) is not particularly limited, and may be 100 mol%. Setting the content proportion of the structural unit (Sy-1) to be within the above range can more improve collapse inhibition, oxygen-type-gas etching resistance, and solvent resistance of the resist pattern of the silicon-containing anti-reflective film formed with the composition for forming a silicon-containing anti-reflective film of the present invention.

The polycarbosilane (Sy) may have a repeating unit represented by the following formula (Sy-2) and/or the following general formula (Sy-3) other than the repeating unit represented by the general formula (Sy-1).

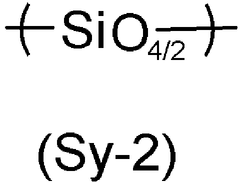

When the polycarbosilane (Sy) has the repeating unit represented by the formula (Sy-2), a lower limit of the content proportion of the structural unit (Sy-2) relative to all the structural units constituting the polycarbosilane (Sy) is preferably 0.1 mol%, more preferably 1 mol%, and further preferably 5 mol%. Meanwhile, an upper limit of the content proportion of the structural unit (Sy-2) is preferably 50 mol%, more preferably 40 mol%, further preferably 30 mol%, and particularly preferably 20 mol%.

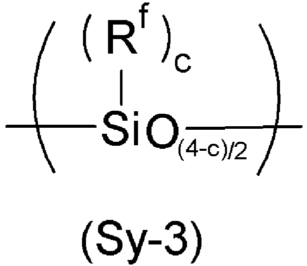

In the general formula (Sy-3), R^{f} represents a substituted or unsubstituted monovalent hydrocarbon group having 1 to 20 carbon atoms. "c" represents 1 or 2. When "c" represents 2, the two R^{f} are same as or different from each other.

The "c" preferably represents 1.

Examples of R^{f} include groups same as the monovalent hydrocarbon group having 1 to 20 carbon atoms exemplified in R^{d} or R^{e} of the above general formula (Sy-1). Examples of the substituent of the monovalent hydrocarbon group having 1 to 20 carbon atoms include groups same as the monovalent heteroatom-containing group exemplified in R^{d} or R^{e} of the above general formula (Sy-1).

R^{f} preferably represents a substituted or unsubstituted monovalent chain hydrocarbon group and a substituted or unsubstituted monovalent aromatic hydrocarbon group, more preferably an alkyl group or an aryl group, and further preferably a methyl group or a phenyl group.

When the polycarbosilane (Sy) has the repeating unit (Sy-3), a lower limit of the content proportion of the structural unit (Sy-3) relative to all the structural units constituting the polycarbosilane (Sy) is preferably 0.1 mol%, more preferably 1 mol%, and further preferably 5 mol%. An upper limit of the content proportion of the structural unit (Sy-3) is preferably 50 mol%, more preferably 40 mol%, further preferably 30 mol%, and particularly preferably 20 mol%.

The polycarbosilane (Sy) may have a structural unit having a Si-O-Si structure formed by dehydrative condensation from the hydroxy group represented by R^{d} or R^{e} in the above general formula (Sy-1), other than the above structural units.

A solvent of the polycarbosilane is preferably an alcoholic solvent or an ether solvent. The alcoholic solvent is particularly preferably ethylene glycol, diethylene glycol, triethylene glycol, propylene glycol, dipropylene glycol, diacetone alcohol, etc. The ether solvent is specifically preferably propylene glycol monomethyl ether, ethylene glycol monomethyl ether, propylene glycol monoethyl ether, ethylene glycol monoethyl ether, propylene glycol monopropyl ether, ethylene glycol monopropyl ether, etc.

As the polycarbosilane used in the present invention, commercial products may be used. For example, a polycarbosilane having a unit structure of the following formula (Sy-4) (for example, trade name: NIPSY TypeS, produced by NGS Advanced Fibers Co., Ltd., (Mn = 2,716 (GPC UV detector / in terms of polystyrene)), trade name: NIPSY Type L (number-average molecular weight: 1,000, weight-average molecular weight: 4,500)), etc. may be used. The weight-average molecular weight of the polycarbosilane used in the present invention is preferably 400 to 12,000, and more preferably 2,000 to 12,000.

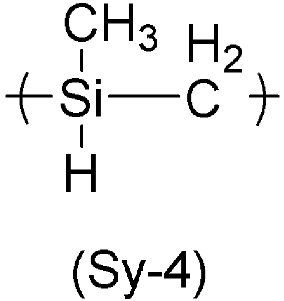

### (Polysilane (Sz))

When the silicon-containing polymer (A) used for the composition for forming a silicon-containing anti-reflective film of the present invention contains a polysilane, the polysilane preferably has a repeating unit represented by the following general formula (Sz-1).

(R⁹R¹⁰R¹¹Si)ₐ₂(R¹²R¹³Si)ₐ₃(R¹⁴Si)ₐ₄(Si)ₐ₅ (Sz-1)

In the formula, R⁹, R¹⁰, R¹¹, R¹², R¹³, and R¹⁴ each represent a methyl group, a phenyl group, or a hydroxy group. "a2", "a3", "a4", and "a5" represent a mole fraction, and a2+a3+a4+a5=1, 0≤a2≤1, 0≤a3≤1, 0≤a4≤1, and 0≤a5≤1.

Further, the polysilane may be one or more types of a polymer selected from a hydrolysate, a condensate, and a hydrolytic condensate of the above polysilane compound. The polysilane may be a hydrolytic condensate, a condensate, or a hydrolytic condensate with a polysiloxane, or may be hydrolytically condensed with the hydrolysable monomer (Sm).

As the polysilane compound represented by the general formula (Sz-1), OGSOL SI-10-10 (polymethylphenylsilane), SI-10-20 (polymethylphenylsilane), Modified SI-20-10 (polyphenylsilane), SI-30-10 (cyclic polydiphenylsilane), produced by Osaka Gas Chemicals Co., Ltd., etc. may be used. These may be reacted under an alkaline condition and reduce the molecular weight for use.

Particularly, the polysilane compound represented by the general formula (Sz-1) has a weight-average molecular weight of preferably 1,000 or less. Setting the weight-average molecular weight to be 1,000 or less facilitate to dissolve a hydrolysate, a condensate, or a hydrolytic condensate of a mixture containing the polysilane compound represented by the general formula (Sz-1) in the solvent component of the composition for forming a silicon-containing anti-reflective film, and particle generation during the film formation can be prevented.

Here, various solvents may be used as a solvent used for the reaction under the alkaline condition. For example, usable is one or more selected from: hydrocarbon solvents such as benzene, toluene, and xylene; glycol solvents such as propylene glycol monomethyl ether and propylene glycol monoethyl ether; ether solvents such as diethyl ether, diisopropyl ether, dibutyl ether, tetrahydrofuran, and 1,4-dioxane; ketone solvents such as acetone, methyl ethyl ketone, methyl isobutyl ketone, methyl amyl ketone, cyclopentanone, and cyclohexanone; and alcoholic solvents such as ethanol, isopropyl alcohol, and butanol.

Various bases may be used as a base to be added. For example, inorganic bases such as sodium hydroxide, potassium hydroxide, barium hydroxide, ammonia, tetramethylammonium hydroxide, sodium carbonate, sodium hydrogen carbonate, potassium carbonate, lithium hydride, sodium hydride, potassium hydride, and calcium hydride; alkyl metals such as methyllithium, n-butyllithium, methylmagnesium chloride, and ethylmagnesium bromide; alkoxides such as sodium methoxide, sodium ethoxide, and potassium t-butoxide; and organic bases such as triethylamine, diisopropylethylamine, N,N-dimethylaniline, pyridine, 4-dimethylaminopyridine, and diazabicycloundecene (DBU) may be used. The reaction temperature is preferably -50°C to about a boiling point of the solvent, and further preferably room temperature to 100°C.

The hydrolysis, condensation, or hydrolytic condensation reaction may be performed by using one or more compounds selected from inorganic acids, aliphatic sulfonic acids, and aromatic sulfonic acids as an acid catalyst. Examples of the acid catalyst used in this case include hydrofluoric acid, hydrochloric acid, hydrobromic acid, sulfuric acid, nitric acid, perchloric acid, phosphoric acid, methanesulfonic acid, benzenesulfonic acid, and toluenesulfonic acid. A use amount of the catalyst is preferably 10⁻⁶ to 10 mol, more preferably 10⁻⁵ to 5 mol, and further preferably 10⁻⁴ to 1 mol relative to 1 mol of the monomer.

An amount of water added for synthesizing the polymer by hydrolytically condensing these monomers is preferably 0.01 to 100 mol, more preferably 0.05 to 50 mol, and further preferably 0.1 to 30 mol per mole of the hydrolysable substituent bonded to the monomer. When the addition amount is 100 mol or less, an apparatus used for the reaction is not excessively large, which is economical. When the addition amount is 0.01 mol or more, the reaction proceeds.

As the procedure, the monomer is added into an aqueous solution of the catalyst to initiate the hydrolytic condensation reaction. In this case, an organic solvent may be added into the aqueous solution of the catalyst, the monomer may be diluted in advance with an organic solvent, or both of them may be performed. The reaction temperature is preferably 0 to 100°C, and more preferably 5 to 80°C. A preferable method is retaining the temperature to 5 to 80°C during dropwise addition of the monomer, and then aging at 20 to 80°C.

Examples of preferable organic solvents that can be added into the aqueous solution of the catalyst or that can dilute the monomer include methanol, ethanol, 1-propanol, 2-propanol, 1-butanol, 2-butanol, 2-methyl-1-propanol, acetone, acetonitrile, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, and a mixture thereof.

More preferable solvents among these are water-soluble solvents. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone; acetonitrile; and tetrahydrofuran. Particularly preferable solvents among these have a boiling point of 100°C or lower.

An amount of the used organic solvent is preferably 0 to 1,000 mL, and particularly preferably 0 to 500 mL relative to 1 mol of the monomer. When the amount of the used organic solvent is 1,000 mL or less, a reaction vessel may be not excessively large, which is economical.

Thereafter, a neutralization reaction of the catalyst is performed as necessary, and the alcohol generated in the hydrolytic condensation reaction is removed under a reduced pressure to obtain an aqueous solution of the reaction mixture. In this case, an amount of a basic substance that can be used for the neutralization is preferably 0.1 to 2 equivalents relative to the acid used as the catalyst. This basic substance may be any substance as long as it exhibits basicity in water.

Subsequently, a byproduct such as an alcohol, which is generated by the hydrolytic condensation reaction, is preferably removed from the reaction mixture. In this time, a temperature at which the reaction mixture is heated is preferably 0 to 100°C, more preferably 10 to 90°C, and further preferably 15 to 80°C, depending on types of the added organic solvent, alcohol generated in the reaction, etc. A pressure reducing degree in this case is preferably the atmospheric pressure or lower, more preferably 80 kPa or lower as an absolute pressure, and further preferably 50 kPa or lower as an absolute pressure, which differs depending on types of the organic solvent, alcohol, etc. to be removed, a ventilation apparatus, a condensation apparatus, and the heating temperature. Although an amount of the removed alcohol in this case is difficult to be accurately determined, approximately 80 mass% or more of the generated alcohol etc. is desirably removed.

Then, the acid catalyst used for the hydrolytic condensation may be removed from the reaction mixture. As a method for removing the acid catalyst, water and the polymer are mixed, and the polymer is extracted with an organic solvent. The organic solvent used in this case is preferably an organic solvent that can dissolve the polymer and that forms separated two layers with mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Further, a mixture of a water-soluble organic solvent and a water-hardly-soluble organic solvent can also be used. Examples of preferable mixtures include methanol + ethyl acetate, ethanol + ethyl acetate, 1-propanol + ethyl acetate, 2-propanol + ethyl acetate, butanediol monomethyl ether + ethyl acetate, propylene glycol monomethyl ether + ethyl acetate, ethylene glycol monomethyl ether + ethyl acetate, butanediol monoethyl ether + ethyl acetate, propylene glycol monoethyl ether + ethyl acetate, ethylene glycol monoethyl ether + ethyl acetate, butanediol monopropyl ether + ethyl acetate, propylene glycol monopropyl ether + ethyl acetate, ethylene glycol monopropyl ether + ethyl acetate, methanol + methyl isobutyl ketone, ethanol + methyl isobutyl ketone, 1-propanol + methyl isobutyl ketone, 2-propanol + methyl isobutyl ketone, propylene glycol monomethyl ether + methyl isobutyl ketone, ethylene glycol monomethyl ether + methyl isobutyl ketone, propylene glycol monoethyl ether + methyl isobutyl ketone, ethylene glycol monoethyl ether + methyl isobutyl ketone, propylene glycol monopropyl ether + methyl isobutyl ketone, ethylene glycol monopropyl ether + methyl isobutyl ketone, methanol + cyclopentyl methyl ether, ethanol + cyclopentyl methyl ether, 1-propanol + cyclopentyl methyl ether, 2-propanol + cyclopentyl methyl ether, propylene glycol monomethyl ether + cyclopentyl methyl ether, ethylene glycol monomethyl ether + cyclopentyl methyl ether, propylene glycol monoethyl ether + cyclopentyl methyl ether, ethylene glycol monoethyl ether + cyclopentyl methyl ether, propylene glycol monopropyl ether + cyclopentyl methyl ether, ethylene glycol monopropyl ether + cyclopentyl methyl ether, methanol + propylene glycol methyl ether acetate, ethanol + propylene glycol methyl ether acetate, 1-propanol + propylene glycol methyl ether acetate, 2-propanol + propylene glycol methyl ether acetate, propylene glycol monomethyl ether + propylene glycol methyl ether acetate, ethylene glycol monomethyl ether + propylene glycol methyl ether acetate, propylene glycol monoethyl ether + propylene glycol methyl ether acetate, ethylene glycol monoethyl ether + propylene glycol methyl ether acetate, propylene glycol monopropyl ether + propylene glycol methyl ether acetate, and ethylene glycol monopropyl ether + propylene glycol methyl ether acetate. The combination is not limited thereto.

A mixing ratio between the water-soluble organic solvent and the water-hardly-soluble organic solvent is appropriately selected, and is preferably 0.1 to 1,000 parts by mass, more preferably 1 to 500 parts by mass, and further preferably 2 to 100 parts by mass of the water-soluble organic solvent relative to 100 parts by mass of the water-hardly-soluble organic solvent.

Subsequently, the reaction mixture may be washed with neutral water. As this water, so-called deionized water or ultrapure water is typically used. An amount of this water is preferably 0.01 to 100 L, more preferably 0.05 to 50 L, and further preferably 0.1 to 5 L relative to 1 L of the solution of the polymer. In this washing method, the both are added into one vessel, and the mixture is stirred and then left to stand to separate the aqueous layer. A washing time is one or more, and preferably one to approximately five because even ten times or more of washing may not yield an expected effect.

This washing procedure with water may allow a part of the polymer to escape into the aqueous layer and yield an effect approximately same as a fractioning procedure. Thus, the washing time with water and the amount of washing water are appropriately selected with considering the effect of removing the catalyst and the effect of fractioning.

Examples of another method for removing the acid catalyst include: a method with an ion-exchange resin; and a method of neutralization with an epoxy compound such as ethylene oxide and propylene oxide, and then removing the neutralized product. These methods can be appropriately selected according to the acid catalyst used for the reaction.

In any cases of the polymer with a remained acid catalyst and the solution of the polymer with removed acid catalyst, a final solvent is added and solvent exchange is performed under a reduced pressure to obtain a solution of the polymer. A temperature of the solvent exchange in this case is preferably 0 to 100°C, more preferably 10 to 90°C, and further preferably 15 to 80°C, depending on types of the reaction solvent and extraction solvent to be removed. A pressure reducing degree in this case is preferably the atmospheric pressure or lower, more preferably 80 kPa or lower as an absolute pressure, and further preferably 50 kPa or lower as an absolute pressure, which differs depending on a type of the extraction solvent to be removed, a ventilation apparatus, a condensation apparatus, and the heating temperature.

In this case, the polymer may be destabilized by exchanging the solvent. This destabilization is caused by compatibility between the final solvent and the polymer. To prevent this destabilization, a monohydric or dihydric or more alcohol having a cyclic ether as a substituent or an ether compound may be added as a stabilizer. An amount of the stabilizer to be added is preferably 0 to 25 parts by mass, more preferably 0 to 15 parts by mass, and further preferably 0 to 5 parts by mass relative to 100 parts by mass of the polymer in the solution before the solvent exchange. When the stabilizer is added, the amount is preferably 0.5 parts by mass or more. As necessary, the stabilizer is added into the solution before the solvent exchange, and then the solvent exchange procedure is performed.

The concentration of the polymer is preferably 0.1 to 20 mass%. Such a concentration prevents proceeding of the condensation reaction of the polymer to change in an insoluble state in an organic solvent. In addition, such a concentration is economical because the amount of the solvent is an appropriate amount.

The final solvent added into the polymer is preferably alcoholic solvents. Particularly preferable alcoholic solvents are monoalkyl ether derivatives of ethylene glycol, diethylene glycol, triethylene glycol, propylene glycol, dipropylene glycol, butanediol, etc. Specifically, preferable solvents are butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, etc.

When these solvents are the main component, non-alcoholic solvents can be added as an auxiliary solvent. Examples of the auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether.

As another reaction procedure, water or a water-containing organic solvent may be added into the monomer or an organic solution of the monomer to initiate the hydrolysis reaction. In this case, the acid catalyst may be added into the monomer or the organic solution of the monomer, or may be added in advance into the water or the water-containing organic solvent. The reaction temperature is preferably 0 to 100°C, and more preferably 10 to 80°C. A preferable method is heating to 10 to 50°C during dropwise addition of the water, and then heating to age the reaction mixture at 20 to 80°C.

When being used, the organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

An amount of the used organic solvent in this case may be same as the above amount. The obtained reaction mixture can be after-treated by the method same as above to obtain the polymer.

The hydrolysis, condensation, or hydrolytic condensation reaction to synthesize the polymer may be performed by using a basic catalyst. Examples of the basic catalyst used in this case include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, and calcium hydroxide. An amount of the used catalyst may be same as the amount in the case where the above acid catalyst is used.

An amount of water added for obtaining the polymer from these monomers is preferably 0.1 to 50 mol relative to 1 mol of the hydrolysable substituent bonded to the monomer. When the amount is 50 mol or less, an apparatus used for the reaction is not excessively large, which is economical. The reaction proceeds with the addition amount of 0.1 mol or more.

The reaction procedure may be same as the method in the case where the above acid catalyst is used.

As the organic solvents that can be added into the aqueous solution of the catalyst or that can dilute the monomer, solvents similar to the organic solvents in the case where the above acid catalyst is used is preferably used. An amount of the used organic solvent is preferably 0 to 1,000 mL relative to 1 mol of the monomer. When the amount is as above, a reaction vessel is not excessively large, which is economical.

Thereafter, neutralization reaction of the catalyst is performed as necessary, and an alcohol generated by the hydrolytic condensation reaction is removed under a reduced pressure to obtain an aqueous solution of the reaction mixture. In this case, an amount of an acidic substance that can be used for the neutralization is preferably 0.1 to 2 equivalents relative to the used alkaline substance as the catalyst. This acidic substance may be any substance as long as it exhibits acidity in water.

Subsequently, a byproduct such as an alcohol, generated by the hydrolytic condensation reaction is preferably removed from the reaction mixture. The temperature for heating the reaction mixture and the pressure reducing degree in this case may be the temperature and the pressure reducing degree same as a case where the above acid catalyst is used.

Then, the basic catalyst used for the hydrolytic condensation may be removed from the reaction mixture. As an organic solvent used for removing the basic catalyst, organic solvents same as in a case where the above acid catalyst is used may be used.

The basis catalyst may also be removed by using a mixture of a water-soluble organic solvent and a water-hardly-soluble organic solvent same as a case where the above acid catalyst is used. The mixing ratio between the water-soluble organic solvent and the water-hardly-soluble organic solvent may be same ratio as a case where the above acid catalyst is used.

Subsequently, the reaction mixture may be washed with neutral water. The washing method may be same as in a case where the above acid catalyst is used.

Into the washed polymer, a final solvent is added and solvent exchange is performed under a reduced pressure to obtain a polymer solution. The temperature and the pressure reducing degree for the solvent exchange may be the temperature and the pressure reducing degree may be same as in a case where the above acid catalyst is used.

In this case, a monohydric or dihydric or more alcohol having a cyclic ether as a substituent or an ether compound may be added as a stabilizer same as in a case of using the above acid catalyst. A concentration of the polymer solution is preferably set to 0.1 to 20 mass%.

The final solvent added into the polymer is preferably alcoholic solvents or ether solvents. The alcoholic solvent is particularly preferably ethylene glycol, diethylene glycol, triethylene glycol, propylene glycol, dipropylene glycol, etc. The ether solvent is specifically preferably propylene glycol monomethyl ether, ethylene glycol monomethyl ether, propylene glycol monoethyl ether, ethylene glycol monoethyl ether, propylene glycol monopropyl ether, ethylene glycol monopropyl ether, etc.

When these solvents are the main component, non-alcoholic solvents can be added as an auxiliary solvent. As this auxiliary solvent, the auxiliary solvent same as a case where the above acid catalyst is used may be used.

As another reaction procedure, water or a water-containing organic solvent may be added into the monomer or an organic solution of the monomer to initiate the hydrolysis reaction. In this case, the basic catalyst may be added into the monomer or the organic solution of the monomer, or may be added in advance into the water or the water-containing organic solvent. The reaction temperature is preferably 0 to 100°C, and more preferably 10 to 80°C. A preferable method is heating to 10 to 50°C during dropwise addition of the water, and then heating to age the reaction mixture at 20 to 80°C.

When being used, the organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

An amount of the used organic solvent in this case may be same as the above amount. The obtained reaction mixture can be after-treated by the same method as above to obtain the polymer.

A molecular weight of the polymer obtained by the above reaction can be regulated by not only selecting the monomer but also controlling the reaction condition of the polymerization. The molecular weight of the obtained polymer is not particularly limited, and a preferably used thermally crosslinkable polysiloxane has a weight-average molecular weight of 100,000 or less, more preferably 200 to 50,000, further preferably 300 to 30,000. When the thermally crosslinkable polysiloxane having a weight-average molecular weight of 100,000 or less is used, no foreign matter nor coating unevenness occurs. Note that data on the above weight-average molecular weight indicate the molecular weight in terms of polystyrene by gel permeation chromatography (GPC) using tetrahydrofuran as an eluent solvent, using RI as a detector, and using polystyrene as a standard substance.

From the viewpoints of anti-reflective performance and raw material availability, the silicon-containing polymer (A) contained in the composition for forming a silicon-containing anti-reflective film of the present invention preferably contains the polysiloxane (Sx).

### <(B) Organic Polymer>

The organic polymer (B) contained in the composition for forming a silicon-containing anti-reflective film of the present invention has two or more hydroxy groups in a repeating unit structure of the polymer, and has no silicon. The organic polymer (B) preferably has the following general formula (1B) or (2B) .

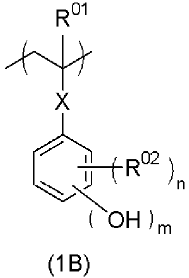

In the formula, R⁰¹ represents a hydrogen atom or a methyl group, R⁰² represents an alkyl group having 1 to 3 carbon atoms or a halogen atom, "m" represents an integer of 2 to 5, "n" represents an integer of 0 to 3, and m+n represents an integer of 2 or more and 5 or less. X represents a single bond or an alkylene group having 1 to 10 carbon atoms and optionally having one or more selected from an oxygen atom and a nitrogen atom.

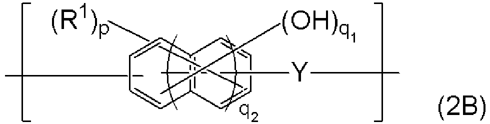

In the formula, R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, q₁ represents an integer of 2 to 6, p+q₁ represents an integer of 2 or more and 6 or less, and q₂ represents 0 or 1.

The organic polymer (B) contained in the composition for forming a silicon-containing anti-reflective film of the present invention may have a structural unit different from the structure of the general formula (1B) or (2B). However, to achieve the anti-reflective effect and to minimize deterioration of thin-film formability of the silicon-containing anti-reflective film formed by using the composition for forming a silicon-containing anti-reflective film, the content of the structural units of the general formulae (1B) and (2B) contained in the organic polymer (B) is preferably 50% or more, further preferably 75% or more, and particularly preferably 100%.

### (Organic Polymer (1B))

The organic polymer (B) is preferably a polymer compound having a repeating unit represented by the following general formula (1B).

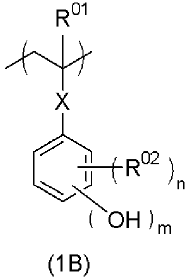

In the formula, R⁰¹ represents a hydrogen atom or a methyl group, R⁰² represents an alkyl group having 1 to 3 carbon atoms or a halogen atom, "m" represents an integer of 2 to 5, "n" represents an integer of 0 to 3, and m+n represents an integer of 2 or more and 5 or less. X represents a single bond or an alkylene group having 1 to 10 carbon atoms and optionally having one or more selected from an oxygen atom and a nitrogen atom.

In the general formula (1B), R⁰¹ represents a hydrogen atom or a methyl group, and preferably a methyl group. R⁰² represents an alkyl group having 1 to 3 carbon atoms or a halogen atom. "m" represents an integer of 2 to 5, "n" represents an integer of 0 to 3, and m+n represents an integer of 2 or more and 5 or less. Preferably, "m" represents an integer of 2, "n" represents an integer of 0 or 1, and m+n represents an integer of 2 or more and 3 or less. Further preferably, "m" represents 2, "n" represents 0, and m+n represents 2.

In the general formula (1B), X represents a single bond or an alkylene group having 1 to 10 carbon atoms and optionally having one or more selected from an oxygen atom and a nitrogen atom. The oxygen atom in the X may form a carbonyl group, a hydroxy group, or an ether bond. For example, the ester bond is an alkylene group having 1 carbon atom containing the oxygen atom. The nitrogen atom in the X may form an amino group. Further, the X may have the oxygen atom and the nitrogen atom. For example, an amide bond is an alkylene group having 1 carbon atom containing the oxygen atom and the nitrogen atom.

Specific examples of the X include, but not limited to, the following groups.

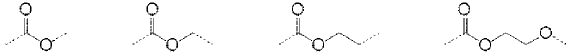

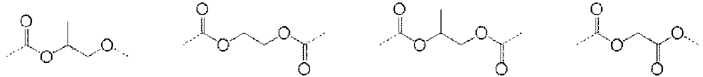

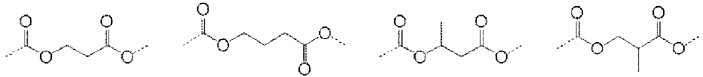

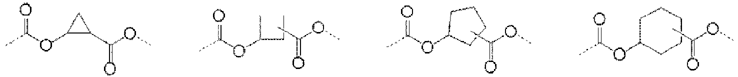

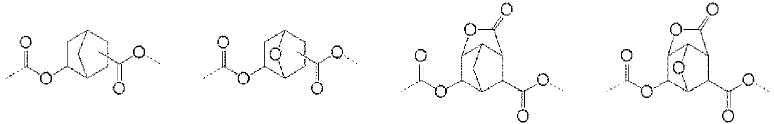

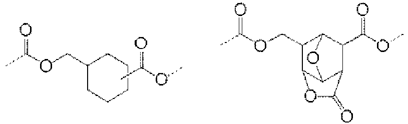

In the formulae, a broken line represents an attachment point.

Examples of R⁰² in the general formula (1B) include a methyl group, an ethyl group, a propyl group, and an isopropyl group, and R⁰² preferably represents a methyl group from the viewpoint of adhesiveness to the resist upper layer film.

Specific examples of the resin represented by the general formula (1B) include, but not limited to, the following resins. In the formulae, R⁰¹ and R⁰² are same as above.

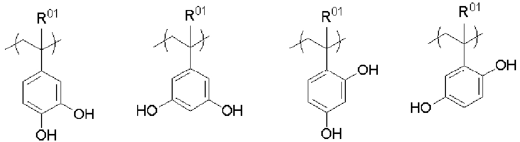

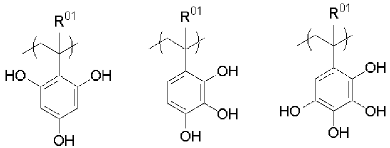

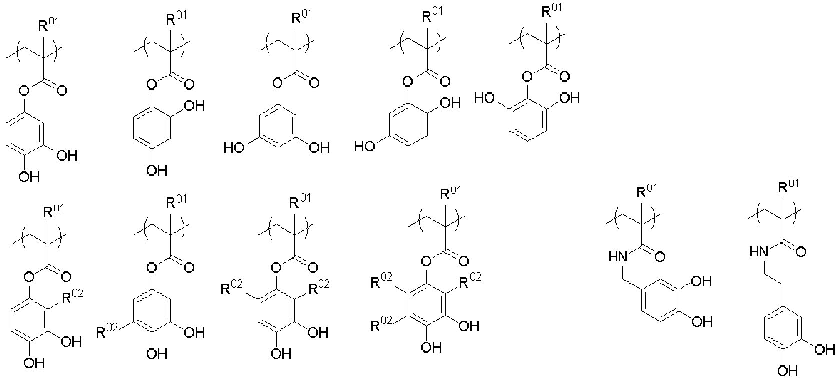

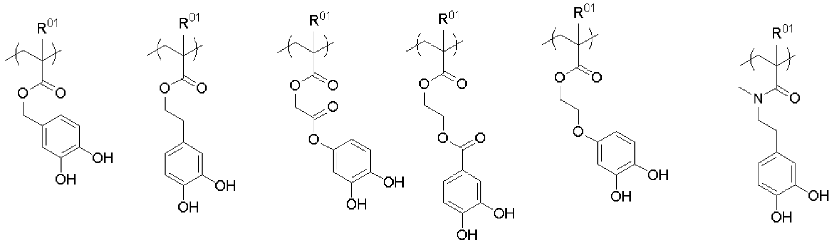

The composition for forming a silicon-containing anti-reflective film containing these resins can form the silicon-containing anti-reflective film having excellent thin-film formability.

The organic polymer (B) may further have either or both of a repeating unit represented by the following general formula (1B-1) and a repeating unit represented by the following general formula (1B-2).

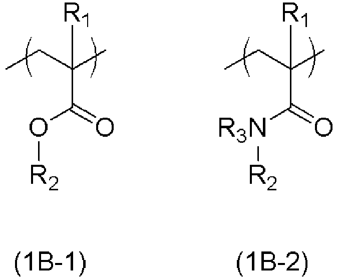

In the formulae, R₁ represents a hydrogen atom or a methyl group, R₂ represents a monovalent organic group having a heterocyclic structure and 2 to 20 carbon atoms, and R₃ represents a hydrogen atom or a linear or branched alkyl group having 1 to 3 carbon atoms.

The organic polymer (B) having either or both of the repeating unit represented by the general formula (1B-1) and the repeating unit represented by the general formula (1B-2) can more improve adhesiveness to the underlayer substrate, and can exhibit excellent thin-film formability.

The R₃ represents a hydrogen atom or a linear or branched alkyl group having 1 to 3 carbon atoms, and preferably a hydrogen atom.

The heterocyclic structure contained in R₂ of the polymer compound having any one of the repeating units represented by the general formulae (1B-1) and (1B-2) is preferably a heterocyclic structure having an oxygen atom.

Containing such a heterocyclic structure yields higher adhesiveness to the underlayer substrate.

The R₂ preferably represents a monovalent organic group having a group selected from a group consisting of the following formulae (R₂-1) to (R₂-3).

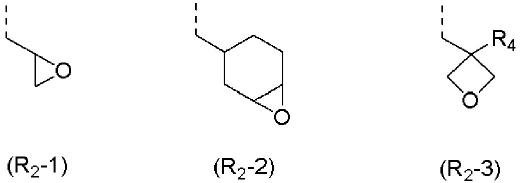

In the formula, R₄ represents a hydrogen atom or an alkyl group having 1 to 10 carbon atoms, and a broken line represents an attachment point.

Containing such a structure yields higher adhesiveness to the underlayer substrate.

Specific examples of the repeating unit represented by the general formula (1B-1) or (1B-2) preferably include the following structures.

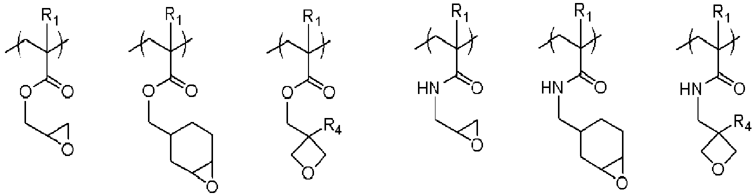

In the formulae, R₁ and R₄ are same as above.

When the organic polymer (B) is the polymer compound having the repeating unit represented by the general formula (1B) and having any one of the repeating units represented by the general formulae (1B-1) and (1B-2), a content proportion of the repeating units represented by the general formulae (1B-1) and (1B-2) is preferably 5 mol% or more and 50 mol% or less relative to all the repeating units. The content proportion is more preferably 10 mol% or more and 30 mol% or less.

### (Organic Polymer (2B))

The organic polymer (B) is preferably a polymer compound having a repeating unit represented by the following general formula (2B).

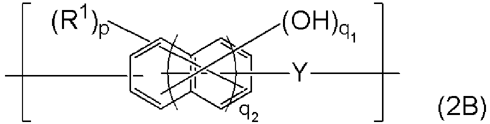

In the formula, R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, "q₁" represents an integer of 2 to 6, p+q₁ represents an integer of 2 or more and 6 or less, and "q₂" represents 0 or 1.

In the general formula (2B), R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, "q₁" represents an integer of 2 to 6, p+q₁ represents an integer of 2 or more and 6 or less, and "q₂" represents 0 or 1.

Here, when q₂ represents 0, "p" represents an integer of 0 to 2, "q₁" represents an integer of 2 to 4, and p+q₁ represents an integer of 2 or more and 4 or less. When "q₂" represents 1, "p" represents an integer of 0 to 5, "q₁" represents an integer of 2 to 6, and p+q₁ represents an integer of 2 or more and 6 or less.

In the general formula (2B), "q₁" preferably represents 2 or 3, and more preferably 2. "q₂" represents 0 or 1, and preferably 0 from the viewpoint of dry-etching resistance.

In the general formula (2B), examples of the saturated monovalent organic group having 1 to 30 carbon atoms represented by R¹ include an alkyl group having 1 to 10 carbon atoms. Examples of the unsaturated monovalent organic group having 2 to 30 carbon atoms represented by R¹ include a vinyl group, an allyl group, an ethynyl group, an allyloxy group, and a propargyl group. Examples of the halogen atom represented by R¹ include a fluorine atom, a chlorine atom, a bromine atom, and an iodine atom.

In the general formula (2B), examples of the divalent organic group having 1 to 30 carbon atoms represented by Y include: alkanediyl groups such as a methylene group, an ethanediyl group, a propanediyl group, a butanediyl group, a pentanediyl group, a hexanediyl group, an octanediyl group, and a decanediyl group; monocyclic cycloalkanediyl groups such as a cyclopropanediyl group, a cyclobutanediyl group, a cyclopentanediyl group, a cylohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups such as a bicyclo[2.2.1]heptanediyl group, a bicyclo[2.2.2]octanediyl group, a tricyclo[5.2.1.0^{2,6}]decanediyl group (dicyclopentylene group), a tricyclo[3.3.1.1^{3,7}]decanediyl group, a tetracyclo[6.2.1.1^{3,6}.0^{2,7}]dodecanediyl group, and an adamantanediyl group; and arenediyl groups such as a phenylene group and a naphthylene group.

Examples of the alkanediyloxy group represented by the Y include a group combining the above alkanediyl group and an oxygen atom. Examples of the cycloalkanediyloxy group represented by the Y include a group combining the above cycloalkanediyl group and an oxygen atom.

A part or all of hydrogen atoms in the alkanediyl group, the cycloalkanediyl group, the alkanediyloxy group, the cycloalkanediyloxy group, and the arenediyl group are optionally substituted. Examples of the substituent include groups same as the substituent examples that may be contained in the organic group represented by R^{a1} described later.

Examples of the organic group represented by the Y include groups represented by the following formulae.

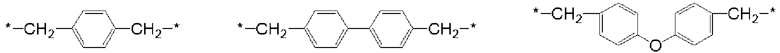

In the formulae, "*" represents an attachment point.

Preferable examples of the Y include a methylene group from the viewpoint of availability of the raw material.

Specific examples of the resin having the structural unit represented by the general formula (2B) include the following resins.

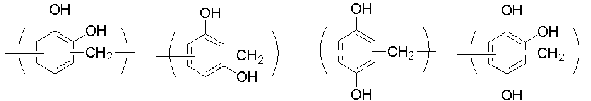

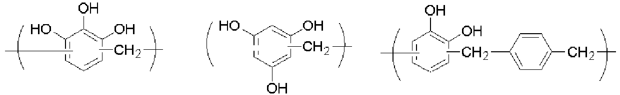

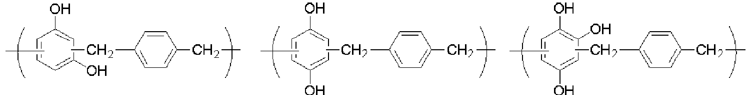

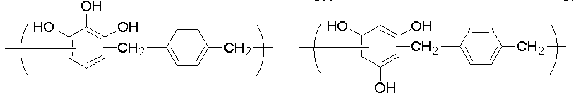

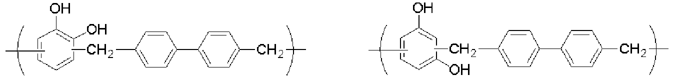

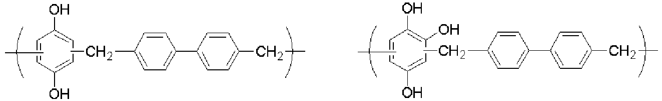

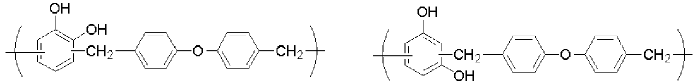

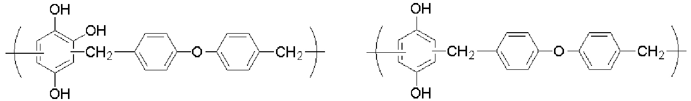

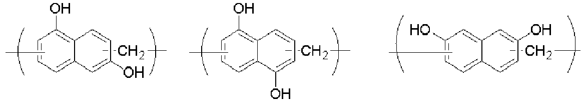

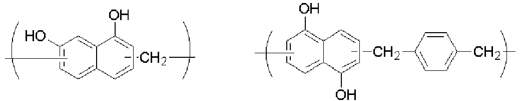

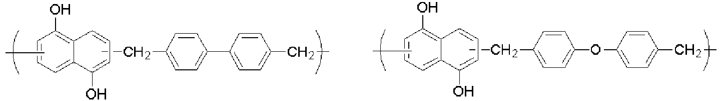

In the formulae, a hydrogen atom on an aromatic ring having a hydroxy group may be substituted with the R¹.

A content of the organic polymer (B) contained in the composition for forming a silicon-containing anti-reflective film of the present invention is preferably within a range of 1 to 50 parts by mass, more preferably within a range of 3 to 30 parts by mass, and further preferably within a range of 5 to 15 parts by mass relative to 100 parts by mass of the silicon-containing polymer (A).

The composition for forming a silicon-containing anti-reflective film containing the organic polymer (B) within such a range can highly achieve both dry-etching resistance of the silicon-containing anti-reflective film formed by using this composition and thin-film formability. When the content of the organic polymer (B) is 1 part by mass or more, thin-film formability of the composition for forming a silicon-containing anti-reflective film does not deteriorate. When the content of the organic polymer (B) is 50 parts by mass or less, the anti-reflective function and etching resistance of the silicon-containing anti-reflective film formed with the composition for forming a silicon-containing anti-reflective film do not deteriorate.

A weight-average molecular weight Mw of the organic polymer (B) contained in the composition for forming a silicon-containing anti-reflective film of the present invention is within a range of preferably 1,500≤Mw≤20,000, further preferably 3,000≤Mw≤15,000, and particularly preferably 4,000≤Mw≤9,000 in terms of polystyrene by gel permeation chromatography.

The organic polymer (B) having a molecular weight within the above range can form the silicon-containing anti-reflective film exhibiting excellent film-formability for forming a thin film. In addition, the silicon-containing anti-reflective film having excellent film-thickness uniformity and inhibition of defects derived from sublimates can be formed. The weight-average molecular weight Mw of the organic polymer (B) of 1,500 or more reduces an outgas component of the organic polymer (B), and does not deteriorate thin-film formability and film-thickness uniformity of the silicon-containing anti-reflective film. In addition, defect derived from sublimates is reduced. The weight-average molecular weight Mw of the organic polymer (B) of 20,000 or less does not deteriorate thermal flowability of the organic polymer (B) and the composition for forming a silicon-containing anti-reflective film of the present invention containing the organic polymer (B), and does not deteriorate thin-film formability of the silicon-containing anti-reflective film.

The organic polymer (B) may further have a repeating unit represented by the following general formula (2B-1).

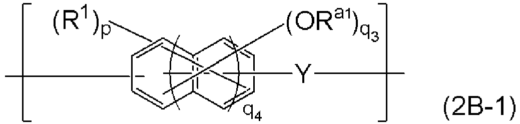

In the general formula (2B-1), R¹ represents a saturated monovalent organic group having 1 to 30 carbon atoms or an unsaturated monovalent organic group having 2 to 30 carbon atoms, Y represents a divalent organic group having 1 to 30 carbon atoms, R^{a1} represents an optionally substituted saturated or unsaturated monovalent organic group having 1 to 30 carbon atoms, "p" represents an integer of 0 to 5, "q₃" represents an integer of 1 to 6, p+q₃ represents an integer of 1 or more and 6 or less, and "q₄" represents 0 or 1.

In the general formula (2B-1), R¹ represents a saturated monovalent organic group having 1 to 30 carbon atoms or an unsaturated monovalent organic group having 2 to 30 carbon atoms, Y represents a divalent organic group having 1 to 30 carbon atoms, R^{a1} represents an optionally substituted saturated or unsaturated monovalent organic group having 1 to 30 carbon atoms, "p" represents an integer of 0 to 5, "q₃" represents an integer of 1 to 6, p+q₃ represents an integer of 1 or more and 6 or less, and "q₄" represents 0 or 1.

Here, when "q₄" represents 0, "p" represents an integer of 0 to 3, "q₃" represents an integer of 1 to 4, and p+q₃ represents an integer of 2 or more and 4 or less. When "q₄" represents 1, "p" represents 0 to 5, "q₃" represents an integer of 1 to 6, and p+q₃ represents an integer of 1 or more and 6 or less.

In the general formula (2B-1), examples of the saturated monovalent organic group having 1 to 30 carbon atoms and the unsaturated monovalent organic group having 2 to 30 carbon atoms represented by R¹ include groups same as R¹ in the general formula (2B).

In the general formula (2B-1), examples of the divalent organic group having 1 to 30 carbon atoms represented by Y include: alkanediyl groups such as a methylene group, an ethanediyl group, a propanediyl group, a butanediyl group, a pentanediyl group, a hexanediyl group, an octanediyl group, and a decanediyl group; monocyclic cycloalkanediyl groups such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups such as a bicyclo[2.2.1]heptanediyl group, a bicyclo[2.2.2]octanediyl group, a tricyclo[5.2.1.0^{2,6}]decanediyl group (dicyclopentylene group), a tricyclo[3.3.1.1^{3,7}]decanediyl group, a tetracyclo[6.2.1.1^{3,6}.0^{2,7}]dodecanediyl group, and an adamantanediyl group; and arenediyl groups such as a phenylene group and a naphthylene group.

Examples of the alkanediyloxy group represented by the Y include a group combining the above alkanediyl group and an oxygen atom. Examples of the cycloalkanediyloxy group represented by the Y include a group combining the above cycloalkanediyl group and an oxygen atom.

A part or all of hydrogen atoms in the alkanediyl group, the cycloalkanediyl group, the alkanediyloxy group, the cycloalkanediyloxy group, and the arenediyl group are optionally substituted. Examples of the substituent include groups same as the substituent examples that may be contained in the organic group represented by R^{a1} described later.

Examples of the organic group represented by the Y include groups represented by the following formulae.

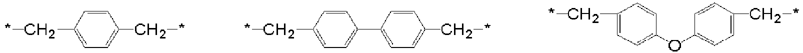

In the formulae, "*" represents an attachment point.

Preferable examples of the Y include a methylene group from the viewpoint of availability of the raw material.

Specific examples of the resin having the structural unit represented by the general formula (2B-1) include the following resins.

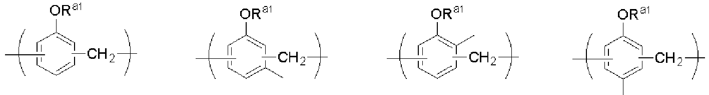

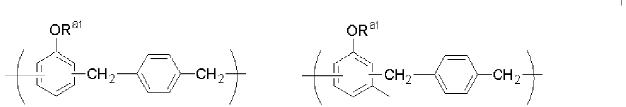

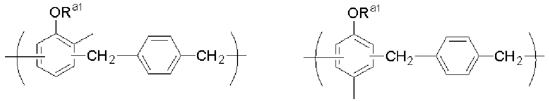

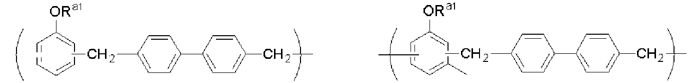

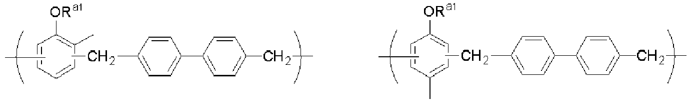

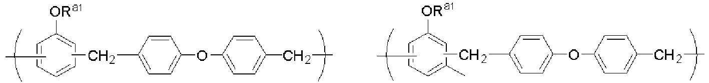

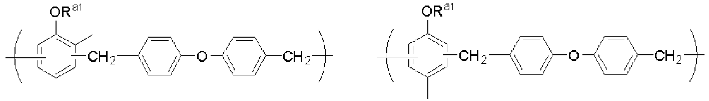

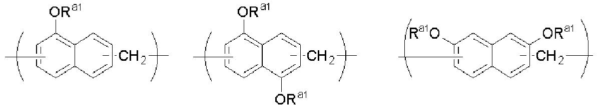

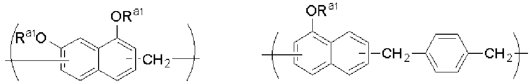

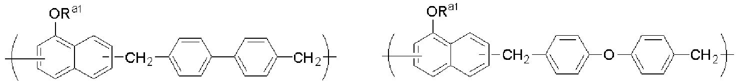

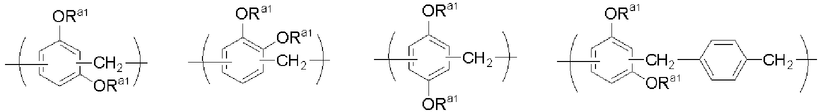

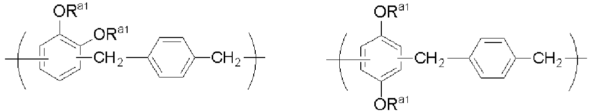

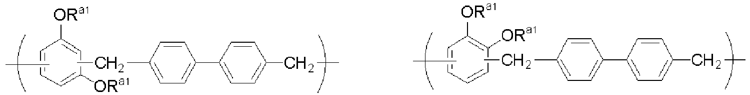

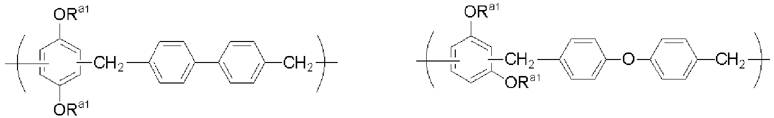

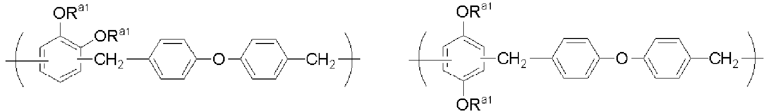

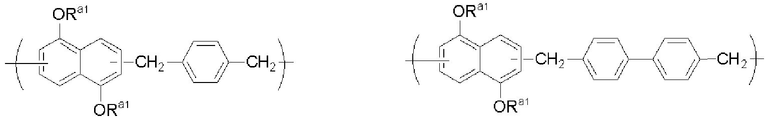

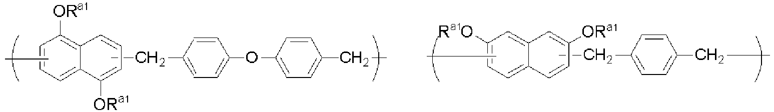

In the formulae, R^{a1} is same as above.

Examples of the substituent that the organic group represented by R^{a1} may have include a saturated or unsaturated monovalent organic group having 1 to 30 carbon atom that is optionally substituted.

From the viewpoint of the thermal curability, the R^{a1} preferably represents any one of an alkyl group having 1 to 10 carbon atoms and a structure represented by the following general formula (b-1).

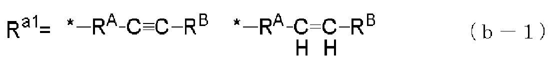

In the general formula (b-1), "*" represents a bonding position to the oxygen atom, R^{A} represents an optionally substituted divalent organic group having 1 to 10 carbon atoms, and R^{B} represents a hydrogen atom or an optionally substituted monovalent organic group having 1 to 10 carbon atoms.

From the viewpoint of thermal flowability, the general formula (b-1) is more preferably the following structure.

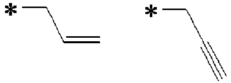

"*" represents a bonding portion to the oxygen atom.

The organic polymer (B) having the repeating unit represented by the above structure improves the thermal flowability, and thereby thin-film formability of the silicon-containing anti-reflective film can be more improved.

When the organic polymer (B) is the polymer compound having the repeating unit represented by the general formula (2B) and having the repeating unit represented by the general formula (2B-1), a content proportion of the repeating unit represented by the general formula (2B-1) is preferably 5 mol% or more and 50 mol% or less relative to all the repeating units. The content proportion is more preferably 10 mol% or more and 30 mol% or less.

### <(C) Organic Solvent>

The organic solvent (C) usable for the composition for forming a silicon-containing anti-reflective film of the present invention is not particularly limited as long as the solvent dissolves or disperses the aforementioned silicon-containing polymer (A) and organic polymer (B), and if contained, a crosslinking agent (D), an acid generator (E), a surfactant (F), a pigment (H), and other additives described later.

Specifically, organic solvents described in paragraphs [0091] to [0092] in JP 2007-199653 A, may be used, for example. More specifically, propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture of one or more thereof are preferably used.

A blending amount of the organic solvent (C) is preferably 200 to 10,000 parts by mass, and more preferably within a range of 250 to 5,000 parts by mass relative to 100 parts by mass of the organic polymer (B).

### <(C1) High-Boiling-Point Solvent>

In the composition for forming a silicon-containing anti-reflective film of the present invention, the organic solvent (C) preferably contains one or more organic solvents having a boiling point of 180°C or higher as a high-boiling-point solvent (C1). Note that, the boiling point is a boiling point at normal pressure.

For example, a mixture of one or more organic solvents having a boiling point of lower than 180°C and one or more organic solvents having a boiling point of 180°C or higher (high-boiling-point solvent (C1)) may be used as the organic solvent (C).

The high-boiling-point solvent (C1) is not particularly limited to hydrocarbons, alcohols, ketones, esters, ethers, and chlorine-based solvents as long as the solvent can dissolve or disperse each component of the composition for forming a silicon-containing anti-reflective film of the present invention. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and triethanolamine. These solvents may be used singly, or may be mixed for use.

The high-boiling-point solvent (C1) is appropriately selected from, for example, the aforementioned solvents depending on a temperature at which the composition for forming a silicon-containing anti-reflective film of the present invention is thermally treated etc. The boiling point of the high-boiling-point solvent is preferably 180°C to 300°C, and further preferably 200°C to 300°C. Such a boiling point has no risk of excessively fast evaporation during baking (thermal treatment), and thereby defect occurrence in film formation due to drying can be inhibited. In addition, such a boiling point eliminates failure to evaporate and remain the solvent in the film after the baking, and thereby does not adversely affect the film properties such as the etching resistance.

When the high-boiling-point solvent (C1) is used, a blending amount thereof is preferably 1 to 30 parts by mass relative to 100 parts by mass of the organic solvent having a boiling point of lower than 180°C. Such a blending amount can impart sufficient thermal flowability during baking, and does not lead to deterioration of the film properties such as etching resistance without residue in the film, which is preferable.

### <Other Additives>

The composition for forming a silicon-containing anti-reflective film preferably contains one or more selected from a crosslinking agent (D), an acid generator (E), a surfactant (F), and a pigment (H).

Hereinafter, the components that can be contained in the composition for forming a silicon-containing anti-reflective film of the present invention, other than the silicon-containing polymer (A), the organic polymer (B), and the organic solvent (C), will be described.

### <(D) Crosslinking Agent>

In the composition for forming a silicon-containing anti-reflective film of the present invention, a crosslinking agent (D) is preferably added in order to increase density of the silicon-containing anti-reflective film, and to increase the effect of inhibiting poisoning in which the base component generated from the silicon-containing hard mask (resist middle layer) moves to the photoresist film (resist upper layer film) to deteriorate sensitivity and resolution of the resist. The crosslinking agent (D) is not particularly limited, and known various types of crosslinking agents may be widely used. An example of the crosslinking agent includes a melamine-type crosslinking agent, a glycoluril-type crosslinking agent, a benzoguanamine-type crosslinking agent, a urea-type crosslinking agent, a β-hydroxyalkylamide-type crosslinking agent, an isocyanurate-type crosslinking agent, an aziridine-type crosslinking agent, an oxazoline-type crosslinking agent, an epoxy-type crosslinking agent, and a phenol-type crosslinking agent. The crosslinking agent (D) may be used singly or in combination of two or more thereof. An amount of the crosslinking agent (D) if added is preferably 5 to 50 parts by mass, more preferably 10 to 40 parts by mass, and further preferably 10 to 30 parts by mass relative to 100 parts by mass of the composition for forming a silicon-containing anti-reflective film. The addition amount of 5 parts by mass or more can exhibit sufficient curability to inhibit the poisoning toward the photoresist film. Meanwhile, the addition amount of 50 parts by mass or less does not decrease the proportion of the silicon-containing polymer (A) in the composition for forming a silicon-containing anti-reflective film, and the dry-etching resistance does not deteriorate.

The crosslinking agent (D) is preferably a compound having an isocyanuric acid structure, and more preferably has a structure of the following general formula (D-1).

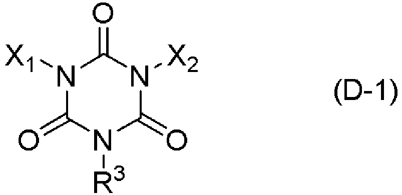

In the formula, X₁, X₂, and R³ represent a methyl group, an ethyl group, a propyl group, an allyl group, a propargyl group, or a group represented by the following general formula (D-2) or (D-3).

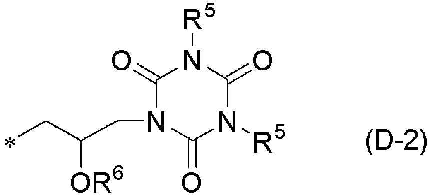

In the formula, R⁵ represents a methyl group, an ethyl group, a propyl group, an allyl group, or a propargyl group, R⁶ represents a hydrogen atom, an acetyl group, an acryloyl group, a methacryloyl group, a benzoyl group, a toloyl group, a naphthoyl group, or an anthranoyl group, and "*" represents a bonding portion.

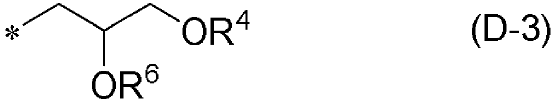

In the formula, R⁶ is same as in the general formula (D-2), and R⁴ represents a hydrogen atom, an acetyl group, an acryloyl group, a methacryloyl group, a benzoyl group, a toloyl group, a naphthoyl group, or an anthranoyl group, except for a combination where each of R⁶ and R⁴ simultaneously represents a hydrogen atom and a benzoyl group and/or a toloyl group.

The crosslinking agent (D) being the compound having the structure can be crosslinked with the polysiloxane by baking to form a dense film when added into the composition for forming a silicon-containing anti-reflective film. Thus, the silicon-containing anti-reflective film exhibiting an excellent effect of inhibiting poisoning can be formed. In addition, adhesiveness to the resist upper layer film can be more improved to form the resist pattern having a high effect of inhibiting collapse of an ultrafine pattern and a good pattern shape.

Examples of the structure represented by the general formula (D-2) include the following structures.

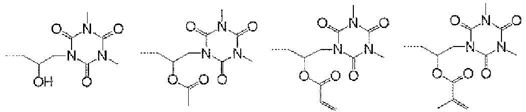

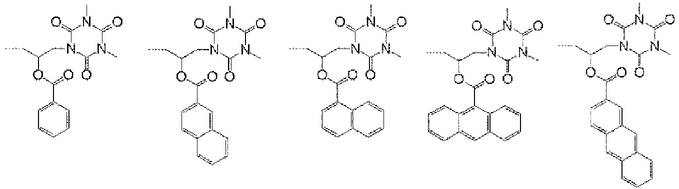

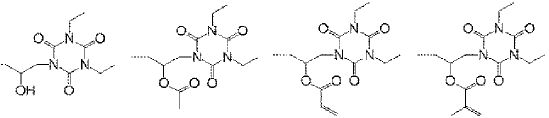

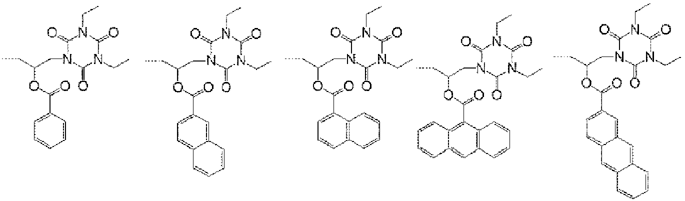

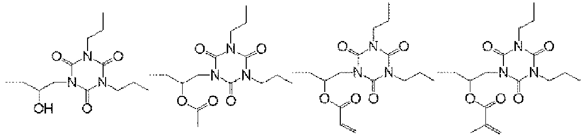

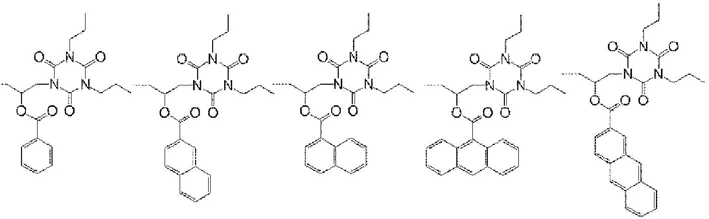

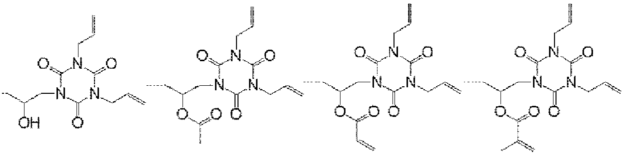

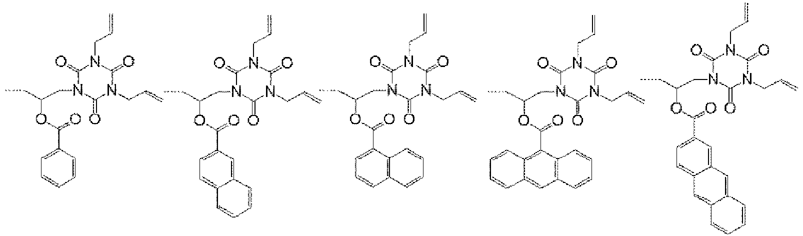

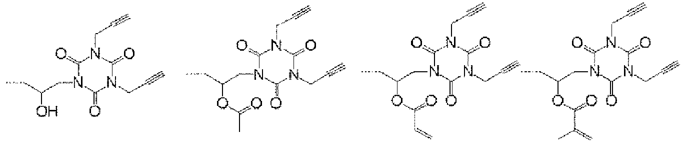

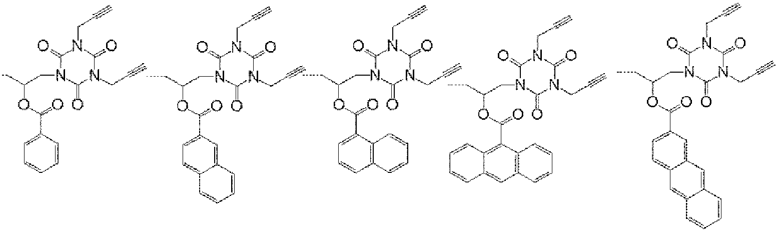

Examples of the preferable structure of the crosslinking agent having the general formula (D-2) include the following structures. R³ is same as above.

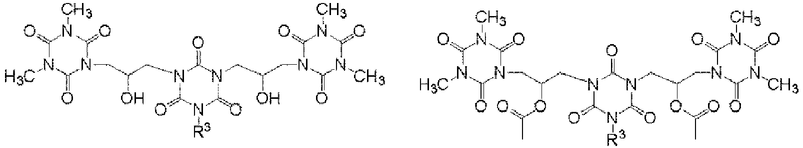

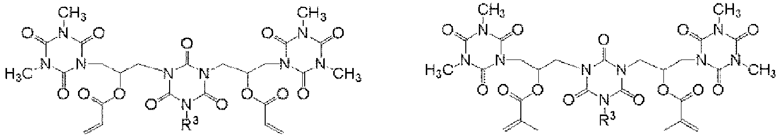

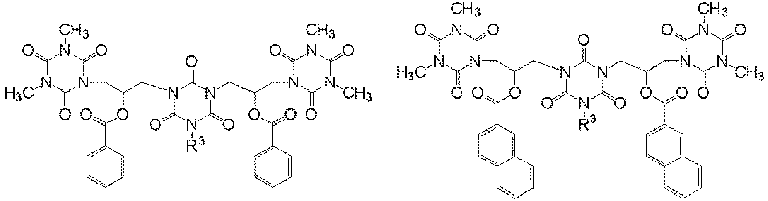

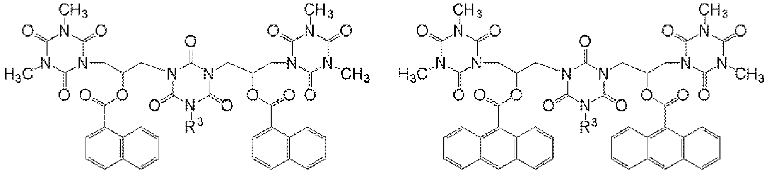

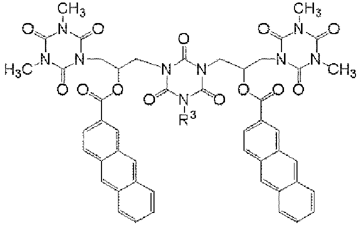

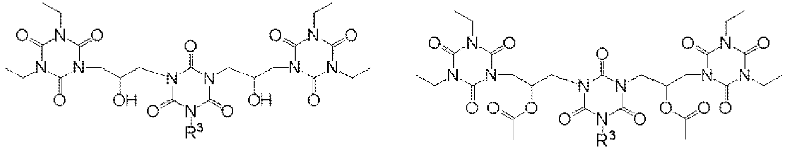

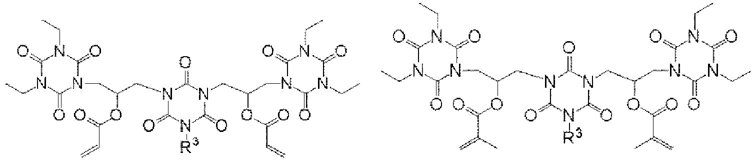

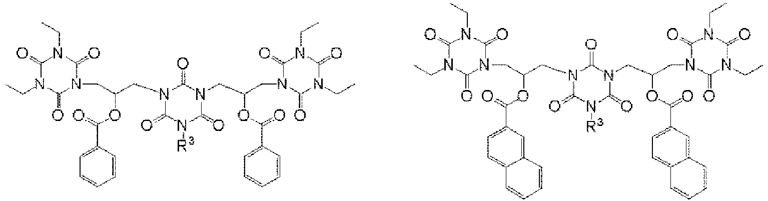

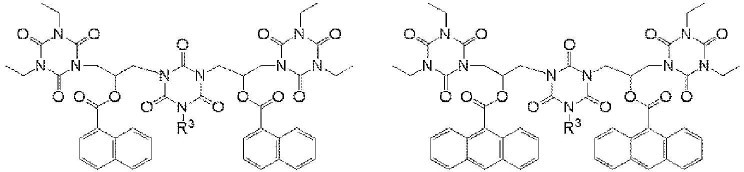

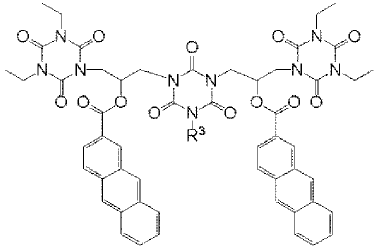

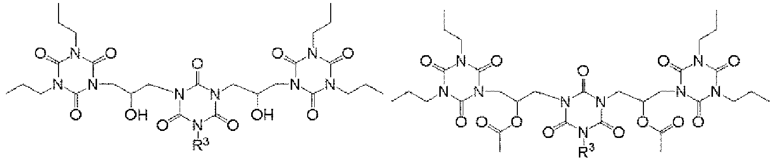

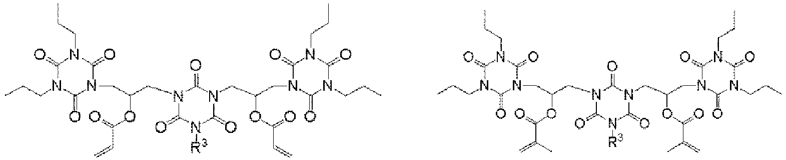

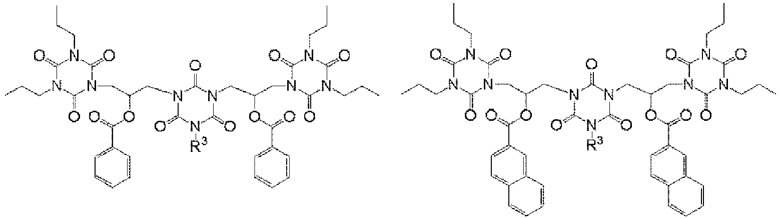

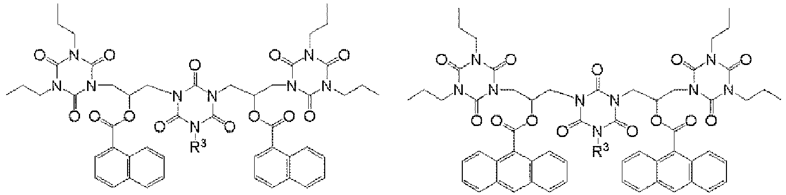

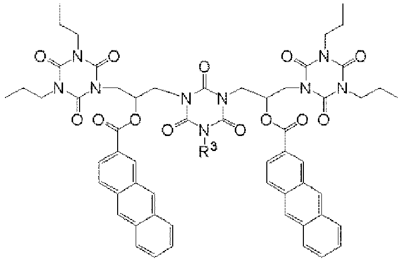

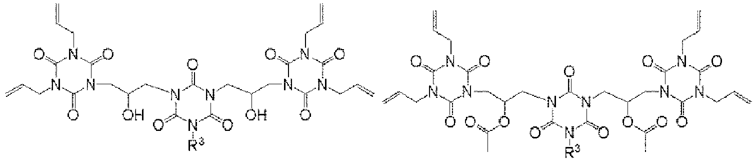

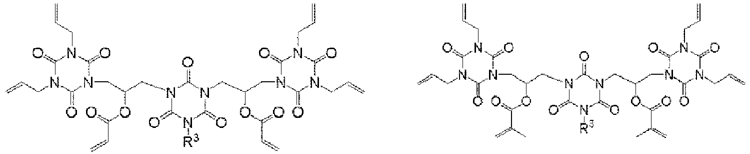

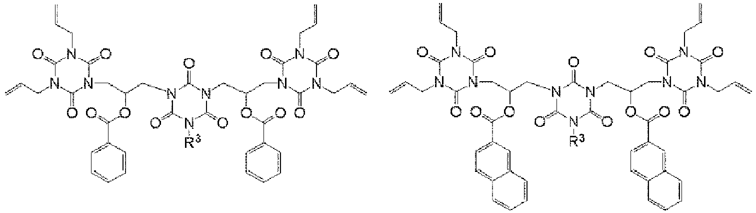

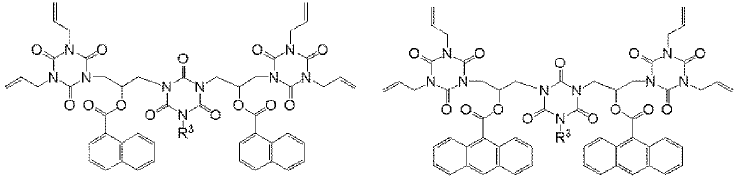

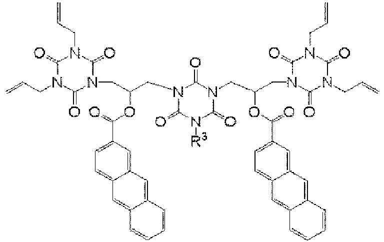

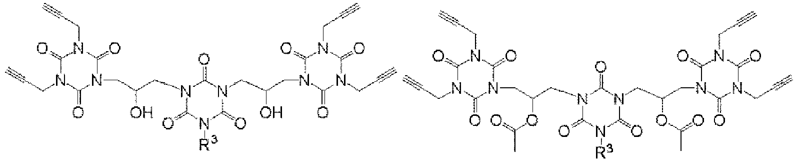

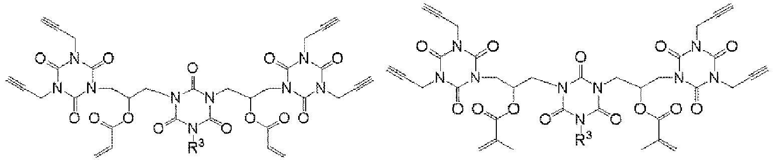

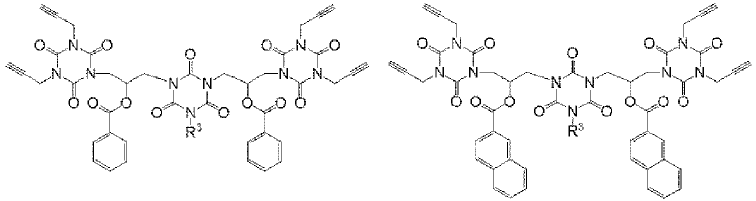

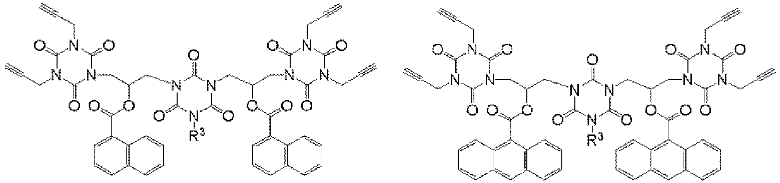

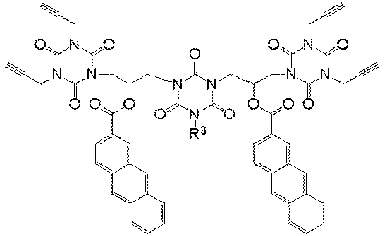

Preferable examples of the crosslinking agent having the structure represented by the general formula (D-3) include the following structures.

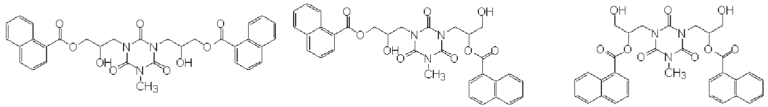

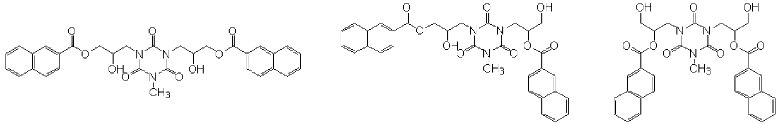

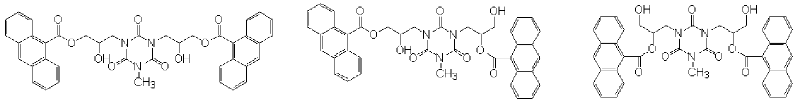

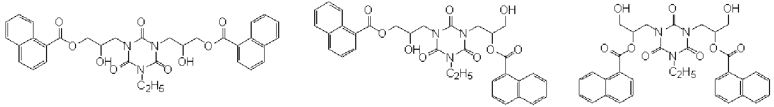

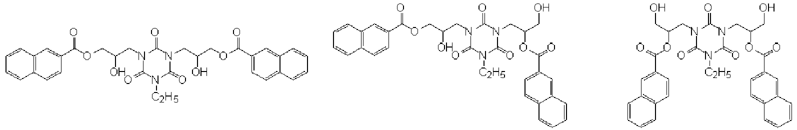

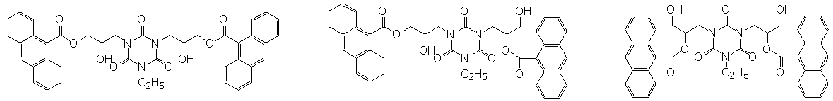

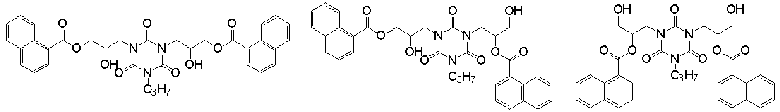

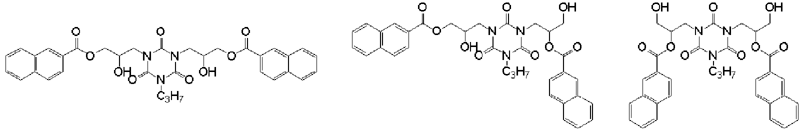

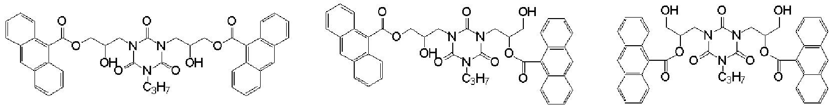

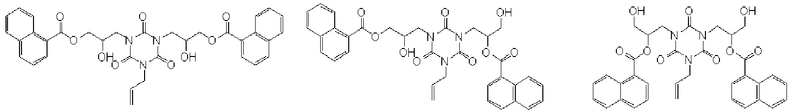

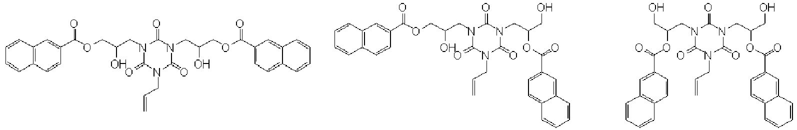

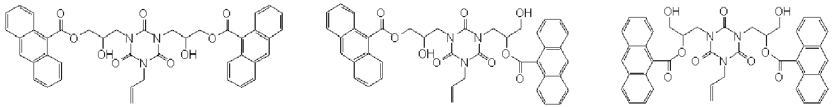

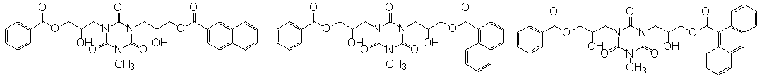

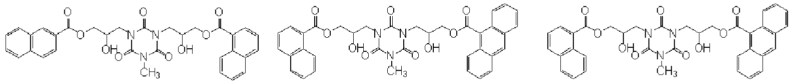

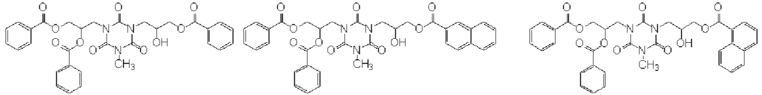

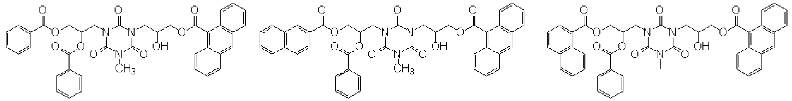

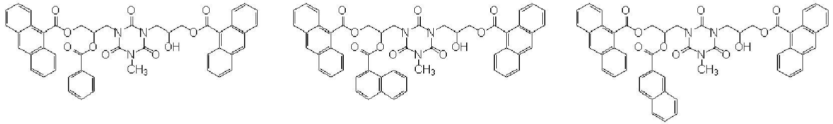

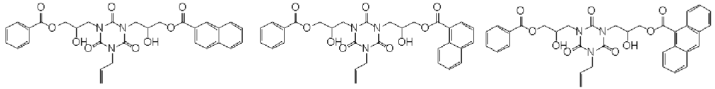

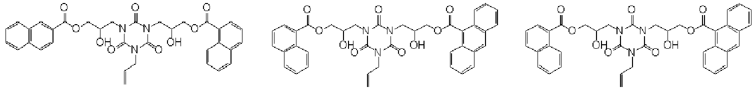

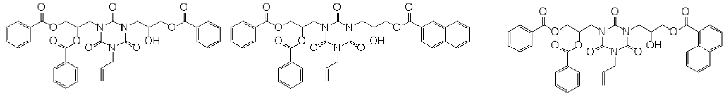

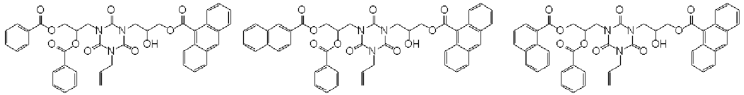

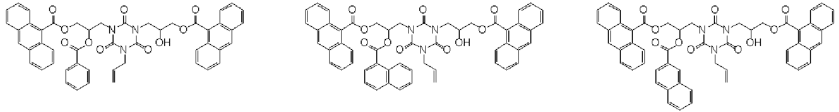

Preferable examples of the compound represented by the general formula (D-1) include the following compounds. Specifically preferably, R⁵ represents an allyl group or a propargyl group, R⁶ represents a hydrogen atom, an acetyl group, or an acryloyl group, and R³ represents an allyl group or the group represented by the general formula (D-2). Further preferably, R⁵ represents an allyl group or a propargyl group, R⁶ represents a hydrogen atom or an acetyl group, and R³ represents an allyl group.

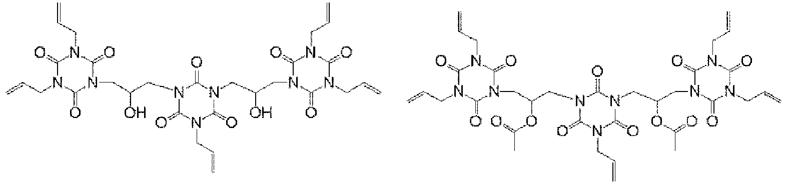

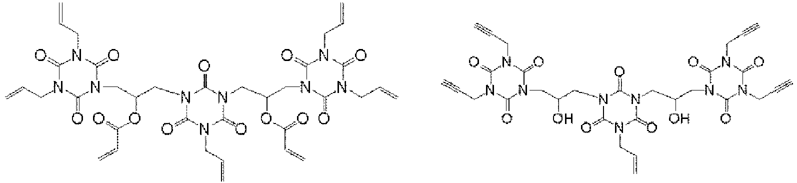

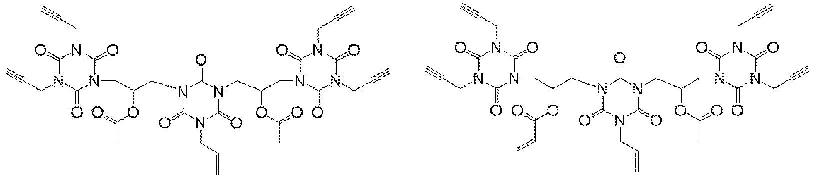

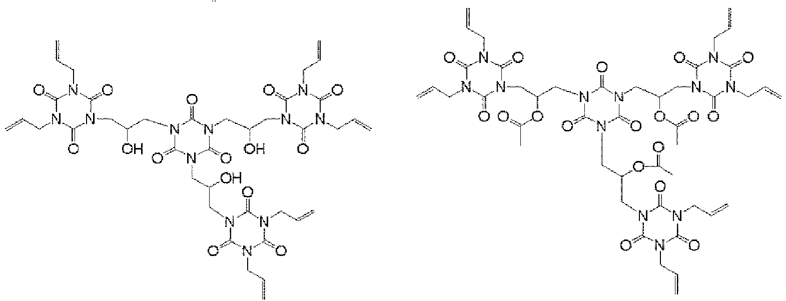

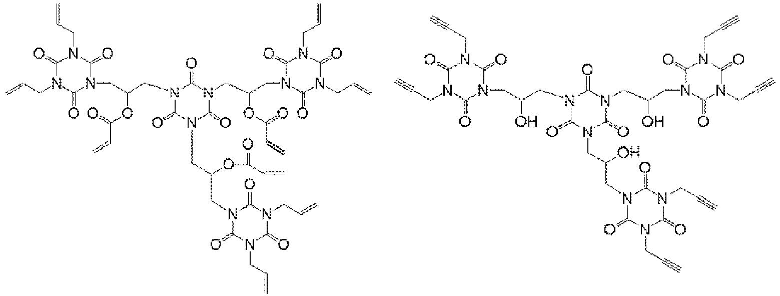

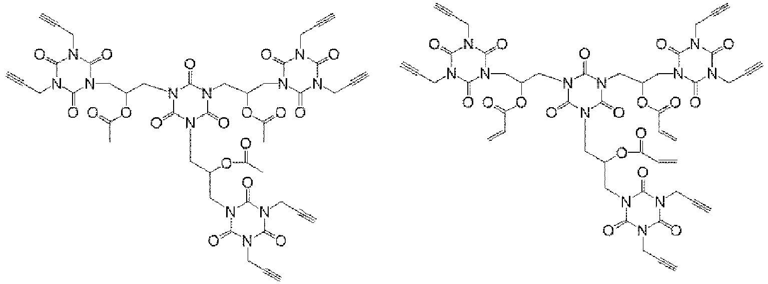

### <(E) Acid Generator>

Into the composition for forming a silicon-containing anti-reflective film of the present invention, one or two or more acid generators may be further blended. Although any substance to serve as an acid precursor, such as a thermal acid generator, a photoacid generator, and an acid amplifier, may be used as the acid generator (E), and in the present invention, more preferable is a photoacid generator in which the blended acid generator is a sulfonium salt to generate an acid by an action of high-energy ray. Specifically, materials described in paragraphs [0061] to [0085] in JP 2007-199653 A may be added, but not limited thereto.

The acid generator (E) may be used singly or in combination of two or more thereof. An amount of the acid generator (E) if blended is preferably 0.05 to 50 parts by mass, and more preferably 0.1 to 10 parts by mass relative to 100 parts by mass of the silicon-containing polymer (A).

### <(F) Surfactant>

Into the composition for forming a silicon-containing anti-reflective film of the present invention, a surfactant (F) may be further blended. Specifically as such a surfactant, materials described in a paragraph [0185] in JP 2009-126940 A may be added. An amount of the surfactant (F) if blended is preferably 0.1 to 5 parts by mass relative to 100 parts by mass of the silicon-containing polymer (A).

### <(H) Pigment>

In the composition for forming a silicon-containing anti-reflective film of the present invention, a pigment (H) may be blended to further improve the resolution of patterning with the multilayer lithography. The pigment (H) is not particularly limited as long as the pigment is a compound having appropriate absorption at the exposure wavelength, and known various compounds can be widely used. An example thereof includes benzenes, naphthalenes, anthracenes, phenanthrenes, pyrenes, isocyanuric acids, and triazines. An amount of the pigment (H) if blended is preferably 0.01 to 10 parts by mass, and more preferably 0.1 to 5 parts by mass relative to 100 parts by mass of the silicon-containing polymer (A).

### Other Components

### (Crosslinking Catalyst)

In the present invention, a crosslinking catalyst (Xc) may be blended with the composition for forming a silicon-containing anti-reflective film. Examples of the crosslinking catalyst that can be blended include compounds represented by the following general formula (Xc0) .

LₐH_{b}A (Xc0)

In the formula, L represents lithium, sodium, potassium, rubidium, cesium, sulfonium, iodonium, phosphonium, or ammonium. A represents a non-nucleophilic counterion. "a" represents an integer of 1 or more, "b" represents 0 or an integer of 1 or more, and a+b represents a valency of the non-nucleophilic counterion.

Specific examples of the crosslinking catalyst used as (Xc0) in the present invention include a sulfonium salt represented by the following general formula (Xc-1), an iodonium salt represented by the following general formula (Xc-2), a phosphonium salt represented by the following general formula (Xc-3), an ammonium salt represented by the following general formula (Xc-4), and a polysiloxane (Xc-10) having an alkali metal salt, an ammonium salt, a sulfonium salt, a phosphonium salt, or an iodonium salt as a part of the structure. Specifically, materials described in paragraphs [0124] to [0163] in JP 2020-118960 A etc. may be added.

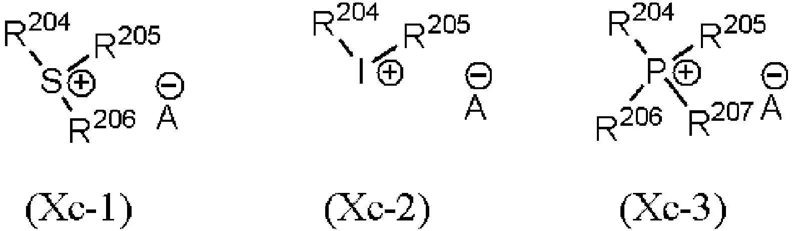

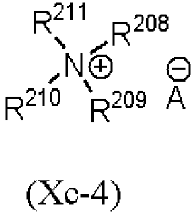

In the formulae, R²⁰⁴, R²⁰⁵, R²⁰⁶, and R²⁰⁷ each represent a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or aryloxoalkyl group having 7 to 12 carbon atoms, a part or all of hydrogen atoms in these groups may be substituted with an alkoxy group etc. R²⁰⁵ and R²⁰⁶ may form a ring, and when forming a ring, each of R²⁰⁵ and R²⁰⁶ represents an alkylene group having 1 to 6 carbon atoms. A⁻ represents the non-nucleophilic counterion. R²⁰⁸, R²⁰⁹, R²¹⁰, and R²¹¹ are same as R²⁰⁴, R²⁰⁵, R²⁰⁶, and R²⁰⁷, but may represent a hydrogen atom. R²⁰⁸ and R²⁰⁹; or R²⁰⁸, R²⁰⁹, and R²¹⁰ may form a ring, and when forming a ring, R²⁰⁸ and R²⁰⁹; and R²⁰⁸, R²⁰⁹, and R²¹⁰ represent an alkylene group having 3 to 10 carbon atoms.

The crosslinking catalysts (Xc-1), (Xc-2), (Xc-3), (Xc-4), and (Xc-10) may be used singly or in combination of two or more thereof. A blending amount of the crosslinking catalyst is preferably 0.01 to 50 parts by mass, and more preferably 0.1 to 40 parts by mass relative to 100 parts by mass of the base polymer (for example, the silicon-containing polymer (A)).

Into the composition for forming a silicon-containing anti-reflective film of the present invention, the following components may be further blended.

### (Organic Acid)

To improve stability of the composition for forming a silicon-containing anti-reflective film of the present invention, a monovalent or divalent or more valent organic acid having 1 to 30 carbon atoms is preferably blended. Examples of the acid added in this case include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, and citric acid. In particular, oxalic acid, maleic acid, formic acid, acetic acid, propionic acid, citric acid, etc. are preferable. To retain the stability, two or more acids may be mixed for use.

A blending amount of the organic acid is 0.001 to 25 parts by mass, preferably 0.01 to 15 parts by mass, and more preferably 0.1 to 5 parts by mass relative to 100 parts by mass of the silicon-containing polymer (A) contained in the composition for forming a silicon-containing anti-reflective film of the present invention.

Alternatively, the organic acid is preferably blended in terms of pH of the composition for forming a silicon-containing anti-reflective film of the present invention so as to preferably satisfy 0≤pH≤7, more preferably 0.3≤pH≤6.5, and further preferably 0.5≤pH≤6.

### (Stabilizer)

Into the composition for forming a silicon-containing anti-reflective film of the present invention, a stabilizer may be blended. As a stabilizer, a monohydric or dihydric or more alcohols having a cyclic ether as a substituent can be added. Specifically, blending a stabilizer described in paragraphs [0181] to [0182] of JP 2009-126940 A can improve the stability of the composition for forming a silicon-containing anti-reflective film.

Into the composition for forming a silicon-containing anti-reflective film of the present invention, a basic compound to improve storage stability can be further added. The basic compound prevents proceeding of the crosslinking reaction due to a small amount of an acid generated from the acid generator, and plays a role as a quencher against the acid. Specific examples of such a basic compound include compounds described in paragraphs [0086] to [0090] in JP 2007-199653 A.

### <Method for Forming Silicon-Containing Anti-Reflective Film>

The present invention provides a method for forming a film that functions as a silicon-containing anti-reflective film of a multilayer resist film used in lithography by using the aforementioned composition for forming a silicon-containing anti-reflective film.

In the method for forming a silicon-containing anti-reflective film using the composition for forming a silicon-containing anti-reflective film of the present invention, the above composition for forming a silicon-containing anti-reflective film is applied on the substrate to be processed by spin-coating method, etc. Use of the spin-coating method etc. can yield the silicon-containing anti-reflective film having excellent thin-film formability. After the spin-coating, the solvent is evaporated, and baking (thermal treatment) is performed to prevent mixing with the resist upper layer film and to enhance the crosslinking reaction. The baking is preferably performed within a range at 100°C or higher and 600°C or lower for 10 to 600 seconds, more preferably performed within a range at 200°C or higher and 500°C or lower for 10 to 300 seconds. With considering effects on device damage and wafer deformation, an upper limit of the heating temperature in the wafer process of the lithography is preferably 500°C or lower, and more preferably 400°C or lower.

In the method for forming a silicon-containing anti-reflective film using the composition for forming a silicon-containing anti-reflective film of the present invention, the composition for forming a silicon-containing anti-reflective film of the present invention is applied on the substrate to be processed by a spin-coating method etc. similarly to the above, and the silicon-containing anti-reflective film can also be formed by baking and curing the composition for forming a silicon-containing anti-reflective film in an atmosphere with an oxygen concentration of 0.1 vol% or more and 21 vol% or less.

Baking the composition for forming a silicon-containing anti-reflective film of the present invention in such an oxygen atmosphere can yield a sufficiently cured film. Although the atmosphere during the baking may be the air, sealing an inert gas such as N₂, Ar, and He to reduce oxygen is preferable for preventing oxidation of the silicon-containing anti-reflective film. To prevent the oxidation, the oxygen concentration is required to be controlled, and is preferably 1,000 ppm or less, and more preferably 100 ppm or less (on a volumetric basis). Preventing the oxidation of the silicon-containing anti-reflective film during the baking avoids increase in the absorption and deterioration in the etching resistance, which is preferable.

### <Patterning Method Using Silicon-Containing Anti-Reflective Film>

The present invention provides, as a patterning method by a two-layer resist process using the composition for forming a silicon-containing anti-reflective film, a patterning method including steps of:
(I-1) applying the aforementioned composition for forming a silicon-containing anti-reflective film on a substrate to be processed, and then heat-treating the composition to form a silicon-containing anti-reflective film;
(I-2) forming a resist upper layer film on the silicon-containing anti-reflective film by using a photoresist material;
(I-3) pattern-exposing the resist upper layer film, and then developing the exposed resist upper layer film with a developer to form a pattern in the resist upper layer film;
(I-4) transferring the pattern to the silicon-containing anti-reflective film by dry etching while using the resist upper layer film having the formed pattern as a mask; and
(I-5) forming a pattern on the substrate to be processed by processing the substrate to be processed while using the silicon-containing anti-reflective film having the transferred pattern as a mask.

The resist upper layer film in the two-layer resist process exhibits etching resistance against fluorine-type gas, and thereby the dry etching of the silicon-containing anti-reflective film while using the resist upper layer film as a mask in the two-layer resist process is preferably performed by using an etching gas mainly containing fluorine-type gas.

The present invention provides, as a patterning method by a three-layer resist process using the composition for forming a silicon-containing anti-reflective film as above, a patterning method including steps of:
(II-1) forming a resist underlayer film on a substrate to be processed;
(II-2) applying the aforementioned composition for forming a silicon-containing anti-reflective film on the resist underlayer film, and then heat-treating the composition to form a silicon-containing anti-reflective film;
(II-3) forming a resist upper layer film on the silicon-containing anti-reflective film by using a photoresist material;
(II-4) pattern-exposing the resist upper layer film, and then developing the exposed resist upper layer film with a developer to form a pattern in the resist upper layer film;
(II-5) transferring the pattern to the silicon-containing anti-reflective film by dry etching while using the resist upper layer film having the formed pattern as a mask;
(II-6) transferring the pattern to the resist underlayer film by dry etching while using the silicon-containing anti-reflective film having the transferred pattern as a mask; and
(II-7) forming a pattern on the substrate to be processed by processing the substrate to be processed while using the resist underlayer film having the transferred pattern as a mask.

The resist underlayer film in the three-layer resist process exhibits etching resistance against fluorine-type gas, and thereby the dry etching of the substrate to be processed while using the resist underlayer film as a mask in the three-layer resist process is preferably performed by using an etching gas mainly containing fluorine-type gas.

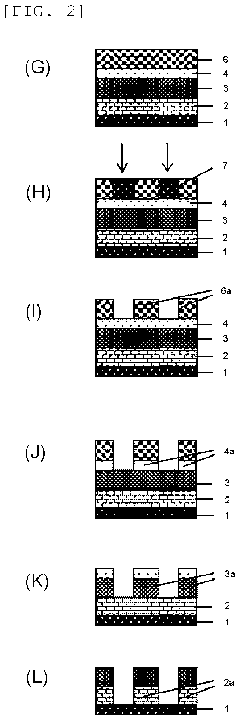

The patterning method with the three-layer resist process will be described by using FIG. 2. The present invention provides, as the patterning method with the three-layer resist process using the composition for forming a silicon-containing anti-reflective film as above, a patterning method including followings: as FIG. 2(G), a resist underlayer film 3 is formed by using a resist underlayer film material on a layer 2 to be processed on a substrate 1 to be processed; a silicon-containing anti-reflective film 4 is formed by using the composition for forming a silicon-containing anti-reflective film on the resist underlayer film; a resist upper layer film 6 is formed by using a photoresist material on the silicon-containing anti-reflective film; subsequently, as in FIG. 2(H), an exposure portion 7 of the resist upper layer film is pattern-exposed, and then developed with a developer as FIG. 2(I) to form a resist upper layer film pattern 6a in the resist upper layer film; as in FIG. 2(J), while using the resist upper layer film having the formed patterned as a mask, a silicon-containing anti-reflective film pattern 4a is transferred to the silicon-containing anti-reflective film by dry etching; as in FIG. 2(K), while using the silicon-containing anti-reflective film having the transferred pattern as a mask, a resist underlayer film pattern 3a is transferred to the resist underlayer film by dry etching; and as in FIG. 2(L), while using the resist underlayer film having the formed pattern as a mask, a pattern 2a is formed on the substrate 1 to be processed by processing the layer to be processed on the substrate to be processed.

In addition, the present invention provides, as a patterning method by a four-layer resist process using the composition for forming a silicon-containing anti-reflective film as above, a patterning method including steps of:
(III-1) forming a resist underlayer film on a substrate to be processed;
(III-2) forming an inorganic hard mask middle layer film selected from a group consisting of a silicon oxide film, a silicon nitride film, and a silicon oxynitride film on the resist underlayer film;
(III-3) applying the aforementioned composition for forming a silicon-containing anti-reflective film on the inorganic hard mask middle layer film, and then heat-treating the composition to form a silicon-containing anti-reflective film;
(III-4) forming a resist upper layer film on the silicon-containing anti-reflective film by using a photoresist material;
(III-5) pattern-exposing the resist upper layer film, and then developing the exposed resist upper layer film with a developer to form a pattern in the resist upper layer film;
(III-6) transferring the pattern to the silicon-containing anti-reflective film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) forming a pattern on the substrate to be processed by processing the substrate to be processed while using the resist underlayer film having the transferred pattern as a mask.

The above patterning method enables to transfer a resist pattern shape on the substrate to be processed with high accuracy in the fine patterning process using the ArF immersion and high NA exposure condition in the semiconductor device producing process.

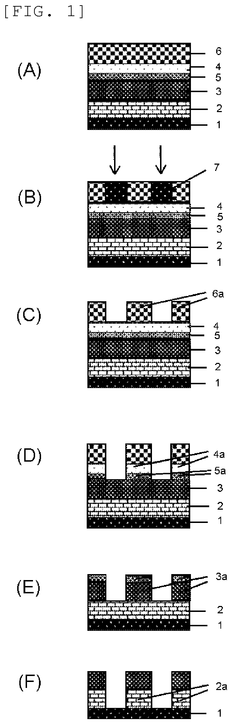

The patterning method by a four-layer resist process will be described by using FIG. 1. The present invention provides, as the patterning method by the four-layer resist process using the composition for forming a silicon-containing anti-reflective film as above, a patterning method including followings: as in FIG. 1(A), a resist underlayer film 3 is formed on a layer 2 to be processed on a substrate 1 to be processed by using a resist underlayer film material; an inorganic hard mask middle layer film 5 is formed on the resist underlayer film by using an inorganic hard mask middle layer film material; a silicon-containing anti-reflective film 4 is formed on the inorganic hard mask middle layer film by using the above composition for forming a silicon-containing anti-reflective film; a resist upper layer film 6 is formed on the silicon-containing anti-reflective film by using a photoresist material; subsequently, as in FIG. 1(B), an exposure portion 7 of the resist upper layer film is pattern-exposed, and then developed with a developer as in FIG. 1(C) to form a resist upper layer film pattern 6a in the resist upper layer film; as in FIG. 1(D), while using the resist upper layer film having the formed pattern as a mask, a silicon-containing anti-reflective film pattern 4a and an inorganic hard mask middle layer film pattern 5a are transferred to the silicon-containing anti-reflective film and the inorganic hard mask middle layer film by dry etching; as in FIG. 1(E), while using the silicon-containing anti-reflective film and the inorganic hard mask middle layer film having the transferred pattern as a mask, a resist underlayer film 3a is transferred to the resist underlayer film by dry etching; and as in FIG. 1(F), while using the resist underlayer film having the formed pattern as a mask, a pattern 2a is formed on the substrate 1 to be processed by processing the layer to be processed on the substrate to be processed.

An example of the patterning method includes a method including:
processing a silicon-containing anti-reflective film and an inorganic hard mask middle layer film (resist middle layer films) by dry etching using fluorine-type gas while using a resist pattern as an etching mask;
processing an organic resist underlayer film (resist underlayer film) by dry etching using oxygen-type gas while using the inorganic hard mask middle layer film pattern as an etching mask; and
processing a substrate to be processed by dry etching using fluorine-type gas while using the organic resist underlayer film pattern as an etching mask.

### <Organic Resist Underlayer Film (Resist Underlayer Film)>

Examples of the organic resist underlayer film material usable for the organic resist underlayer film (resist underlayer film) include materials already known as an underlayer film for the three-layer resist method or for the two-layer resist method using a silicon resist composition. Examples thereof include resins and compositions described in JP 2012-001687 A, JP 2012-077295 A, JP 2004-264710 A, JP 2005-043471 A, JP 2005-250434 A, JP 2007-293294 A, JP 2008-065303 A, JP 2004-205685 A, JP 2007-171895 A, JP 2009-014816 A, JP 2007-199653 A, JP 2008-274250 A, JP 2010-122656 A, JP 2012-214720 A, JP 2014-029435 A, WO 2012/077640 A1, WO 2010/147155 A1, WO 2012/176767 A1, JP 2005-128509 A, JP 2006-259249 A, JP 2006-259482 A, JP 2006-293298 A, JP 2007-316282 A, JP 2012-145897 A, JP 2017-119671 A, JP 2019-044022 A, etc.

For example, the above resist underlayer film can be formed on the substrate to be processed by a spin-coating method etc. using a composition solution containing the above organic resist underlayer film material. After the organic resist underlayer film is formed by the spin-coating method etc., baking is desirably performed for evaporating the organic solvent. The baking temperature is preferably within a range of 100 to 600°C, and the baking time is preferably within a range of 10 to 300 seconds.

It is also acceptable that an organic hard mask formed by a CVD method or an ALD method is applied instead of the above organic resist underlayer film material. In the patterning method of the present invention, the organic hard mask formed by the CVD method is preferably applied.

Use of the organic hard mask formed by the CVD method for the organic resist underlayer film enables to process the substrate to be processed for the resist pattern shape with high accuracy. The organic hard mask formed by the CVD method exhibits higher resistance against dry etching using fluorine-type gas than the organic resist underlayer film formed with the organic resist underlayer film material, and thereby useful for forming the fine pattern.

The organic resist underlayer film preferably contains any one of a graphene film, an amorphous carbon film, and a diamond-like carbon film.

In the patterning method using the resist underlayer film, the organic resist underlayer film exhibits high resistance against the fluorine-type gas used for processing the substrate to be processed by dry etching, and thereby the substrate to be processed can be processed for the resist pattern shape with high accuracy.

A thickness of the resist underlayer film is preferably 10 to 1,000 nm, more preferably 15 nm to 100 nm, and further preferably 20 nm to 50 nm.

### <Silicon-Containing Hard Mask (Resist Middle Film)>

Examples of the silicon-containing hard mask material usable for the silicon-containing hard mask (resist middle film) include a polysiloxane-based resist middle film material. Examples thereof include materials described in JP 2004-310019 A, JP 2005-015779 A, JP 2005-018054 A, JP 2005-352104 A, JP 2007-226170 A, etc.

In the conventional silicon-containing hard mask material, preferably used is a polysiloxane in which a phenyl group or a light-absorption group etc. having a silicon-silicon bond is bonded as a pendant in order to impart the anti-reflective effect and that is crosslinkable by an acid or heat. Since such a material has a large amount of organic groups, the pattern shape may be deteriorated in dry-etching the organic resist underlayer film with oxygen-type gas. Meanwhile, in the patterning method of the present invention, the anti-reflective function is imparted to the silicon-containing anti-reflective film to inhibit the reflection, and therefore, the silicon-containing hard mask material can be designed to have minimized organic groups, which deteriorates the dry-etching resistance, and the highly accurate processing of the substrate to be processed can be achieved.

For example, the above silicon-containing hard mask can be formed on the substrate to be processed by a spin-coating method etc. using a composition solution containing the above silicon-containing hard mask material. After the silicon-containing hard mask is formed by the spin-coating method etc., baking is preferably performed for evaporating the organic solvent. The baking temperature is preferably within a range of 100 to 600°C, and the baking time is preferably within a range of 10 to 300 seconds.

It is also acceptable that an inorganic hard mask middle layer film formed by a CVD method or an ALD method is applied instead of the above silicon-containing hard mask material. Specifically, the inorganic hard mask middle layer film is preferably a layer selected from a group consisting of a silicon oxide film, a silicon nitride film, and a silicon oxynitride film. For example, a method for forming the silicon nitride film is described in JP 2002-334869 A and WO 2004/066377 A1.

In the patterning method of the present invention, the inorganic hard mask middle layer film (a layer selected from a group consisting of a silicon oxide film, a silicon nitride film, and a silicon oxynitride film) formed by the CVD method is preferably applied.

In the above patterning method using the inorganic hard mask middle layer film, the inorganic hard mask middle layer film exhibits high resistance against oxygen-type gas used for processing the organic resist underlayer film by dry etching, and thereby the substrate to be processed can be processed for the resist pattern shape with high accuracy. In addition, the patterning method of the present invention exhibits an excellent effect from the viewpoint of inhibiting poisoning from the resist underlayer film and the underlayer toward the photoresist layer (resist upper layer film) when using the inorganic hard mask, and thereby the patterning method of the present invention is useful for forming the fine pattern.

A film thickness of the silicon-containing hard mask is preferably 5 to 200 nm, and more preferably 10 to 100 nm. As the silicon-containing hard mask, a silicon oxynitride film (SiON), which has a high effect as the anti-reflective film, is most preferably used. Since a substrate temperature during formation of the SiON film reaches 300 to 500°C, the organic resist underlayer film is required to resist the temperature of 300 to 500°C.

### <Silicon-Containing Anti-Reflective Film>

The silicon-containing anti-reflective film is preferably formed by using the composition for forming a silicon-containing anti-reflective film of the present invention.

A proportion of silicon (b) in the silicon-containing anti-reflective film measured by Rutherford backscattering spectrometry (RBS) is preferably 5 to 30 mass%, more preferably 5 to 25 mass%, and further preferably 5 to 20 mass%. When the proportion of silicon (b) in the silicon-containing anti-reflective film is 5 mass% or more, the film with high refraction can be formed to increase the anti-reflective function. When the proportion of silicon (b) in the silicon-containing anti-reflective film is 30 mass% or less, increase in an etching rate against the fluorine-type gas can be inhibited to increase a selectivity ratio with the silicon-containing hard mask (resist middle film).

The silicon-containing anti-reflective film as above has a smaller etching rate against the fluorine-type gas than the silicon-containing hard mask (resist middle film), and thereby the resist pattern shape can be transferred to the silicon-containing hard mask (resist middle film) with high accuracy.

The film thickness of the silicon-containing anti-reflective film is preferably 12 nm or less.

### <Photoresist Film (Resist Upper Layer Film)>

In the patterning method of the present invention, the composition for the resist upper layer film is not particularly limited as long as the composition includes a chemically amplifying photoresist composition. Note that the present invention can adopt any of positive development using an alkali developer and negative development using an organic solvent developer. Thus, the positive-type resist upper layer film material or the negative-type resist upper layer film material is appropriately selected depending on the development method.

A thickness of the resist upper layer film is not particularly limited, but preferably 10 to 500 nm, and particularly preferably 20 to 200 nm.

In the positive-type patterning method, the resist upper layer film is formed, subjected to a heating treatment, then exposed to light, and alkali development is performed using typically an alkali developer to obtain the positive-type resist pattern. After the exposure, post exposure baking (PEB) is preferably performed.

As the alkali developer, tetramethylammonium hydroxide (TMAH) aqueous solution etc. may be used.

In the negative-type patterning method, the resist upper layer film is formed, subjected to a heating treatment, then exposed to light, and organic-solvent development is performed using typically an organic solvent to obtain the negative-type resist pattern. After the exposure, PEB is preferably performed.

As the organic solvent developer, usable are developer etc. containing one or more components selected from 4-methyl-2-pentanol, 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, amyl acetate, butenyl acetate, isoamyl acetate, phenyl acetate, propyl formate, butyl formate, isobutyl formate, amyl formate, isoamyl formate, methyl valerate, methyl pentenoate, methyl crotonate, ethyl crotonate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, benzyl acetate, methyl phenylacetate, benzyl formate, phenylethyl formate, methyl 3-phenylpropionate, benzyl propionate, ethyl phenylacetate, and 2-phenylethyl acetate.

The photoresist composition may contain metal atoms such as Sn, In, Ga, Ge, Al, Ce, La, Cs, Zr, Hf, Ti, Bi, Sb, and Zn. When the resist upper layer film is formed with the above photoresist composition, the method therefor may be spin-coating or vapor deposition treatment by CVD or ALD.

When the resist upper layer film is formed by the vapor deposition treatment with CVD or ALD, the photoresist composition is an EUV-sensitive metal oxide, the metal is selected from Sn, Zr, Hf, Ti, Bi, Sb, etc., and specifically Sn, which has excellent EUV sensitivity, is preferable. The metal oxide may be a photosensitive organometal oxide such as an organotin oxide (for example, haloalkyl Sn, alkoxyalkyl Sn, or amidealkyl Sn). Some specific examples of an appropriate precursor thereof include trimethyltin chloride, dimethyltin dichloride, methyltin trichloride, tris(dimethylamino)methyltin (IV), and (dimethylamino)trimethyltin (IV).

The metal oxide may be deposited with PECVD or PEALD by using Lam Vector (R) tool, for example. In ALD Example, the Sn oxide precursor is separated from the O precursor / plasma. The deposition temperature is preferably within a range of 50°C to 600°C. The deposition pressure is preferably between 100 to 6,000 mTorr. The flow rate of the precursor liquid for the metal oxide (for example, the organotin oxide precursor) may be 0.01 to 10 cmm, and the gas flow rate (CO₂, CO, Ar, or N₂) may be 100 to 10,000 sccm. The plasma power may be 200 to 1,000 W per 300-mm wafer station by using high-frequency plasma (for example, 13.56 MHz, 27.1 MHz, or higher frequency). The deposition thickness is preferably 100 to 2,000 Å.

Examples of the exposure light include high-energy radiation having a wavelength of 300 nm or shorter, specifically excimer laser with 248 nm, 193 nm, or 157 nm, soft X-ray with 3 to 20 nm, electron beam, and X-ray.

The patterning method of the above resist upper layer film is preferably patterning of photolithography with a wavelength of 5 nm or longer and 300 nm or shorter, direct drawing with electron beam, nanoimprinting, or combination thereof.

The body to be processed (substrate to be processed) is not particularly limited, and a substrate such as Si, α-Si, p-Si, SiO₂, SiN, SiON, W, TiN, and Al, a material in which a layer to be processed is formed on the substrate, etc. are used. As the layer to be processed, various low-k films such as Si, SiO₂, SiON, SiN, p-Si, α-Si, W, W-Si, Al, Cu, and Al-Si, and stopper films thereof are used. The layer to be processed can be formed to have a thickness of typically 30 to 10,000 nm, and particularly 50 to 5,000 nm. When the layer to be processed is formed, the substrate and the layer to be processed having different materials are used.

### EXAMPLE

Hereinafter, the present invention will be further specifically described with showing Synthesis Examples, Comparative Synthesis Examples, Examples, and Comparative Examples, but the present invention is not limited by these. The weight-average molecular weight and the dispersion degree were determined in terms of polystyrene by gel permeation chromatography (GPC) using tetrahydrofuran as an eluent solvent, using RI as a detector, and using polystyrene as a standard substance.

Synthesis Examples 1 to 10: Synthesis of Polysiloxanes (A1) to (A4) for Silicon-Containing Anti-Reflective Film, Polycarbosilane (A5) for Silicon-Containing Anti-Reflective Film, and Polysilanes (A6) to (A10) for Silicon-Containing Anti-Reflective Film

### (Synthesis Example 1)

### Synthesis of Polysiloxane (A1) for Silicon-Containing Anti-Reflective Film

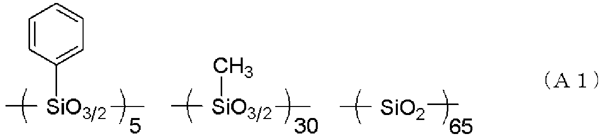

Adding 120 g of methanol, 0.1 g of 10% nitric acid, and 60 g of ultrapure water was performed to form a uniform solution at 40°C under a nitrogen atmosphere. Then, a mixture of 49.4 g of tetramethoxysilane, 20.4 g of methyltrimethoxysilane, and 5.0 g of phenyltrimethoxysilane was slowly added dropwise. After the dropwise addition, a hydrolytic condensation reaction was performed at 40°C for 12 hours. After the reaction was finished, 600 g of propylene glycol monoethyl ether (PGEE) was added, and water and an alcohol byproduct were distilled off to recover a polysiloxane compound (A1) for a silicon-containing anti-reflective film as 400 g of a PGEE solution (compound concentration: 10%). A molecular weight in terms of polystyrene of the polysiloxane compound (A1) for a silicon-containing anti-reflective film was measured to find Mw = 2,600.

### (Synthesis Example 2)

### Synthesis of Polysiloxane (A2) for Silicon-Containing Anti-Reflective Film

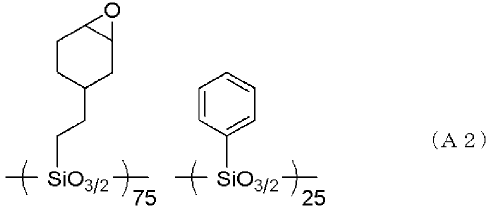

Adding 1,400 g of ethanol, 700 g of ultrapure water, and 50 g of a 25% tetramethylammonium hydroxide was performed to form a uniform solution at 40°C under a nitrogen atmosphere. A mixture of 138.6 g of 2-(3,4-epoxycyclohexyl)ethyltrimethoxysilane and 37.2 g of phenyltrimethoxysilane was slowly added dropwise, and then a reaction was performed at 40°C for 2 hours. After the reaction was finished, 35 g of acetic acid was added to terminate the reaction, and a pressure was reduced to distill off ethanol. Into the solution after the distillation, 2,000 ml of ethyl acetate was added, the aqueous layer was separated, the organic layer was washed twice with 400 ml of ultrapure water, then 1,000 g of propylene glycol monomethyl ether acetate (PGMEA) was added, and a water content and the low-boiling point solvent were distilled off to recover a polysiloxane compound (A2) for a silicon-containing anti-reflective film as 600 g of a PGMEA solution (compound concentration: 20%). A molecular weight in terms of polystyrene of the polysiloxane compound (A2) for a silicon-containing anti-reflective film was measured to find Mw = 2,800.

### (Synthesis Example 3)

### Synthesis of Polysiloxane (A3) for Silicon-Containing Anti-Reflective Film

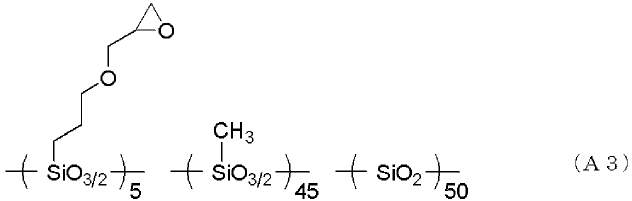

Adding 120 g of methanol, 0.1 g of 10% nitric acid, and 60 g of ultrapure water was performed to form a uniform solution at 40°C under a nitrogen atmosphere. Then, a mixture of 38.1 g of tetramethoxysilane, 30.6 g of methyltrimethoxysilane, and 5.9 g of 3-glycidoxypropyltrimethoxysilane was slowly added dropwise. After the dropwise addition, a hydrolytic condensation reaction was performed at 40°C for 12 hours. After the reaction was finished, 600 g of propylene glycol monoethyl ether (PGEE) was added, and a water content and an alcohol byproduct were distilled off to recover a polysiloxane compound (A3) for a silicon-containing anti-reflective film as 440 g of a PGEE solution (compound concentration: 10%). A molecular weight in terms of polystyrene of the polysiloxane compound (A3) for a silicon-containing anti-reflective film was measured to find Mw = 2,900.

### (Synthesis Example 4)

### Synthesis of Polysiloxane (A4) for Silicon-Containing Anti-Reflective Film

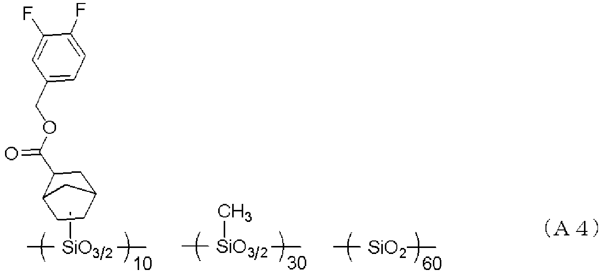

Into a mixture of 120 g of methanol, 0.1 g of 10% nitric acid, and 60 g of deionized water, a mixture of 20.4 g of methyltrimethoxysilane, 45.7 g of tetramethoxysilane, and 20.1 g of a compound represented by the following formula (A4-1) was added, and the mixture was retained at 40°C for 12 hours to perform hydrolytic condensation. After the reaction was finished, 500 g of propylene glycol monoethyl ether (PGEE) was added, and a water content used for the hydrolytic condensation and an alcohol byproduct were distilled off under a reduced pressure to obtain a polysiloxane compound (A4) for a silicon-containing anti-reflective film as 450 g of a PGEE solution (compound concentration: 10%). A molecular weight in terms of polystyrene of the polysiloxane compound (A4) for a silicon-containing anti-reflective film was measured to find Mw = 2,200.

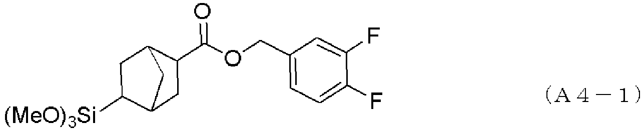

### (Synthesis Example 5)

### Synthesis of Polycarbosilane (A5) for Silicon-Containing Anti-Reflective Film

Into a nitrogen-filled reaction container, 2.9 g of magnesium and 5.5 g of tetrahydrofuran were added, and the mixture was stirred at 20°C. Then, 8.7 g of a compound represented by the following formula (Z-1), 2.2 g of a compound represented by the following formula (Z-2), and 4.7 g of a compound represented by the following formula (Z-3) were dissolved in 56 g of tetrahydrofuran to prepare a monomer solution. A temperature in the reaction container was set to 20°C, and the monomer solution was added dropwise over 1 hour while stirring the mixture. The time when the dropwise addition was completed was regarded as the starting time of a reaction, the reaction was performed at 40°C for 1 hour and then 60°C for 3 hours. After the reaction was finished, 33 g of tetrahydrofuran was added, and the polymerization solution was cooled to 10°C or lower with ice cooling. Into the cooled polymerization solution, 15.2 g of triethylamine was added, and then 4.8 g of methanol was added dropwise through a dropping funnel over 10 minutes while stirring the mixture. The time when the dropwise addition was completed was regarded as the starting time of a reaction, the reaction was performed at 20°C for 1 hour. The polymerization solution was poured into 110 g of diisopropyl ether, and the precipitated salt was filtered off. Then, tetrahydrofuran, excess triethylamine, and excess methanol in the filtrate were removed by using an evaporator. The obtained residue was poured into 28 g of diisopropyl ether, the precipitated salt was filtered off, and 20 g of cyclohexanone was added into the filtrate. Diisopropyl ether in the solution was removed by using an evaporator to obtain a cyclohexanone solution of a polycarbosilane (A5) for a silicon-containing anti-reflective film having a solid-content concentration of 8 mass%. Mw of the polycarbosilane (A5) for a silicon-containing anti-reflective film was 1,960.

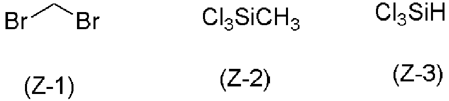

### (Synthesis Example 6)

### Synthesis of Polysilane (A6) for Silicon-Containing Anti-Reflective Film

Into 100.0 g of tetrahydrofuran, 10.0 g of OGSOL SI-10-20 (Mw: 1,900) produced by Osaka Gas Chemicals Co., Ltd., was dissolved, and 6.0 g of triethylamine and 16.0 g of ultrapure water were added. This solution was subjected to a reaction under reflux for 7 hours, then 375 g of propylene glycol monoethyl ether (PGEE) was added, and concentrated under a reduced pressure to obtain 91.3 g of a PGEE solution of a polysilane (A6) for a silicon-containing anti-reflective film (polymer concentration: 11%). Mw was 980.

### (Synthesis Example 7)

### Synthesis of Polysilane (A7) for Silicon-Containing Anti-Reflective Film

Into 100.0 g of tetrahydrofuran, 10.0 g of OGSOL SI-20-10 (Mw: 1,300) produced by Osaka Gas Chemicals Co., Ltd., was dissolved, and 2.0 g of 29% aqueous ammonia and 6.0 g of ultrapure water were added. This solution was subjected to a reaction under reflux for 6.5 hours, then 250 g of propylene glycol monoethyl ether (PGEE) was added, and concentrated under a reduced pressure to obtain 70.3 g of a PGEE solution of a polysilane (A7) for a silicon-containing anti-reflective film (polymer concentration: 15%). Mw was 870.

### (Synthesis Example 8)

### Synthesis of Polysilane (A8) for Silicon-Containing Anti-Reflective Film

Into 100.0 g of tetrahydrofuran, 10.0 g of Modified OGSOL SI-20-10 (Mw: 1,400) produced by Osaka Gas Chemicals Co., Ltd., was dissolved, and 6.0 g of triethylamine and 16.0 g of ultrapure water were added. This solution was subjected to a reaction under reflux for 12 hours, then 250 g of propylene glycol monoethyl ether (PGEE) was added, and concentrated under a reduced pressure to obtain 71.3 g of a PGEE solution of a polysilane (A8) for a silicon-containing anti-reflective film (polymer concentration: 14%). Mw was 830.

### (Synthesis Example 9)

### Synthesis of Polysilane (A9) for Silicon-Containing Anti-Reflective Film

Into a mixture of 120 g of PGEE, 1 g of 70% nitric acid, and 60 g of deionized water, a mixture of 17.0 g of methyltrimethoxysilane, 5.0 g of phenyltrimethoxysilane, 45.7 g of tetramethoxysilane, and 54.6 g of the PGEE solution of the polysilane (A6) for a silicon-containing anti-reflective film was added, and the mixture was retained at 40°C for 12 hours to perform hydrolytic condensation. After the reaction was finished, 300 g of PGEE was added, and an alcohol biproduct and excess water was distilled off under a reduced pressure to obtain 300 g of a PGEE solution of a polysilane (A9) for a silicon-containing anti-reflective film (polymer concentration: 12%). Mw was 3,000.

### (Synthesis Example 10)

### Synthesis of Polysilane (A10) for Silicon-Containing Anti-Reflective Film

Into a mixture of 80 g of PGEE, 1 g of 70% nitric acid, and 60 g of deionized water, a mixture of 17.0 g of methyltrimethoxysilane, 5.0 g of phenyltrimethoxysilane, 45.7 g of tetramethoxysilane, and 43.6 g of the PGEE solution of the polysilane (A8) for a silicon-containing anti-reflective film was added, and the mixture was retained at 40°C for 12 hours to perform hydrolytic condensation. After the reaction was finished, 300 g of PGEE was added, and an alcohol biproduct and excess water was distilled off under a reduced pressure to obtain 320 g of a PGEE solution of a polysilane (A10) for a silicon-containing anti-reflective film (polymer concentration: 11%). Mw was 2, 900.

### Synthesis of (B) Organic Polymers (B1) to (B9) and Polymer Compounds (R1) to (R2)

(B1) to (B9) as polymer compounds of organic polymers (B) and (R1) to (R2) as comparative polymer compounds were synthesized. For preparing these polymer compounds, monomers (J1) to (J9) described below were used.

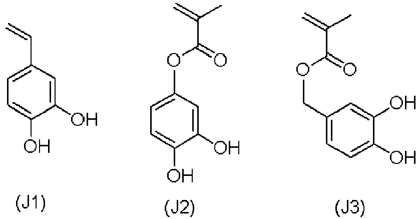

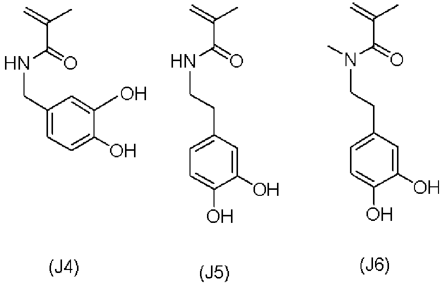

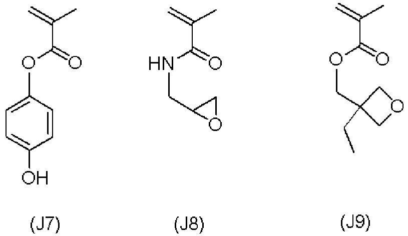

### (Synthesis Example 11)

### Synthesis of Organic Polymer (B1)

Under a nitrogen atmosphere, 37.5 g of propylene glycol monomethyl ether acetate (PGMEA) was heated and stirred at 80°C. Into this, a mixture of 50.0 g of (J1) and 82.5 g of PGMEA and a mixture of 4.2 g of dimethyl 2,2-azobis(2-methylpropionate) and 30.0 g of PGMEA were simultaneously and separately added over 2 hours. The mixture was further heated and stirred for 24 hours, and then cooled to room temperature to obtain a PGMEA solution of a target polymer (B1). As a result of analysis, the polymer (B-1) had a weight-average molecular weight (Mw) of 10,100 and a dispersion degree (Mw/Mn) of 2.1.

Synthesis of Organic Polymers (B2) to (B9) and Polymer Compounds (R1) to (R2) (Synthesis Examples 12 to 19 and Comparative Examples 1 to 2)

Organic polymers (B2) to (B9) and polymer compounds (R1) to (R2) were synthesized by using raw materials shown in Table 1 under the same condition as of the synthesis of (B1) to obtain each target product. Table 1 show the results.

**[Table 1]**

| Synthesis Example | Monomer 1 | | Monomer 2 | | Polymerizing agent | Polymer compound | Mw | Mw/Mn |
|---|---|---|---|---|---|---|---|---|
| | Raw material | g | Raw material | g | g | | | |
| 11 | J1 | 50 | | | 4.2 | B1 | 10,100 | 2.1 |
| 12 | J2 | 50 | | | 3.0 | B2 | 13,600 | 2.4 |
| 13 | J3 | 5 | | | 0.3 | B3 | 14,000 | 2.6 |
| 14 | J4 | 50 | | | 2.8 | B4 | 18,200 | 2.1 |
| 15 | J5 | 50 | | | 2.6 | B5 | 8,300 | 1.8 |
| 16 | J6 | 50 | | | 2.4 | B6 | 5,500 | 2.3 |
| 17 | J1 | 30 | J7 | 20 | 3.8 | B7 | 16,600 | 3.2 |
| 18 | J2 | 40 | J8 | 10 | 3.2 | B8 | 14,300 | 2.5 |
| 19 | J3 | 45 | J9 | 5 | 2.8 | B9 | 19,700 | 2.8 |
| Comparative Synthesis Example 1 | J7 | 50 | | | 3.2 | R1 | 7,000 | 2.7 |
| Comparative Synthesis Example 2 | J8 | 50 | | | 4.1 | R2 | 9,300 | 2.3 |

### Synthesis of (B) Organic Polymers (B10) to (B14)

(B10) to (B14) as resins of organic polymers (B) and (R3) to (R5) as comparative resins were synthesized. For preparing these resins, resin raw materials (K1) to (K9) being monomers described below were used.

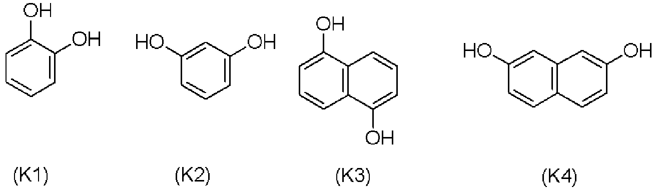

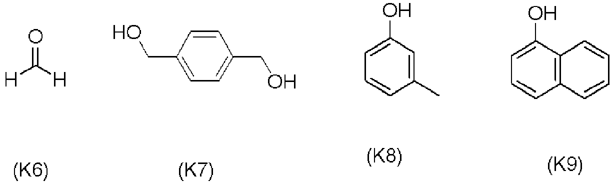

### (Synthesis Example 20)

### Synthesis of Resin (B10)

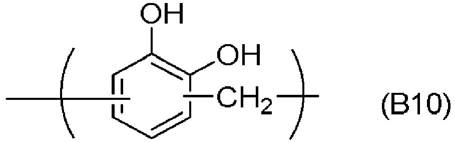

Under a nitrogen atmosphere, 144.2 g of a resin raw material (K1), 53.2 g of a resin raw material (K6), and 250 g of propylene glycol monomethyl ether (PGME) were added and uniformized at an internal temperature of 100°C. Thereafter, a mixed liquid in which 3.0 g of paratoluenesulfonic acid monohydrate and 7.1 g of PGME were mixed and uniformized in advance was slowly added dropwise, and a reaction was performed at an internal temperature of 120°C for 8 hours. After the reaction was finished, the mixture was cooled to room temperature, 2,000 ml of MIBK was added, washed six times with 500 ml of pure water, and the organic layer was dried and solidified under a reduced pressure to obtain a resin (B10) .

The weight-average molecular weight (Mw) and the dispersion degree (Mw/Mn) were determined by GPC to obtain the following results.
(B10): Mw = 3,300, Mw/Mn = 2.16

### (Synthesis Example 21)

### Synthesis of Resin (B11)

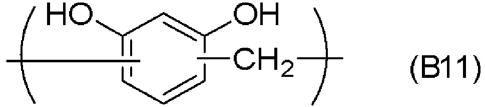

Under a nitrogen atmosphere, 144.2 g of a resin raw material (K2), 95.8 g of a resin raw material (K6), and 250 g of propylene glycol monomethyl ether (PGME) were added and uniformized at an internal temperature of 100°C. Thereafter, a mixed liquid in which 3.0 g of paratoluenesulfonic acid monohydrate and 7.1 g of PGME were mixed and uniformized in advance was slowly added dropwise, and a reaction was performed at an internal temperature of 120°C for 8 hours. After the reaction was finished, the mixture was cooled to room temperature, 2,000 ml of MIBK was added, washed six times with 500 ml of pure water, and the organic layer was dried and solidified under a reduced pressure to obtain a resin (B11) .

The weight-average molecular weight (Mw) and the dispersion degree (Mw/Mn) were determined by GPC to obtain the following results.
(B11): Mw = 8,500, Mw/Mn = 2.65

### (Synthesis Example 22)

### Synthesis of Organic Polymer (B12)

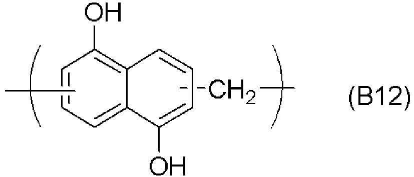

Under a nitrogen atmosphere, 160.2 g of a resin raw material (K3), 40.6 g of a resin raw material (K6), and 250 g of propylene glycol monomethyl ether (PGME) were added and uniformized at an internal temperature of 100°C. Thereafter, a mixed liquid in which 3.2 g of paratoluenesulfonic acid monohydrate and 8.0 g of PGME were mixed and uniformized in advance was slowly added dropwise, and a reaction was performed at an internal temperature of 120°C for 8 hours. After the reaction was finished, the mixture was cooled to room temperature, 2,000 ml of MIBK was added, washed six times with 500 ml of pure water, and the organic layer was dried and solidified under a reduced pressure to obtain a resin (B12) .

The weight-average molecular weight (Mw) and the dispersion degree (Mw/Mn) were determined by GPC to obtain the following results.
(B12): Mw = 3,400, Mw/Mn = 2.54

### (Synthesis Example 23)

### Synthesis of Resin (B13)

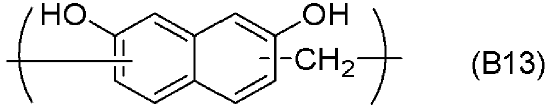

Under a nitrogen atmosphere, 160.2 g of a resin raw material (K4), 40.6 g of a resin raw material (K6), and 300 g of propylene glycol monomethyl ether (PGME) were added and uniformized at an internal temperature of 100°C. Thereafter, a mixed liquid in which 3.2 g of paratoluenesulfonic acid monohydrate and 8.0 g of PGME were mixed and uniformized in advance was slowly added dropwise, and a reaction was performed at an internal temperature of 120°C for 8 hours. After the reaction was finished, the mixture was cooled to room temperature, 2,000 ml of MIBK was added, washed six times with 500 ml of pure water, and the organic layer was dried and solidified under a reduced pressure to obtain a resin (B13) .

The weight-average molecular weight (Mw) and the dispersion degree (Mw/Mn) were determined by GPC to obtain the following results.
(B13): Mw = 3,300, Mw/Mn = 2.41

### (Synthesis Example 24)

### Synthesis of Resin (B14)

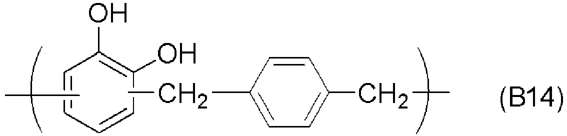

Under a nitrogen atmosphere, 94.1 g of a resin raw material (K1), 90.3 g of a resin raw material (K7), and 400 g of dichloromethane were added to prepare a uniform dispersion at an internal temperature of 30°C. Thereafter, 211 g of methanesulfonic acid was added dropwise over 2 hours, and a reaction was performed at an internal temperature of 30°C for 24 hours. After the reaction was finished, the mixture was cooled to room temperature, 2,000 ml of MIBK was added, washed six times with 500 ml of pure water, and the organic layer was dried and solidified under a reduced pressure. Into the residue, 300 g of THF was added to prepare a uniform solution, and crystallized in 2,000 g of hexane. The precipitated crystal was separated by filtration, and washed twice with 500 g of hexane to be recovered. The recovered crystal was dried in vacuo at 70°C to obtain a resin (B14).

The weight-average molecular weight (Mw) and the dispersion degree (Mw/Mn) were determined by GPC to obtain the following results.
(B14): Mw = 6,700, Mw/Mn = 3.04

### (Synthesis Example 25)

### Synthesis of Resin (B15)

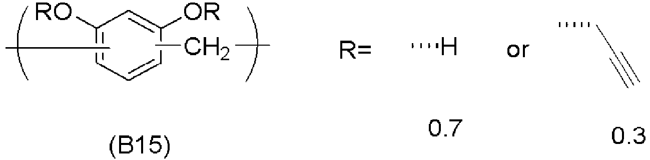

Under a nitrogen atmosphere, 20.0 g of the resin (B11), 13.6 g of potassium carbonate, and 100 g of DMF were added to prepare a uniform dispersion at an internal temperature of 50°C. Into this dispersion, 12.1 g of 3-bromo-1-propyne was slowly added, and a reaction was performed at an internal temperature of 50°C for 24 hours. Into the reaction liquid, 300 ml of methyl isobutyl ketone and 300 g of pure water were added to dissolve the precipitated salt, then the separated aqueous layer was removed, the obtained organic layer was added into 1,500 g of hexane, and the upper layer was removed. Thereafter, the organic layer was dissolved again with 300 ml of methyl isobutyl ketone, washed six times with 100 g of 3% nitric acid and 100 g of pure water, and then the organic layer was dried and solidified under a reduced pressure to obtain a resin (B15).

The weight-average molecular weight (Mw) and the dispersion degree (Mw/Mn) were determined by GPC to obtain the following results.
(B15): Mw = 6, 500, Mw/Mn = 2.95

Note that the resin (B15) had a repeating unit represented by the resin (B11).

### (Comparative Synthesis Example 3)

### Synthesis of Resin (R3) for Comparative Example

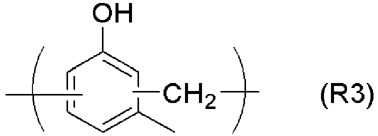

Under a nitrogen atmosphere, 216.3 g of a resin raw material (K8), 81.3 g of a resin raw material (K6), 10.8 g of oxalic acid, and 200 g of dioxane were added, and a reaction was performed at an internal temperature of 100°C for 24 hours. After the reaction was finished, the mixture was cooled to room temperature, 2,000 ml of MIBK was added, and washed six times with 500 ml of pure water. The organic layer was recovered, and a water content, the solvent, and the remained monomer were removed under a reduced pressure at 2 mmHg at an internal temperature of 150°C to obtain a resin (R3) for Comparative Example.

The weight-average molecular weight (Mw) and the dispersion degree (Mw/Mn) were determined by GPC to obtain the following results.
(R3): Mw = 3,300, Mw/Mn = 3.50

### (Comparative Synthesis Example 4)

### Synthesis of Resin (R4) for Comparative Example

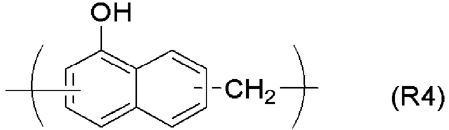

Under a nitrogen atmosphere, 144.2 g of a resin raw material (K9), 40.6 g of a resin raw material (K6), and 250 g of propylene glycol monomethyl ether (PGME) were added and uniformized at an internal temperature of 100°C. Thereafter, a mixed liquid in which 3.0 g of paratoluenesulfonic acid monohydrate and 7.1 g of PGME were mixed and uniformized in advance was slowly added dropwise, and a reaction was performed at an internal temperature of 120°C for 8 hours. After the reaction was finished, the mixture was cooled to room temperature, 2,000 ml of MIBK was added, washed six times with 500 ml of pure water, and the organic layer was dried and solidified under a reduced pressure to obtain a resin (R4) for Comparative Example.

The weight-average molecular weight (Mw) and the dispersion degree (Mw/Mn) were determined by GPC to obtain the following results.
(R4): Mw = 3,300, Mw/Mn = 2.26

### (Comparative Synthesis Example 5)

### Synthesis of Resin (R5) for Comparative Example

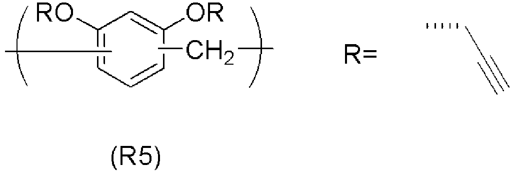

Under a nitrogen atmosphere, 20.0 g of the resin (B11), 45.3 g of potassium carbonate, and 100 g of DMF were added to prepare a uniform dispersion at an internal temperature of 50°C. Into this dispersion, 40.3 g of 3-bromo-1-propyne was slowly added, and a reaction was performed at an internal temperature of 50°C for 24 hours. Into the reaction liquid, 300 ml of methyl isobutyl ketone and 300 g of pure water were added to dissolve the precipitated salt, then the separated aqueous layer was removed, the obtained organic layer was added into 1,500 g of hexane, and the upper layer was removed. Thereafter, the organic layer was dissolved again with 300 ml of methyl isobutyl ketone, washed six times with 100 g of 3% nitric acid and 100 g of pure water, and then the organic layer was dried and solidified under a reduced pressure to obtain a resin (R5) for Comparative Example.

The weight-average molecular weight (Mw) and the dispersion degree (Mw/Mn) were determined by GPC to obtain the following results.
(R5): Mw = 7,800, Mw/Mn = 3.05

### Preparation of Composition for Forming Silicon-Containing Anti-Reflective Film (UDL-1 to 22 and Comparative UDL-1 to 6)

The silicon-containing polymers (A) (A1) to (A10), the organic polymers (B) (B1) to (B15), the organic polymers (R1) to (R5) for Comparative Example, crosslinking agents (D1) to (D3), crosslinking catalysts, photoacid generators (AG1) to (AG4), and a high-boiling-point solvent (C-1) were dissolved in an organic solvent containing 0.1 mass% of FC-4430 (produced by 3M Corporation and purified by own compony) in proportions shown in Table 2 to Table 4, and filtered with a 0.1-pm filter made of a fluororesin to prepare compositions for forming a silicon-containing anti-reflective film (UDL-1 to 22 and Comparative UDL-1 to 6).

**[Table 2]**

| Composition for forming silicon-containing anti-reflective film | Silicon-containing polymer (A) | | | Organic polymer (B) | | Acid generator | Crosslinking catalyst | Crosslinking agent | Hihg-boiling-point solvent | Solvent |
|---|---|---|---|---|---|---|---|---|---|---|
| | | (parts by mass) | | | (parts by mass) | (parts by mass) | (parts by mass) | (parts by mass) | (parts by mass) | (parts by mass) |
| UDL-1 | A1 | 1 | Polysiloxane | B1 | 0.1 | | TPSNO₃ (0.1) | - | - | PGMEA/PGEE (30/70) |
| UDL-2 | A2 | 1 | Polysiloxane | B2 | 0.1 | | - | D1 (0.2) | - | PGMEA (100) |
| UDL-3 | A3 | 1 | Polysiloxane | B3 | 0.1 | AG1 (0.2) | - | D2 (0.2) | - | PGMEA/PGEE (30/70) |
| UDL-4 | A4 | 1 | Polysiloxane | B4 | 0.1 | AG2 (0.2) | | - | - | PGMEA/PGEE (30/70) |
| UDL-5 | A1 | 1 | Polysiloxane | B5 | 0.1 | AG3 (0.2) | | - | - | PGMEA/PGEE (30/70) |
| UDL-6 | A2 | 1 | Polysiloxane | B6 | 0.1 | AG4 (0.2) | - | D3 (0.2) | - | PGMEA (100) |
| UDL-7 | A3 | 1 | Polysiloxane | B7 | 0.1 | | QBANO₃ (0.1) | - | - | PGMEA/PGEE (30/70) |
| UDL-8 | A4 | 1 | Polysiloxane | B8 | 0.1 | | TPS-NO₃ (0.1) | - | - | PGMEA/PGEE (30/70) |
| UDL-9 | A1 | 1 | Polysiloxane | B9 | 0.1 | | | - | - | PGMEA/PGEE (30/70) |
| UDL-10 | A2 | 1 | Polysiloxane | B10 | 0.1 | AG4 (0.4) | - | D1 (0.2) | - | PGMEA (100) |
| UDL-11 | A3 | 1 | Polysiloxane | B11 | 0.1 | | TPSNO₃ (0.1) | - | | PGMEA/PGEE (30/70) |
| UDL-12 | A4 | 1 | Polysiloxane | B12 | 0.1 | | QBANO₃ (0.1) | - | | PGMEA/PGEE (30/70) |
| UDL-13 | A1 | 1 | Polysiloxane | B13 | 0.1 | | | | C-1 (5) | PGMEA/PGEE (30/70) |

**[Table 3]**

| Composition for forming silicon-containing anti-reflective film | Silicon-containing polymer (A) | | | Organic polymer (B) | | Acid generator | Crosslinking catalyst | Crosslinking agent | Hihg-boiling-point solvent | Solvent |
|---|---|---|---|---|---|---|---|---|---|---|
| | | (parts by mass) | | | (parts by mass) | (parts by mass) | (parts by mass) | (parts by mass) | (parts by mass) | (parts by mass) |
| UDL-14 | A2 | 1 | Polysiloxane | B14 | 0.1 | | | | - | PGMEA (100) |
| UDL-15 | A3 | 1 | Polysiloxane | B15 | 0.1 | | | | | PGMEA/PGEE (30/70) |
| UDL-16 | A5 | 1 | Polycarbosilane | B1 | 0.1 | | | | | CyHO(100) |
| UDL-17 | A6 | 1 | Polysilane | B2 | 0.1 | | | | | PGMEA/PGEE (30/70) |
| UDL-18 | A7 | 1 | Polysilane | B3 | 0.1 | | | | | PGMEA/PGEE (30/70) |
| UDL-19 | A8 | 1 | Polysilane | B4 | 0.1 | | | | | PGMEA/PGEE (30/70) |
| UDL-20 | A9 | 1 | Polysilane | B5 | 0.1 | | | | | PGMEA/PGEE (30/70) |
| UDL-21 | A10 | 1 | Polysilane | B6 | 0.1 | | | | | PGMEA/PGEE (30/70) |
| UDL-22 | A2 | 1 | Polysiloxane | B10 | 0.5 | | | | | PGMEA/PGEE (30/70) |

**[Table 4]**

| Composition for forming silicon-containing anti-reflective film | Silicon-containing polymer (A) | | | Organic polymer (B) | | Acid generator | Crosslinking catalyst | Crosslinking agent | Hihg-boiling-point solvent | Solvent |
|---|---|---|---|---|---|---|---|---|---|---|
| | | (parts by mass) | | | (parts by mass) | (parts by mass) | (parts by mass) | (parts by mass) | (parts by mass) | (parts by mass) |
| Comparative UDL-1 | A2 | 1 | Polysiloxane | - | - | | TPSNO₃ (0.1) | | | PGEE (100) |
| Comparative UDL-2 | A1 | 1 | Polysiloxane | R1 | 0.1 | | | | | PGMEA/PGEE (30/70) |
| Comparative UDL-3 | A2 | 1 | Polysiloxane | R2 | 0.1 | | | | | PGMEA (100) |
| Comparative UDL-4 | A3 | 1 | Polysiloxane | R3 | 0.1 | | | | | PGMEA/PGEE (30/70) |
| Comparative UDL-5 | A4 | 1 | Polysiloxane | R4 | 0.1 | | | | | PGMEA/PGEE (30/70) |
| Comparative UDL-6 | A1 | 1 | Polysiloxane | R5 | 0.1 | | | | | PGMEA/PGEE (30/70) |

The used crosslinking agents (D1) to (D3) are as shown below.

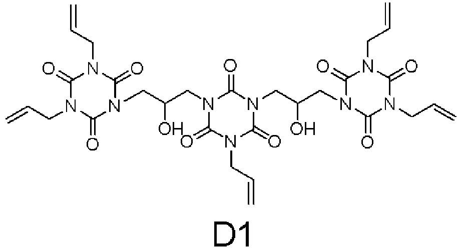

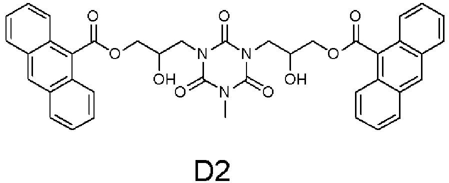

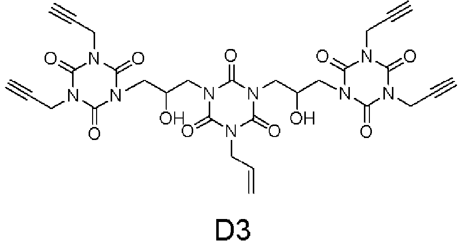

The used crosslinking catalysts are as shown below.
- TPSNO₃: triphenylsulfonium nitride
- QBANO₃: tetrabutylammonium nitride

The used solvents are as shown below.
- PGEE: propylene glycol monoethyl ether
- PGMEA: propylene glycol monomethyl ether acetate
- CyHO: cyclohexanone

The used photoacid generators are as shown in the following Table 5.

**[Table 5]**

| Acid generator | Structure |
|---|---|
| (AG1) | 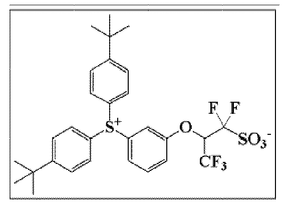 |
| (AG2) | 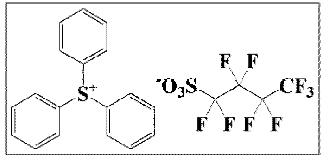 |
| (AG3) | 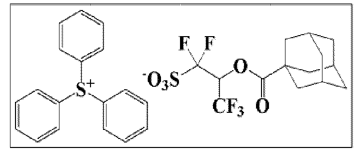 |
| (AG4) | (CH₃CH₂)₃N⁺H |
| | C₄F₉SO₃⁻ |

### Solvent Resistance Evaluation (Examples 1-1 to 1-22 and Comparative Examples 1-1 to 1-6)

The compositions for forming a silicon-containing anti-reflective film (UDL-1 to 22 and Comparative UDL-1 to 6) prepared above were applied on a silicon substrate, baked at 220°C for 60 seconds, and then film thicknesses at from a center of the substrate to a periphery were measured to calculate an average film thickness ("a" [nm]). Subsequently, a PGMEA solvent is dispensed thereon, left to stand for 30 seconds, spin-dried, baked at 100°C for 60 seconds for evaporating PGMEA, and a film thickness ("b" [nm]) was measured. A difference in film the thickness before and after the PGMEA treatment (film residual rate: (b/a)×100) was determined. Table 6 shows the results.

**[Table 6]**

| Example | Composition for forming silicon-containing anti-reflective film | Baking temperature | Film thickness after film formation: "a" | Film thickness after solvent treatment: "b" | b/a ×100 |
|---|---|---|---|---|---|
| | | | Å | Å | % |
| Example 1-1 | UDL-1 | 220°C | 100.4 | 100.3 | 100% |
| Example 1-2 | UDL-2 | 220°C | 100.8 | 100.7 | 100% |
| Example 1-3 | UDL-3 | 220°C | 101.3 | 101.3 | 100% |
| Example 1-4 | UDL-4 | 220°C | 100.5 | 100.4 | 100% |
| Example 1-5 | UDL-5 | 220°C | 101.2 | 101.1 | 100% |
| Example 1-6 | UDL-6 | 220°C | 100.6 | 100.6 | 100% |
| Example 1-7 | UDL-7 | 220°C | 99.3 | 99.2 | 100% |
| Example 1-8 | UDL-8 | 220°C | 99.8 | 99.6 | 100% |
| Example 1-9 | UDL-9 | 220°C | 100.3 | 100.3 | 100% |
| Example 1-10 | UDL-10 | 220°C | 100.8 | 100.7 | 100% |
| Example 1-11 | UDL-11 | 220°C | 99.4 | 99.4 | 100% |
| Example 1-12 | UDL-12 | 220°C | 100 | 99.9 | 100% |
| Example 1-13 | UDL-13 | 220°C | 100.2 | 100.2 | 100% |
| Example 1-14 | UDL-14 | 220°C | 99.8 | 99.8 | 100% |
| Example 1-15 | UDL-15 | 220°C | 101.4 | 101.3 | 100% |
| Example 1-16 | UDL-16 | 220°C | 103.7 | 103.5 | 100% |
| Example 1-17 | UDL-17 | 220°C | 104.2 | 104 | 100% |
| Example 1-18 | UDL-18 | 220°C | 103.1 | 103.1 | 100% |
| Example 1-19 | UDL-19 | 220°C | 103.7 | 103.6 | 100% |
| Example 1-20 | UDL-20 | 220°C | 106.2 | 106 | 100% |
| Example 1-21 | UDL-21 | 220°C | 103.6 | 103.5 | 100% |
| Example 1-22 | UDL-22 | 220°C | 100.5 | 100.4 | 100% |
| Comparative Example 1-1 | Comparative UDL-1 | 220°C | 99.6 | 99.6 | 100% |
| Comparative Example 1-2 | Comparative UDL-2 | 220°C | 99.8 | 99.8 | 100% |
| Comparative Example 1-3 | Comparative UDL-3 | 220°C | 100.4 | 100.1 | 100% |
| Comparative Example 1-4 | Comparative UDL-4 | 220°C | 100 | 99.7 | 100% |
| Comparative Example 1-5 | Comparative UDL-5 | 220°C | 99.7 | 99.6 | 100% |
| Comparative Example 1-6 | Comparative UDL-6 | 220°C | 99.8 | 99.5 | 100% |

Examples 1-1 to 1-22 using the compositions for forming a silicon-containing anti-reflective film of the present invention (UDL-1 to 22) have a film residual rate ((b/a)×100) after the PGMEA rinsing treatment of 99% or more. It is understood that the crosslinking reaction occurs to exhibit sufficient solvent resistance.

### Thin Film Formability (Examples 2-1 to 2-22 and Comparative Examples 2-1 to 2-6)

The compositions for forming a silicon-containing anti-reflective film (UDL-1 to 22 and Comparative UDL-1 to 6) prepared above were applied on a silicon substrate, and baked at 220°C for 60 seconds. By this operation, the silicon-containing anti-reflective film having a film thickness each regulated to 12 nm, 10 nm, or 7 nm was formed. Then, a single-layer resist for ArF being a resist upper layer film material was applied thereon, and baked at 105°C for 60 seconds to form a photoresist film having a film thickness of 100 nm. An immersion protective film material (TC-1) was applied on the photoresist film, and baked at 90°C for 60 seconds to form a protective film having a film thickness of 50 nm.

The resist upper layer film material (single-layer resist for ArF) was prepared by: dissolving a polymer (RP1), an acid generator (PAG1), and a basic compound (Amine1) in a solvent containing 0.1 mass% of a surfactant FC-4430 (produced by Sumitomo 3M Limited.) at proportions shown in Table 7; and filtering the solution with a filter made of a fluororesin with 0.1 um.

**[Table 7]**

| | Polymer (parts by mass) | Acid generator (parts by mass) | Basic compound (parts by mass) | Solvent (parts by mass) |
|---|---|---|---|---|
| Single-layer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (single-layer resist for ArF) are shown below.

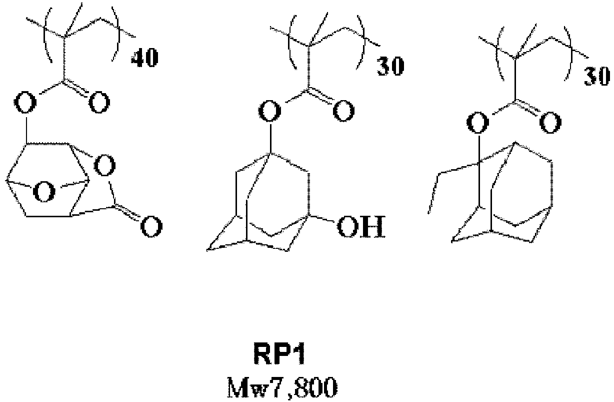

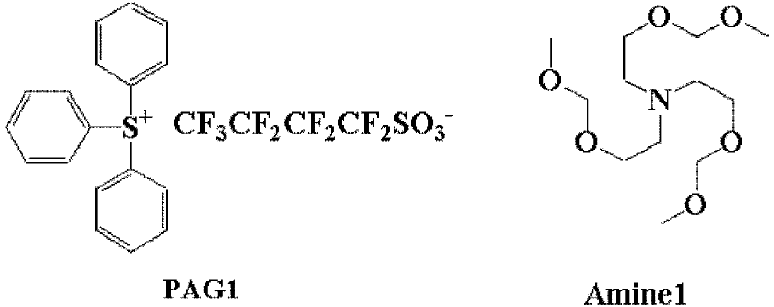

The immersion protective film material (TC-1) was prepared by: dissolving a protective film polymer (PP 1) in an organic solvent in proportions shown in Table 8; and filtering the solution with a filter made of a fluororesin with 0.1 um.

**[Table 8]**

| | Polymer (parts by mass) | Organic solvent (parts by mass) |
|---|---|---|
| TC-1 | PP1 (100) | Diisoamyl ether (2700) |
| | | 2-Methyl-1-butanol (270) |

The polymer (PP1) used for the immersion protective film material (TC-1) is shown below.

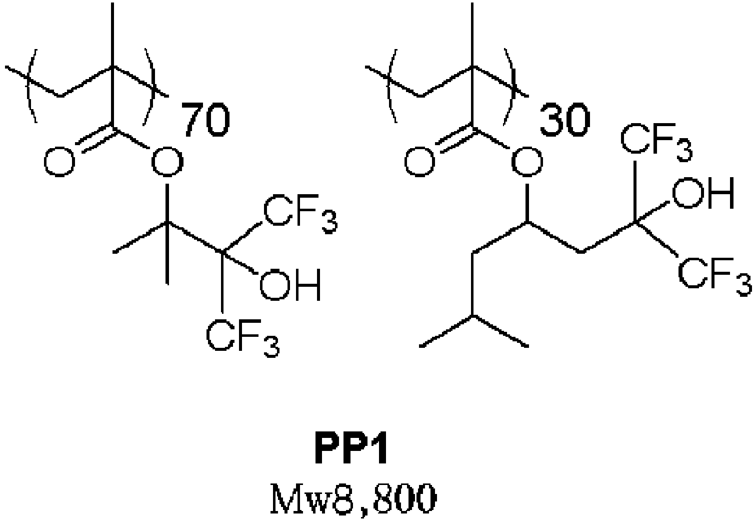

Then, the film was exposed with an ArF immersion exposure device (produced by NIKON CORPORATION; NSR-S610C, NA: 1.30, σ: 0.98/0.65, 35°-dipole s-polarized illumination, 6% halftone phase-shifting mask), baked at 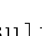 100°C for 60 seconds (PEB), and developed with a 2.38 mass% aqueous solution of tetramethylammonium hydroxide (TMAH) for 30 seconds to obtain a positive line-and-space pattern (resist pattern) of 1:1 with 10 um.

Film formability of the silicon-containing anti-reflective film was evaluated by using length-measurement SEM (CG5000), produced by Hitachi High-Technologies Corporation. Specifically, focus was regulated by utilizing the line pattern obtained above, and film formability of the silicon-containing anti-reflective film having the formed space pattern was observed. A case where film formation failure such as a sea-island structure was not generated was judged as "Good", and a case where the sea-island structure was observed was judged as "Poor". Table 9 shows the results.

Table 9 also shows results evaluated by changing the underlayer of the silicon-containing anti-reflective film from the silicon substrate to an oxynitride film (SiON).

Structural formulae of a silicon-containing middle film polymer for ArF (SiP1) and a crosslinking catalyst (CAT1) used for forming the oxynitride film (SiON) are shown below.

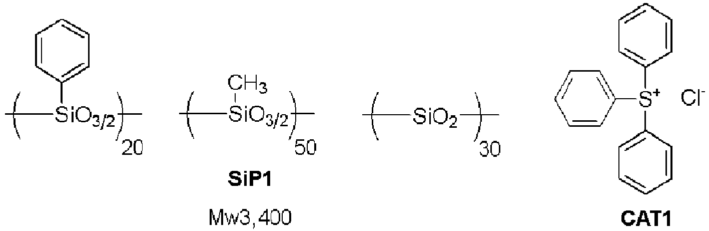

**[Table 9]**

| Example | Composition for forming silicon-containing anti-reflective film | Baking temperature | Film formability | Film formability | Film formability | Film formability | Film formability | Film formability |
|---|---|---|---|---|---|---|---|---|
| | | | 12 nm on Si | 10 nm on Si | 7 nm on Si | 12 nm on SiON | 10 nm on SiON | 7 nm on SiON |
| Example 2-1 | UDL-1 | 220°C | Good | Good | Poor | Good | Good | Poor |
| Example 2-2 | UDL-2 | 220°C | Good | Good | Poor | Good | Good | Poor |
| Example 2-3 | UDL-3 | 220°C | Good | Good | Poor | Good | Good | Poor |
| Example 2-4 | UDL-4 | 220°C | Good | Good | Poor | Good | Good | Poor |
| Example 2-5 | UDL-5 | 220°C | Good | Good | Poor | Good | Good | Poor |
| Example 2-6 | UDL-6 | 220°C | Good | Good | Poor | Good | Good | Poor |
| Example 2-7 | UDL-7 | 220°C | Good | Poor | Poor | Good | Poor | Poor |
| Example 2-8 | UDL-8 | 220°C | Good | Poor | Poor | Good | Poor | Poor |
| Example 2-9 | UDL-9 | 220°C | Good | Poor | Poor | Good | Poor | Poor |
| Example 2-10 | UDL-10 | 220°C | Good | Good | Good | Good | Good | Good |
| Example 2-11 | UDL-11 | 220°C | Good | Good | Good | Good | Good | Good |
| Example 2-12 | UDL-12 | 220°C | Good | Good | Good | Good | Good | Good |
| Example 2-13 | UDL-13 | 220°C | Good | Good | Good | Good | Good | Good |
| Example 2-14 | UDL-14 | 220°C | Good | Good | Good | Good | Good | Good |
| Example 2-15 | UDL-15 | 220°C | Good | Good | Poor | Good | Good | Poor |
| Example 2-16 | UDL-16 | 220°C | Good | Poor | Poor | Good | Poor | Poor |
| Example 2-17 | UDL-17 | 220°C | Good | Poor | Poor | Good | Poor | Poor |
| Example 2-18 | UDL-18 | 220°C | Good | Poor | Poor | Good | Poor | Poor |
| Example 2-19 | UDL-19 | 220°C | Good | Poor | Poor | Good | Poor | Poor |
| Example 2-20 | UDL-20 | 220°C | Good | Poor | Poor | Good | Poor | Poor |
| Example 2-21 | UDL-21 | 220°C | Good | Poor | Poor | Good | Poor | Poor |
| Example 2-22 | UDL-22 | 220°C | Good | Good | Good | Good | Good | Good |
| Comparative Exmaple 2-1 | Comparative UDL-1 | 220°C | Poor | Poor | Poor | Poor | Poor | Poor |
| Comparative Exmaple 2-2 | Comparative UDL-2 | 220°C | Poor | Poor | Poor | Poor | Poor | Poor |
| Comparative Exmaple 2-3 | Comparative UDL-3 | 220°C | Poor | Poor | Poor | Poor | Poor | Poor |
| Comparative Exmaple 2-4 | Comparative UDL-4 | 220°C | Poor | Poor | Poor | Poor | Poor | Poor |
| Comparative Exmaple 2-5 | Comparative UDL-5 | 220°C | Poor | Poor | Poor | Poor | Poor | Poor |
| Comparative Exmaple 2-6 | Comparative UDL-6 | 220°C | Poor | Poor | Poor | Poor | Poor | Poor |

The silicon-containing anti-reflective film formed by using the composition for forming a silicon-containing anti-reflective film of the present invention resulted in excellent film formability in forming a thin film with 12 nm in film thickness.

Meanwhile, differing from the composition for forming a silicon-containing anti-reflective film of the present invention, the sea-island structure presumably derived from aggregation was observed in thin film formation of 12 nm in film thickness with Comparative Examples 2-1 to 2-6 using Comparative UDL-1 to 6 not containing the organic polymer (B), which is the polymer having two or more hydroxy groups in the repeating unit structure of the polymer and having no silicon. This was presumably because compatibility with the underlayer substrate was insufficient to cause aggregation of the silicon-containing polymer.

Among the added organic polymers (B), the silicon-containing anti-reflective film formed by using UDL-1 to 6, 10 to 15, and 22 using the organic polymer (B) only containing the polymer having two or more hydroxy groups in the repeating unit structure of the polymer and having no silicon yielded the results of exhibiting excellent film formability even in thin film formation with 10 nm in film thickness. It is considered that a larger proportion of the polymer having two or more hydroxy groups in the repeating unit structure of the polymer and having no silicon in the organic polymer (B) improves the compatibility with the underlayer substrate to improve the film formability of the silicon-containing anti-reflective film.

The silicon-containing anti-reflective film formed by using UDL-10 to 14 and 22 using the polymer having the structure of the general formula (2B) for the organic polymer (B) resulted in excellent film formability also in forming a further thin film with 7 nm in film thickness. The factor is unclear, but it is presumed that the polymer having the structure of the general formula (2B) has excellent heat resistance and thereby has improved thermal curability and thermal flowability than the composition for forming a silicon-containing anti-reflective film using the polymer having the structure of the general formula (1B), and inhibit aggregation of the silicon-containing polymer in baking.

### Evaluation of Optical Constants (Examples 3-1 to 3-5 and Comparative Example 3-1

The compositions for forming a silicon-containing anti-reflective film (UDL-2, 6, 10, 14, and 22, and Comparative UDL-1) prepared above were applied on a silicon substrate, baked at 220°C for 60 seconds, and then optical constants (refractive index "n" and extinction coefficient "k") at a wavelength of 193 nm were determined with an incident-angle-variable spectrometric ellipsometer (VASE), available from J. A. Woollam Co., Inc. The following Table 10 shows the results.

**[Table 10]**

| Example | Composition for forming silicon-containing anti-reflective film | Baking temperature | n | k |
|---|---|---|---|---|
| | | | 193 nm | 193 nm |
| Example 3-1 | UDL-2 | 220°C | 1.78 | 0.33 |
| Example 3-2 | UDL-6 | 220°C | 1.78 | 0.38 |
| Example 3-3 | UDL-10 | 220°C | 1.8 | 0.33 |
| Example 3-4 | UDL-14 | 220°C | 1.76 | 0.33 |
| Example 3-5 | UDL-22 | 220°C | 1.72 | 0.32 |
| Comparative Example 3-1 | Comparative UDL-1 | 220°C | 1.81 | 0.32 |

All the optical constants of Examples 3-1 to 3-5, which used the composition for forming a silicon-containing anti-reflective film containing the silicon-containing polymer (A2), were an "n" value of between 1.70 to 1.85 and a "k" value of between 0.3 to 0.40. Although the composition for forming a silicon-containing anti-reflective film of the present invention has composition containing the organic polymer (B) in order to improve thin film formability, it is understood that change in the optical constant from single composition of the silicon-containing polymer (A) is small, and deterioration of the anti-reflective performance essential for the anti-reflective film can be inhibited to minimum. Meanwhile, a larger content rate of the organic polymer (B) contained in the composition for forming a silicon-containing anti-reflective film more decreases the optical constant "n", and thus, it can be said that the addition amount is preferably 50 parts by mass or less relative to 100 parts by mass of the silicon-containing polymer (A).

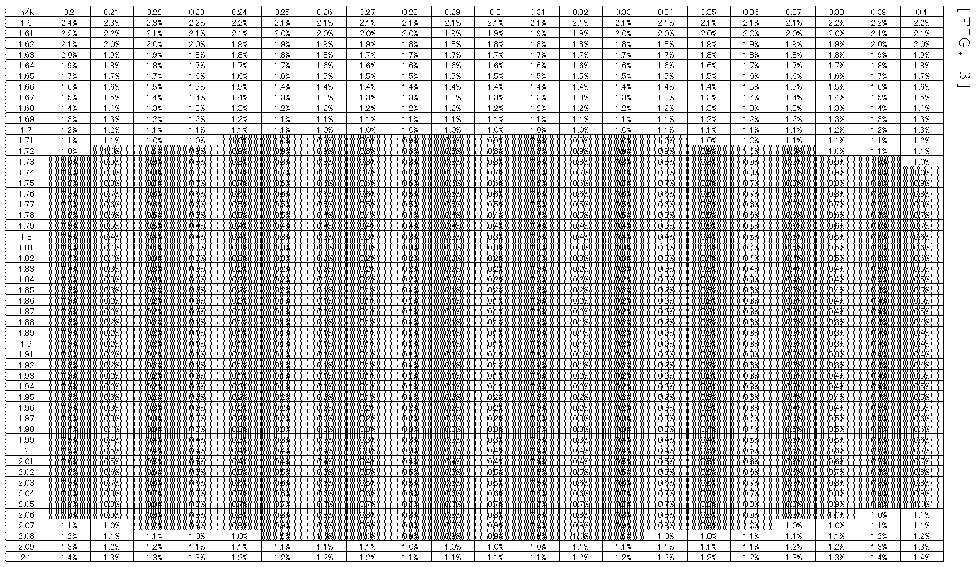

As for the optical constants, although depending on the film thickness, the type of the laminated film, etc., the "n" value of between about 1.70 to 2.05 and the "k" value of between about 0.2 to 0.4 can mostly inhibit reflecting light from the substrate in ArF immersion and high NA exposure even in forming the anti-reflective film as a thin film of 10 nm or less, which can be applied as the resist underlayer film for the photoresist patterning (FIG. 3). It is understood that all the optical constants in the above Examples are within the preferable ranges and can be applied as the anti-reflective film for the photoresist patterning.

### ArF Patterning Test (Examples 4-1 to 4-5 and Comparative Examples 4-1 to 4-2)

On a silicon wafer on which a silicon oxide film with 200 nm in film thickness was formed, an amorphous carbon film (carbon content: 73 atomic%) was formed with 35 nm in film thickness as an organic underlayer film, and a silicon oxynitride film (SiON) was formed with 15 nm in film thickness as a silicon-containing hard mask. The composition for forming a silicon-containing anti-reflective film (UDL-2, 6, 10, 14, and 22, and Comparative UDL-1) were applied on the SiON film and heated at 220°C for 60 seconds to form a silicon-containing anti-reflective film with 10 nm in film thickness.

Subsequently, on the silicon-containing anti-reflective film, an ArF resist solution (PR1) for negative development containing the following ArF resist polymer (P-1), a photoacid generator (PAG-A), an amine quencher (Q-1), a surfactant (F-1), and solvents at composition shown in Table 11 was applied, and baked at 110°C for 60 seconds to form a photoresist film (PR-1) with 70 nm in film thickness.

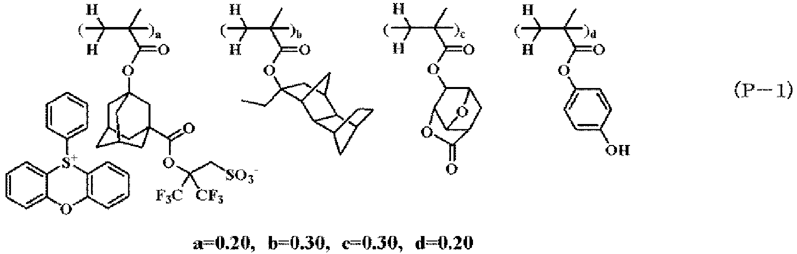

### Photoacid Generator

### (PAG-A): Triphenylsulfonium 2-(adamantane-1-carbonyloxy)-1,1,3,3,3-pentafluoropropane-1-sulfonate (compound described in JP 2007-145797 A)

### Amine Quencher

### (Q-1): 2-Morpholinoethyl laurate

### Surfactant

Alkali-Soluble Surfactant (F-1): Poly (3,3,3-trifluoro-2-hydroxy-1,1-dimethyl-2-trifluoromethylpropyl methacrylate / 1,1,1-trifluoro-2-hydroxy-6-methyl-2-trifluoromethylhept-4-yl methacrylate) (compound described in JP 2008-122932 A)

Weight-average molecular weight (Mw) = 7,300, dispersion degree (Mw/Mn) = 1.86

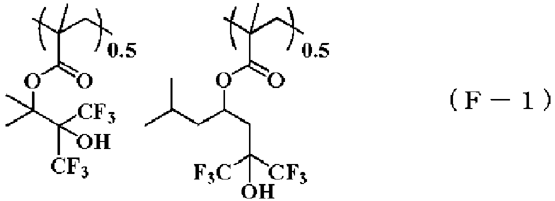

### Solvent

PGMEA: Propylene glycol monomethyl ether acetate
CyHO: Cyclohexanone

**[Table 11]**

| | Resist polymer | parts by mass | Photoacid generator | parts by mass | Amine quencher | parts by mass | Surfactant | parts by mass | Solvent 1 | parts by mass | Solvent 2 | parts by mass |
|---|---|---|---|---|---|---|---|---|---|---|---|---|
| PR1 | P-1 | 80 | PAG-A | 3.8 | Q-1 | 0.6 | F-1 | 5 | PGMEA | 576 | CyHO | 1728 |

This film was exposed by using an ArF immersion excimer stepper (available from ASML Holding N.V., XT19001, NA: 1.35, σ: 0.98/0.80, cross-pole opening 30°, 6% halftone phase-shifting mask) and by using a mask having an aligned hole pattern with 90 nm in pitch and 36 nm in width as size-on-wafer, subjected to a thermal treatment (PEB) for 60 seconds after the exposure, then butyl acetate was discharged through a development nozzle while rotation at 30 rpm for 3 seconds, and then stationary puddle development was performed for 27 seconds to obtain a negative-type pattern.

The hole size of the pattern produced under the above condition was measured with an electron microscope available from Hitachi High-Technologies Corporation (CG5000). The sectional shape (pattern shape) was observed with an electron microscope available from Hitachi High-Technologies Corporation (S-4800). A case where a bottom footing shape and an undercut shape were not observed was evaluated as Good, and a case where an obvious bottom footing shape or undercut shape was observed was evaluated as Poor.

The reflectance was calculated by using PROLITH 2020a (Litho Tech Japan Corporation). The film thickness of the silicon-containing anti-reflective film was fixed to 10 nm, and calculated was a reflectance when the silicon-containing anti-reflective film had "n" of 1.60 to 2.10 and "k" of 0.20 to 0.40. FIG. 3 shows the results. Preferable is the optical constants (n/k) that can reduce the reflecting light from the underlayer substrate in pattern exposure to 1.0% or less.

While using the above resist pattern (D layer) as a mask, the silicon-containing anti-reflective film (C layer) and the silicon-containing hard mask (B layer) were processed by dry etching under the following condition (1), and then the pattern was transferred to the organic underlayer film (A layer) under the following condition (2). Finally, the pattern was transferred to the oxide film (substrate to be processed) under the following condition (3).

### (1) Processing condition for silicon-containing anti-reflective film (C layer) and silicon-containing hard mask (B layer)

Apparatus: Dry-etching apparatus Telius SP, available from Tokyo Electron Ltd.
Chamber pressure: 80 mT
RF power (upper part): 500 W
RF power (lower part): 300 W
CF₄ gas flow rate: 150 sccm
CHF₃ gas flow rate: 50 sccm
Time: 15 sec

### (2) Processing condition for organic underlayer film (A layer)

Apparatus: Dry-etching apparatus Telius SP, available from Tokyo Electron Ltd.
Chamber pressure: 80 mT
RF power (upper part): 500 W
RF power (lower part): 300 W
CO₂ gas flow rate: 320 sccm
N₂ gas flow rate: 80 sccm
Time: 45 sec

### (3) Processing condition for oxide film (substrate to be processed)

Apparatus: Dry-etching apparatus Telius SP, available from Tokyo Electron Ltd.
Chamber pressure: 10 mT
RF power (upper part): 100 W
RF power (lower part): 800 W
CF₄ gas flow rate: 25 sccm
CHF₃ gas flow rate: 15 sccm
O₂ gas flow rate: 5 sccm
Time: 60 sec

The hole size of the pattern produced under the above condition was measured with an electron microscope available from Hitachi High-Technologies Corporation (CG5000). Hole diameters at 50 different points in the same exposure shot were measured, and a 3σ value of size deviation was specified as CDU. Table 12 shows the results. A lower vale of CDU indicates better size controllability, which is preferable.

**[Table 12]**

| Example | A layer | B layer | C layer | D layer | Reflection | CD after exposure | CDU after exposure | Pattern after exposure | CD after processing | CDU after processing |
|---|---|---|---|---|---|---|---|---|---|---|
| | Organic underlayer film | Silicon-containing hard mask | Silicon-containing anti-reflective film | Photoresist film | % | nm | nm | Shape | nm | nm |
| Example 4-1 | ACL | SiON | UDL-2 | PR-1 | 0.48% | 35.6 | 1.5 | Good | 39.6 | 2.3 |
| Example 4-2 | ACL | SiON | UDL-6 | PR-1 | 0.64% | 35.9 | 1.6 | Good | 39.7 | 2.4 |
| Example 4-3 | ACL | SiON | UDL-10 | PR-1 | 0.38% | 35.7 | 1.6 | Good | 39.9 | 2.2 |
| Example 4-4 | ACL | SiON | UDL-14 | PR-1 | 0.60% | 36.5 | 1.9 | Good | 40.1 | 2.3 |
| Example 4-5 | ACL | SiON | UDL-22 | PR-1 | 0.88% | 36.2 | 1.8 | Good | 40.4 | 2.5 |
| Comparative Example 4-1 | ACL | SiON | None | PR-1 | 3.20% | 38.1 | 3.6 | Undercut | 41.5 | 4.4 |
| Comparative Example 4-2 | ACL | SiON | Comparative UDL-1 | PR-1 | 0.32% | 37.4 | 2.8 | Undercut | 41.3 | 3.6 |

From the results in Table 12, it has been understood that the patterning method using the compositions for forming a silicon-containing anti-reflective film of the present invention (Examples 4-1 to 4-5) exhibit a good sectional pattern shape after exposure and good CDU after processing the substrate to be processed. In particular, the silicon-containing anti-reflective films formed by using the composition for forming a silicon-containing anti-reflective film UDL-2, 6, or 10, which contains the crosslinking agent (D1 or D3), yields the resist pattern having excellent CDU after exposure presumably because of the excellent effect of inhibiting poisoning.

In Comparative Example 4-1, the sectional pattern shape after exposure was an undercut shape. This was presumably because the silicon-containing anti-reflective film was not used, and thereby the base component generated from the SiON film was transferred to the photoresist film to deteriorate resolution of the resist. In addition, it was presumed that CDU of the resist pattern after exposure was deteriorated also due to the insufficient effect of inhibiting reflecting light to cause insufficient CDU after processing the substrate to be processed.

In Comparative Example 4-2, the sectional pattern shape after exposure was an undercut shape. This was presumably because the effect of inhibiting poisoning of Comparative UDL-1 used as the silicon-containing anti-reflective film was insufficient, and the base component generated from the SiON film was transferred to the photoresist film to deteriorate resolution of the resist. In addition, it was presumed that CDU of the resist pattern after exposure was deteriorated also due to the insufficient thin-film formability to cause insufficient CDU also after processing the substrate to be processed.

From the above, the silicon-containing anti-reflective film formed by using the composition for forming a silicon-containing anti-reflective film of the present invention has excellent thin film formability, anti-reflective effect, and effect of inhibiting poisoning from the resist underlayer to the photoresist film, and yields the pattern shape with high rectangularity of the resist upper layer film. Therefore, the composition for forming a silicon-containing anti-reflective film of the present invention is particularly suitably used for the multilayer resist process, and extremely useful in fine patterning for producing semiconductor devices.

The present description includes the following embodiments.
[1]: A composition for forming a silicon-containing anti-reflective film, comprising:
   a silicon-containing polymer (A);
   an organic polymer (B); and
   an organic solvent (C), wherein
   the silicon-containing polymer (A) comprises any one selected from a polysiloxane, a polycarbosilane, and a polysilane, and
   the organic polymer (B) comprises two or more hydroxy groups in a repeating unit structure of the polymer, and comprises no silicon.
[2]: The composition for forming a silicon-containing anti-reflective film of the above [1], wherein the organic polymer (B) comprises the following general formula (1B) or (2B), 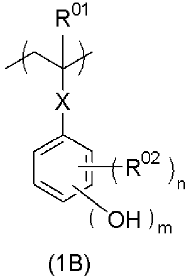
   wherein R⁰¹ represents a hydrogen atom or a methyl group, R⁰² represents an alkyl group having 1 to 3 carbon atoms or a halogen atom, "m" represents an integer of 2 to 5, "n" represents an integer of 0 to 3, m+n represents an integer of 2 or more and 5 or less, X represents a single bond or an alkylene group having 1 to 10 carbon atoms and optionally having one or more selected from an oxygen atom and a nitrogen atom, 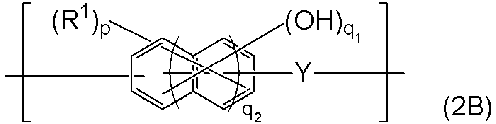
   wherein R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, "q₁" represents an integer of 2 to 6, p+q₁ represents an integer of 2 or more and 6 or less, and "q₂" represents 0 or 1.
[3]: The composition for forming a silicon-containing anti-reflective film of the above [1] or [2], wherein the polysiloxane comprises one or more selected from a repeating unit represented by the following general formula (Sx-1), a repeating unit represented by the following general formula (Sx-2), and a partial structure represented by the following general formula (Sx-3), 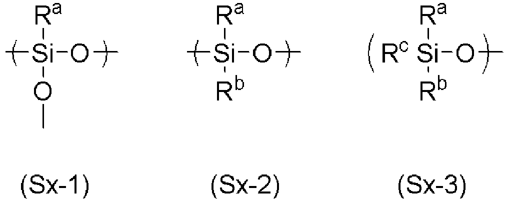 wherein R^{a}, R^{b}, and R^{c} represent a monovalent organic group having 1 to 30 carbon atoms which may be same as or different from each other.
[4]: The composition for forming a silicon-containing anti-reflective film of the above [3], wherein at least one of the R^{a} to R^{c} in the general formulae (Sx-1) to (Sx-3) represents an organic group having one or more carbon-oxygen single bonds or carbon-oxygen double bonds.
[5]: The composition for forming a silicon-containing anti-reflective film of any one of the above [1] to [4], wherein the polycarbosilane comprises a unit structure represented by the following general formula (Sy-1), 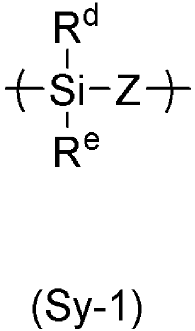 wherein R^{d} and R^{e} each independently represent a hydrogen atom, a hydroxy group, a halogen atom, or a monovalent organic group having 1 to 30 carbon atoms, and Z represents a substituted or unsubstituted divalent hydrocarbon group having 1 to 20 carbon atoms.
[6]: The composition for forming a silicon-containing anti-reflective film of any one of the above [1] to [5], wherein a content of the organic polymer (B) is within a range of 1 to 50 parts by mass relative to 100 parts by mass of the silicon-containing polymer (A).
[7]: The composition for forming a silicon-containing anti-reflective film of any one of the above [1] to [6], wherein a weight-average molecular weight Mw of the organic polymer (B) is within a range of 1,500 ≤ Mw ≤ 20,000 in terms of polystyrene by gel permeation chromatography.
[8]: The composition for forming a silicon-containing anti-reflective film of any one of the above [1] to [7], further comprising a crosslinking agent (D).
[9]: The composition for forming a silicon-containing anti-reflective film of the above [8], wherein the crosslinking agent (D) is a compound comprising an isocyanuric acid structure.
[10]: The composition for forming a silicon-containing anti-reflective film of any one of the above [1] to [9], further comprising one or more selected from an acid generator (E), a surfactant (F), and a pigment (H) .
[11]: The composition for forming a silicon-containing anti-reflective film of any one of the above [1] to [10], wherein the organic solvent (C) comprises one or more organic solvents having a boiling point of 180°C or higher as a high-boiling-point solvent (C1).
[12]: A patterning method for forming a pattern on a substrate to be processed, the method comprising steps of:
   (I-1) applying the composition for forming a silicon-containing anti-reflective film of any one of the above [1] to [11] on a substrate to be processed, and then heat-treating the composition to form a silicon-containing anti-reflective film;
   (I-2) forming a resist upper layer film on the silicon-containing anti-reflective film by using a photoresist material;
   (I-3) pattern-exposing the resist upper layer film, and then developing the exposed resist upper layer film with a developer to form a pattern in the resist upper layer film;
   (I-4) transferring the pattern to the silicon-containing anti-reflective film by dry etching while using the resist upper layer film having the formed pattern as a mask; and
   (I-5) forming a pattern on the substrate to be processed by processing the substrate to be processed while using the silicon-containing anti-reflective film having the transferred pattern as a mask.
[13]: A patterning method for forming a pattern on a substrate to be processed, the method comprising steps of:
   (II-1) forming a resist underlayer film on a substrate to be processed;
   (II-2) applying the composition for forming a silicon-containing anti-reflective film of any one of the above [1] to [11] on the resist underlayer film, and then heat-treating the composition to form a silicon-containing anti-reflective film;
   (II-3) forming a resist upper layer film on the silicon-containing anti-reflective film by using a photoresist material;
   (II-4) pattern-exposing the resist upper layer film, and then developing the exposed resist upper layer film with a developer to form a pattern in the resist upper layer film;
   (II-5) transferring the pattern to the silicon-containing anti-reflective film by dry etching while using the resist upper layer film having the formed pattern as a mask;
   (II-6) transferring the pattern to the resist underlayer film by dry etching while using the silicon-containing anti-reflective film having the transferred pattern as a mask; and
   (II-7) forming a pattern on the substrate to be processed by processing the substrate to be processed while using the resist underlayer film having the transferred pattern as a mask.
[14]: A patterning method for forming a pattern on a substrate to be processed, the method comprising steps of:
   (III-1) forming a resist underlayer film on a substrate to be processed;
   (III-2) forming an inorganic hard mask middle layer film selected from a group consisting of a silicon oxide film, a silicon nitride film, and a silicon oxynitride film on the resist underlayer film;
   (III-3) applying the composition for forming a silicon-containing anti-reflective film of any one of the above [1] to [11] on the inorganic hard mask middle layer film, and then heat-treating the composition to form a silicon-containing anti-reflective film;
   (III-4) forming a resist upper layer film on the silicon-containing anti-reflective film by using a photoresist material;
   (III-5) pattern-exposing the resist upper layer film, and then developing the exposed resist upper layer film with a developer to form a pattern in the resist upper layer film;
   (III-6) transferring the pattern to the silicon-containing anti-reflective film and the inorganic hard mask middle layer film by dry etching while using the resist upper layer film having the formed pattern as a mask;
   (III-7) transferring the pattern to the resist underlayer film by dry etching while using the inorganic hard mask middle layer film having the transferred pattern as a mask; and
   (III-8) forming a pattern on the substrate to be processed by processing the substrate to be processed while using the resist underlayer film having the transferred pattern as a mask.
[15]: The patterning method of any one of the above [12] to [14], wherein a film thickness of the silicon-containing anti-reflective film is 12 nm or less.

It should be noted that the present invention is not limited to the above-described embodiments. The embodiments are just examples, and any examples that approximately have the same feature and demonstrate the same functions and effects as those in the technical concept disclosed in claims of the present invention are included in the technical scope of the present invention.

## Claims

1. A composition for forming a silicon-containing anti-reflective film, comprising:
a silicon-containing polymer (A);
an organic polymer (B); and
an organic solvent (C), wherein
the silicon-containing polymer (A) comprises any one selected from a polysiloxane, a polycarbosilane, and a polysilane, and
the organic polymer (B) comprises two or more hydroxy groups in a repeating unit structure of the polymer, and comprises no silicon.

2. The composition for forming a silicon-containing anti-reflective film according to claim 1, wherein the organic polymer (B) comprises the following general formula (1B) or (2B), 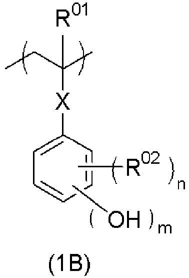
wherein R⁰¹ represents a hydrogen atom or a methyl group, R⁰² represents an alkyl group having 1 to 3 carbon atoms or a halogen atom, "m" represents an integer of 2 to 5, "n" represents an integer of 0 to 3, m+n represents an integer of 2 or more and 5 or less, X represents a single bond or an alkylene group having 1 to 10 carbon atoms and optionally having one or more selected from an oxygen atom and a nitrogen atom, 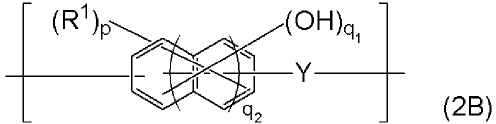
wherein R¹ represents any one selected from a saturated monovalent organic group having 1 to 30 carbon atoms, an unsaturated monovalent organic group having 2 to 30 carbon atoms, and a halogen atom, Y represents a divalent organic group having 1 to 30 carbon atoms, "p" represents an integer of 0 to 5, "q₁" represents an integer of 2 to 6, p+q₁ represents an integer of 2 or more and 6 or less, and "q₂" represents 0 or 1.

3. The composition for forming a silicon-containing anti-reflective film according to claim 1 or 2, wherein the polysiloxane comprises one or more selected from a repeating unit represented by the following general formula (Sx-1), a repeating unit represented by the following general formula (Sx-2), and a partial structure represented by the following general formula (Sx-3), 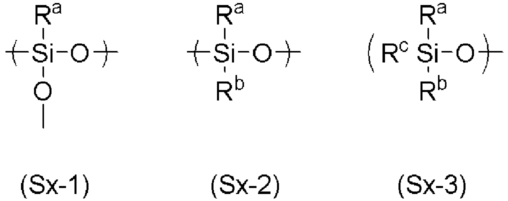 wherein R^{a}, R^{b}, and R^{c} represent a monovalent organic group having 1 to 30 carbon atoms which may be same as or different from each other.

4. The composition for forming a silicon-containing anti-reflective film according to claim 3, wherein at least one of the R^{a} to R^{c} in the general formulae (Sx-1) to (Sx-3) represents an organic group having one or more carbon-oxygen single bonds or carbon-oxygen double bonds.

5. The composition for forming a silicon-containing anti-reflective film according to any one of claims 1 to 4, wherein the polycarbosilane comprises a unit structure represented by the following general formula (Sy-1), 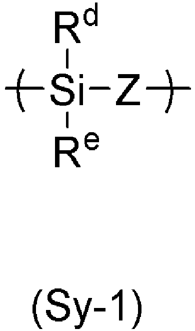 wherein R^{d} and R^{e} each independently represent a hydrogen atom, a hydroxy group, a halogen atom, or a monovalent organic group having 1 to 30 carbon atoms, and Z represents a substituted or unsubstituted divalent hydrocarbon group having 1 to 20 carbon atoms.

6. The composition for forming a silicon-containing anti-reflective film according to any one of claims 1 to 5, wherein a content of the organic polymer (B) is within a range of 1 to 50 parts by mass relative to 100 parts by mass of the silicon-containing polymer (A).

7. The composition for forming a silicon-containing anti-reflective film according to any one of claims 1 to 6, wherein a weight-average molecular weight Mw of the organic polymer (B) is within a range of 1,500 ≤ Mw ≤ 20,000 in terms of polystyrene by gel permeation chromatography.

8. The composition for forming a silicon-containing anti-reflective film according to any one of claims 1 to 7, further comprising a crosslinking agent (D).

9. The composition for forming a silicon-containing anti-reflective film according to claim 8, wherein the crosslinking agent (D) is a compound comprising an isocyanuric acid structure.

10. The composition for forming a silicon-containing anti-reflective film according to any one of claims 1 to 9, further comprising one or more selected from an acid generator (E), a surfactant (F), and a pigment (H).

11. The composition for forming a silicon-containing anti-reflective film according to any one of claims 1 to 10, wherein the organic solvent (C) comprises one or more organic solvents having a boiling point of 180°C or higher as a high-boiling-point solvent (C1).

12. A patterning method for forming a pattern on a substrate to be processed, the method comprising steps of:
(I-1) applying the composition for forming a silicon-containing anti-reflective film according to any one of claims 1 to 11 on a substrate to be processed, and then heat-treating the composition to form a silicon-containing anti-reflective film;
(I-2) forming a resist upper layer film on the silicon-containing anti-reflective film by using a photoresist material;
(I-3) pattern-exposing the resist upper layer film, and then developing the exposed resist upper layer film with a developer to form a pattern in the resist upper layer film;
(I-4) transferring the pattern to the silicon-containing anti-reflective film by dry etching while using the resist upper layer film having the formed pattern as a mask; and
(I-5) forming a pattern on the substrate to be processed by processing the substrate to be processed while using the silicon-containing anti-reflective film having the transferred pattern as a mask.

13. A patterning method for forming a pattern on a substrate to be processed, the method comprising steps of:
(II-1) forming a resist underlayer film on a substrate to be processed;
(II-2) applying the composition for forming a silicon-containing anti-reflective film according to any one of claims 1 to 11 on the resist underlayer film, and then heat-treating the composition to form a silicon-containing anti-reflective film;
(II-3) forming a resist upper layer film on the silicon-containing anti-reflective film by using a photoresist material;
(II-4) pattern-exposing the resist upper layer film, and then developing the exposed resist upper layer film with a developer to form a pattern in the resist upper layer film;
(II-5) transferring the pattern to the silicon-containing anti-reflective film by dry etching while using the resist upper layer film having the formed pattern as a mask;
(II-6) transferring the pattern to the resist underlayer film by dry etching while using the silicon-containing anti-reflective film having the transferred pattern as a mask; and
(II-7) forming a pattern on the substrate to be processed by processing the substrate to be processed while using the resist underlayer film having the transferred pattern as a mask.

14. A patterning method for forming a pattern on a substrate to be processed, the method comprising steps of:
(III-1) forming a resist underlayer film on a substrate to be processed;
(III-2) forming an inorganic hard mask middle layer film selected from a group consisting of a silicon oxide film, a silicon nitride film, and a silicon oxynitride film on the resist underlayer film;
(III-3) applying the composition for forming a silicon-containing anti-reflective film according to any one of claims 1 to 11 on the inorganic hard mask middle layer film, and then heat-treating the composition to form a silicon-containing anti-reflective film;
(III-4) forming a resist upper layer film on the silicon-containing anti-reflective film by using a photoresist material;
(III-5) pattern-exposing the resist upper layer film, and then developing the exposed resist upper layer film with a developer to form a pattern in the resist upper layer film;
(III-6) transferring the pattern to the silicon-containing anti-reflective film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) forming a pattern on the substrate to be processed by processing the substrate to be processed while using the resist underlayer film having the transferred pattern as a mask.

15. The patterning method according to any one of claims 12 to 14, wherein a film thickness of the silicon-containing anti-reflective film is 12 nm or less.
